# EUROPEAN PATENT SPECIFICATION

(11) **EP 4 383 082 B1**
(45) Date of publication and mention of the grant of the patent: **08.07.2026**
(21) Application number: 21956010.9
(22) Date of filing: 02.09.2021
(51) Int. Cl.: G11C 5/04, G11C 5/02, G06F 3/06, G11C 5/06, G11C 8/12

(54) **STORAGE SYSTEM**
SPEICHERSYSTEM
SYSTÈME DE STOCKAGE

(43) Date of publication of application: 12.06.2024
(73) Proprietor: Kioxia Corporation, Tokyo 108-0023 (JP)
(72) Inventor: HITOMI, Tatsuro, Tokyo 108-0023 (JP); YOSHIMIZU, Yasuhito, Tokyo 108-0023 (JP); MIURA, Masayuki, Tokyo 108-0023 (JP); MIYAOKA, Mitoshi, Tokyo 108-0023 (JP); KOJIMA, Tetsuharu, Tokyo 108-0023 (JP); SANUKI, Tomoya, Tokyo 108-0023 (JP)
(74) Representative: Marks & Clerk LLP
(86) International application number: PCT/JP2021/032273
(87) International publication number: WO 2023/032121

(56) References cited:
- JP-A- 2000 030 433
- JP-A- 2020 149 667
- US-A1- 2005 055 601
- US-A1- 2021 149 568
- US-B2- 8 655 482

## Description

### Technical Field

Embodiments of the present invention relate to a technique for controlling a nonvolatile memory.

### Background Art

Storage devices implemented with a nonvolatile memory have recently become widespread. As one of such storage devices, a solid state drive (SSD) implemented with a NAND flash memory has been known.

The SSD is used as a storage of various computers. Recently, the SSD is also used as a storage in data centers.

In data centers, it is necessary to read and write large amounts of data at a high speed.

Under these circumstances, there is a need to implement a new storage system that is useful for processing large amounts of data. US 2005/0055601 describes a memory device (HDD) storage system that has at least one storing location in which a memory device is received while the memory device is not supplied with an electric power, at least one docking location where the memory device is supplied with the electric power so that data can be stored in the memory device and retrieved from the memory device, and a transport device for transporting the memory device between the shelf and the docking location.

US 2021/149568 describes a storage device that includes a stage on which a semiconductor wafer can be mounted, wherein data is capable of being read from the semiconductor wafer or data is capable of being written to the semiconductor wafer. The storage device further includes a plurality of probe pins for reading or writing data, and a controller connected the probe pins. The semiconductor wafer includes electrodes connectable to the probe pins, a first memory area that can store user data, and a second memory area that can store identification information for identification of the semiconductor wafer and a check code for checking integrity of the identification information. The controller is capable of reading the identification information and the check code from the second memory area.

### Citation List

### Patent Literatures

Patent Literature 1: US 2019/0387291 A
Patent Literature 2: US 10467163 B
Patent Literature 3: JP 2016-81332 A
Patent Literature 4: JP 2005-517236 A
Patent Literature 5: US 2005/0055601
Patent Literature 6: US 2021/149568

### Summary of Invention

### Technical Problem

An object to be solved by an embodiment of the present invention is to provide a storage system useful for processing large amounts of data.

### Solution to Problem

Aspects of the invention are in accordance with the appended independent claims. Various optional features are the subject of the appended dependent claims. There is described herein a storage system comprises a package stocker, a drive, a host apparatus, and a package transport device. The package stocker is configured to store a plurality of semiconductor packages. Each of the plurality of semiconductor packages includes one or more nonvolatile memory dies. The drive includes at least one socket on which the semiconductor package is able to be detachably mounted, and a controller that is configured to control the one or more nonvolatile memory dies of the semiconductor package mounted on the socket. The host apparatus is communicatively connected to the drive, and is configured to execute reading and writing data from and to the one or more nonvolatile memory dies of the semiconductor package via the controller. The package transport device is configured to transport the semiconductor package between the package stocker and the drive. The host apparatus determines a first semiconductor package that includes a first nonvolatile memory die to be accessed, among the plurality of semiconductor packages. When the first semiconductor package is mounted on the socket of the drive, the host apparatus executes reading or writing data from or to the first nonvolatile memory die via the controller. When the first semiconductor package is not mounted on the socket of the drive, the host apparatus causes the package transport device to transport the first semiconductor package to the socket of the drive, and to mount the first semiconductor package on the socket of the drive.

### Brief Description of Drawings

FIG. 1 is a block diagram illustrating an example of a configuration of a storage system according to a first embodiment.
FIG. 2 is a side view illustrating an example of an arrangement of a package stocker, a package transport device, a drive, and a host apparatus, which are included in the storage system according to the first embodiment.
FIG. 3 is a plan view illustrating an example of an arrangement of the package stocker, the package transport device, the drive, and the host apparatus, which are included in the storage system according to the first embodiment.
FIG. 4 is a diagram illustrating an example of a configuration of a semiconductor package used in the storage system according to the first embodiment.
FIG. 5 is a diagram illustrating shapes of a front surface, a back surface, and a side surface of a semiconductor package used in the storage system according to the first embodiment.
FIG. 6 is a perspective view illustrating a plurality of pairs of rails included in the package stocker of the storage system according to the first embodiment.
FIG. 7 is a block diagram illustrating an example of a configuration of the host apparatus included in the storage system according to the first embodiment.
FIG. 8 is a diagram illustrating a package loading/unloading slot of the package stocker included in the storage system according to the first embodiment.
FIG. 9 is a diagram illustrating an operation of adding a new semiconductor package to the package stocker included in the storage system according to the first embodiment.
FIG. 10 is a diagram illustrating an operation of changing a location of a semiconductor package, which is executed in the storage system according to the first embodiment.
FIG. 11 is another diagram illustrating an operation of changing a location of a semiconductor package, which is executed in the storage system according to the first embodiment.
FIG. 12 is a diagram illustrating another operation of changing a location of a semiconductor package, which is executed in the storage system according to the first embodiment.
FIG. 13 is a diagram illustrating still another operation of changing a location of a semiconductor package, which is executed in the storage system according to the first embodiment.
FIG. 14 is a diagram illustrating still yet another operation of changing a location of a semiconductor package, which is executed in the storage system according to the first embodiment.
FIG. 15 is a diagram illustrating still yet another operation of changing a location of a semiconductor package, which is executed in the storage system according to the first embodiment.
FIG. 16 is a flowchart illustrating a procedure of a process of reading or writing data, which is executed by the host apparatus included in the storage system according to the first embodiment.
FIG. 17 is a flowchart illustrating details of a procedure of a process of reading or writing data, which is executed by the host apparatus included in the storage system according to the first embodiment.
FIG. 18A is a flowchart illustrating a part of another procedure of the process of reading or writing data, which is executed by the host apparatus included in the storage system according to the first embodiment.
FIG. 18B is a flowchart illustrating a continuation part of said another procedure of the process of reading or writing data, which is executed by the host apparatus included in the storage system according to the first embodiment.
FIG. 19 is a block diagram illustrating an example of a configuration of a storage system according to a second embodiment.
FIG. 20 is a perspective view illustrating an example of a configuration of a tray used in the storage system according to the second embodiment.
FIG. 21 is a cross-sectional view of the tray illustrated in FIG. 20.
FIG. 22 is a perspective view illustrating an example of another configuration of the tray used in the storage system according to the second embodiment.
FIG. 23 is a cross-sectional view of the tray illustrated in FIG. 22.
FIG. 24 is a plan view illustrating shapes of an upper surface and a lower surface of the tray illustrated in FIG. 22.
FIG. 25 is a side view of the tray illustrated in FIG. 22.
FIG. 26 is a perspective view illustrating a rail structure of a package stocker included in the storage system according to the second embodiment.
FIG. 27 is a perspective view illustrating another example of the rail structure of the package stocker included in the storage system according to the second embodiment.
FIG. 28 is a block diagram illustrating an example of a configuration of a host apparatus included in the storage system according to the second embodiment.
FIG. 29 is a diagram illustrating a tray loading/unloading slot of the package stocker included in the storage system according to the second embodiment.
FIG. 30 is a diagram illustrating an operation of adding a new tray to the package stocker included in the storage system according to the second embodiment.
FIG. 31 is a diagram illustrating the alignment between the tray and a drive, which are included in the storage system according to the second embodiment.
FIG. 32 is another diagram illustrating the alignment between the tray and the drive included in the storage system according to the second embodiment.
FIG. 33 is a diagram illustrating an operation of changing a location of a tray, which is executed in the storage system according to the second embodiment.
FIG. 34 is another diagram illustrating an operation of changing a location of a tray, which is executed in the storage system according to the second embodiment.
FIG. 35 is a diagram illustrating another operation of changing a location of a tray, which is executed in the storage system according to the second embodiment.
FIG. 36 is a diagram illustrating still another operation of changing a location of a tray, which is executed in the storage system according to the second embodiment.
FIG. 37 is a diagram illustrating still yet another operation of changing a location of a tray, which is executed in the storage system according to the second embodiment.
FIG. 38 is a diagram illustrating still yet another operation of changing a location of a tray, which is executed in the storage system according to the second embodiment.
FIG. 39 is a flowchart illustrating a procedure of a process of reading or writing data from or to a nonvolatile memory die, which is executed by the host apparatus included in the storage system according to the second embodiment.
FIG. 40 is a flowchart illustrating details of the procedure of the process of reading or writing data from or to the nonvolatile memory die, which is executed by the host apparatus included in the storage system according to the second embodiment.
FIG. 41A is a flowchart illustrating a part of another procedure of the process of reading or writing data from or to the nonvolatile memory die, which is executed by the host apparatus included in the storage system according to the second embodiment.
FIG. 41B is a flowchart illustrating a continuation part of said another procedure of the process of reading or writing data from or to the nonvolatile memory die, which is executed by the host apparatus included in the storage system according to the second embodiment.

### Description of Embodiments

Hereinafter, embodiments will be described with reference to the drawings.

### (First Embodiment)

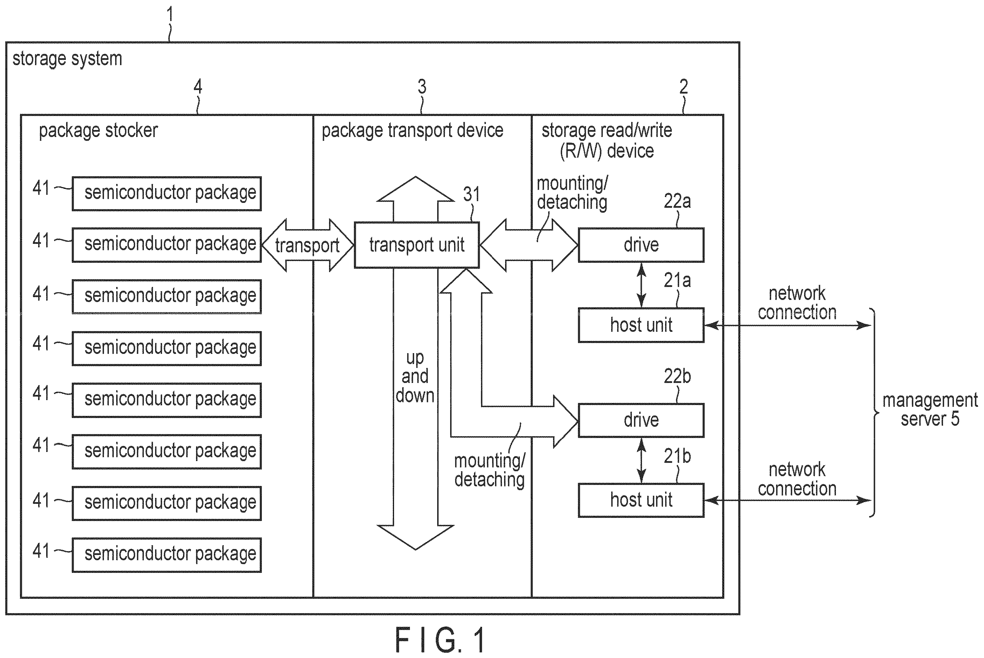

First, a configuration of a storage system according to a first embodiment will be described. FIG. 1 is a block diagram illustrating an example of a configuration of a storage system 1 according to the first embodiment. The storage system 1 may be used in a data center.

The storage system 1 includes a storage read/write (R/W) device 2, a package transport device 3, and a package stocker 4.

The storage R/W device 2 includes a host unit 21 and a drive 22. FIG. 1 illustrates a case where the storage R/W device 2 includes two host units 21a and 21b and two drives 22a and 22b. However, the number of the host units 21 and the number of the drives 22 provided in the storage R/W device 2 may be one, or three or more.

The host unit 21 is a host apparatus configured to execute the reading and writing of data from and to a nonvolatile memory die. The host unit 21 is communicatively connected to the corresponding drive 22. The host unit 21 and the corresponding drive 22 can communicate with each other according to, for example, a standard of PCI Express^{™} (PCIe^{™}). In addition, the host unit 21 may communicate with a management server 5 in the data center via a network. The host unit 21 and the management server 5 can communicate with each other according to, for example, a standard of Ethernet.

The drive 22 includes a controller and at least one socket. The socket is configured such that a semiconductor package 41 is able to be detachably mounted thereon. The controller is configured to control one or more nonvolatile memory dies included in a semiconductor package 41 mounted on the socket.

In the example illustrated in FIG. 1, the host unit 21a is communicatively connected to the drive 22a. The host unit 21b is communicatively connected to the drive 22b.

That is, the host unit 21a is a host apparatus configured to execute the reading and writing of data from and to one or more nonvolatile memory dies of a semiconductor package 41 having been mounted on a socket of the drive 22a, via the controller of the drive 22a. Similarly, the host unit 21b is a host apparatus configured to execute the reading and writing of data from and to one or more nonvolatile memory dies of a semiconductor package 41 having been mounted on a socket of the drive 22b, via the controller of the drive 22b.

The package transport device 3 is a device that transports a semiconductor package 41 between the package stocker 4 and the drive 22. The package transport device 3 may include, for example, one or more transport units 31 that are movable up and down, and right and left. The transport unit 31 may transport a semiconductor package 41 stored in any storage location of a plurality of storage locations in the package stocker 4 to any drive 22 in the storage R/W device 2, and may mount the transported semiconductor package 41 on a socket of the drive 22. In addition, the transport unit 31 may detach a semiconductor package 41 from a socket of any drive 22, and may transport the detached semiconductor package 41 to any storage location in the package stocker 4. The package transport device 3 may include one or more transport robots.

The package stocker 4 is capable of storing a plurality of semiconductor packages 41. Each of the semiconductor packages 41 includes one or more nonvolatile memory dies. Each of the one or more nonvolatile memory dies is, for example, a NAND flash memory.

Next, a basic operation of the storage system 1 will be described. The host unit 21 has a location management function and a transport control function. The location management function is a function of managing locations where the plurality of semiconductor packages 41 are respectively present. The transport control function is a function of controlling the transport of a semiconductor package 41 by controlling the package transport device 3.

A package identifier (also referred to as a semiconductor package identification name) is assigned to each of the plurality of semiconductor packages 41. The host unit 21 may manage a correspondence between the package identifier and a location where a semiconductor package 41 identified by this package identifier is present.

A location where a certain semiconductor package 41 may be present is, for example, any one socket among one or more sockets included in the drive 22, or any one package storage location among a plurality of package storage locations included in the package stocker 4.

The host unit 21 determines a semiconductor package 41 that includes a nonvolatile memory die to be accessed, among the plurality of semiconductor packages 41. The host unit 21 identifies the location where the determined semiconductor package 41 is present, whereby the host unit 21 may determine whether or not the determined semiconductor package 41 is mounted on any one socket of the drive 22.

When the determined semiconductor package 41 is mounted on any one socket of the drive 22, the host unit 21 executes the reading or writing of data from or to the nonvolatile memory die to be accessed, via the controller of the drive 22.

When the determined semiconductor package 41 is not mounted on any of the sockets of the drive 22 and is stored in the package stocker 4, the host unit 21 causes the package transport device 3 to transport the determined semiconductor package 41 from the package stocker 4 to any one socket of the drive 22, and to mount the determined semiconductor package 41 on the socket. In this case, the host unit 21 may transmit a transport request described below, to the package transport device 3.

For example, this transport request specifies a location in the package stocker 4 where the determined semiconductor package 41 is stored (also referred to as a package storage location) as a transport source location, and also specifies any one socket of the drive 22 as a transport destination location. A transport unit 31 of the package transport device 3 transports the semiconductor package 41 present at the specified transport source location to the specified transport destination location. Then, the transport unit 31 mounts the semiconductor package 41 to the socket of the transport destination location.

Generally, in a storage device such as a solid state drive (SSD), a semiconductor package is fixedly mounted on a board in the storage device by soldering.

On the other hand, in the storage system 1 according to the present embodiment, each of the plurality of semiconductor packages 41 is separated from the drive 22, and each semiconductor package 41 itself is used as a removable storage medium that is detachably mounted on a socket of the drive 22.

Generally, a storage medium and a controller are incorporated in a drive such as an SSD or a hard disk drive (HDD). Thus, the size of each drive is relatively large. Therefore, the configuring of a storage system in which a plurality of drives each incorporating a storage medium and a controller are selectively connected to a host unit may increase in size and cost of the entire storage system.

A configuration of a storage system using a storage medium which includes no controller, such as an optical disc medium or a magnetic tape, is also conceivable. However, it is necessary to physically move an optical head or a magnetic head in an operation of reading and writing data from and to the optical disc medium or the magnetic tape. Therefore, in the configuration of the storage system using the optical disc medium or the magnetic tape as the storage medium, the latency until a reading and writing process becomes executable increases and the I/O throughput decreases as compared with a configuration in which data is read and written from and to a nonvolatile memory die.

In the storage system 1, the semiconductor package 41 and the drive 22 are separated. Therefore, the semiconductor package 41 alone can be stored in the package stocker 4 as a storage medium. Therefore, it is possible to reduce a space required for storing multiple storage media.

Further, a semiconductor package 41 that includes a nonvolatile memory die to be accessed is transported from the package stocker 4 to a socket in the drive 22 by the package transport device 3, and the semiconductor package 41 is mounted on this socket. The semiconductor package 41 mounted on the socket is electrically connected to the controller of the drive 22. Therefore, since it is not necessary to physically move an optical head or a magnetic head, it is possible to rapidly execute the reading and writing of data to and from the nonvolatile memory die to be accessed, with low latency as compared with the configuration using an optical disk medium or a magnetic tape as a storage medium. As a result, it is possible to make the storage system 1 suitable for processing large amounts of data required in a data center.

The host unit 21 may further have a function of managing a priority of each of the plurality of semiconductor packages 41. The algorithm for determining the priority of each of the plurality of semiconductor packages 41 is not limited to a specific algorithm, and the priority of each of the plurality of semiconductor packages 41 can be determined based on various conditions.

For example, the priority of a semiconductor package 41 that includes a certain nonvolatile memory die may be determined based on an access request to this nonvolatile memory die. The priority of each of the semiconductor packages 41 may be determined based on the access frequency to each of the semiconductor packages 41. The priority of each of the semiconductor packages 41 may be determined based on the elapsed time since the last access time to each of the semiconductor packages 41. The priority of each of the semiconductor packages 41 may be determined based on a state indicating completion or incompletion of an access process to each of the semiconductor packages 41. The priority of each of the semiconductor packages 41 may be determined based on an estimated remaining time until the access process to each of the semiconductor package 41 is completed. The priority of each of the semiconductor packages 41 may be determined based on an application program executed in the host unit 21. The priority of each of the semiconductor packages 41 may be determined based on the prediction result of a probability of an occurrence of an access request to each of the semiconductor packages 41.

Alternatively, the priority of each of the semiconductor packages 41 may be determined by using combinations of any two or more conditions of the access request, the access frequency, the elapsed time since the last access time, the completion or incompletion of the access process, the estimated remaining time until the completion of the access process, the application program to be executed, and the prediction result of the probability for access.

The host unit 21 can also control the location where each of the plurality of semiconductor packages 41 is present, based on the priority of each of the plurality of semiconductor packages 41. For example, the host unit 21 may control the location where each of the plurality of semiconductor packages 41 is present, based on the priority of each of the plurality of semiconductor packages 41, such that a semiconductor package 41 having a priority of a first level is mounted on a socket of the drive 22, and a semiconductor package 41 having a priority of a second level, which is lower than the priority of the first level, is stored in the package stocker 4.

Note that some of the transport units 31 included in the package transport device 3 may be used as buffers that temporarily hold semiconductor packages 41. In this case, a semiconductor package 41 having the priority of the second level, which is lower than the priority of the first level, is held in a transport unit 31 included in the package transport device 3. Then, a semiconductor package 41 having a priority of a third level, which is lower than the priority of the second level, is stored in the package stocker 4.

A transport unit 31 holding a semiconductor package 41 having the priority of the second level may be moved to a specific evacuation location so as not to interfere with the transporting operation by another transport unit 31. The transport unit 31 holding the semiconductor package 41 having the priority of the second level is also referred to as a "buffer of the package transport device 3" or a "buffer of the robot" below. Each of the transport units 31 included in the package transport device 3 may function as the buffer of the package transport device 3. Therefore, the number of buffers of the package transport device 3 is equal to the number of transport units 31 included in the package transport device 3.

Further, holding a semiconductor package 41, which has been detached from a socket of the drive 22, in the package transport device 3 (that is, the transport unit 31) without storing the detached semiconductor package in the package stocker 4 is also referred to as "transporting the semiconductor package 41 to the buffer of the package transport device 3" below.

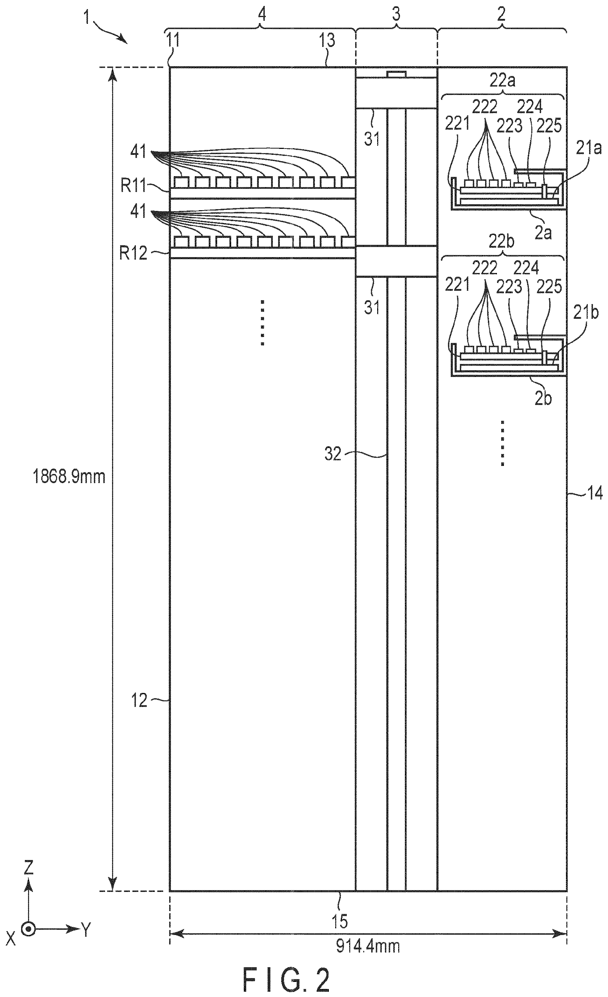

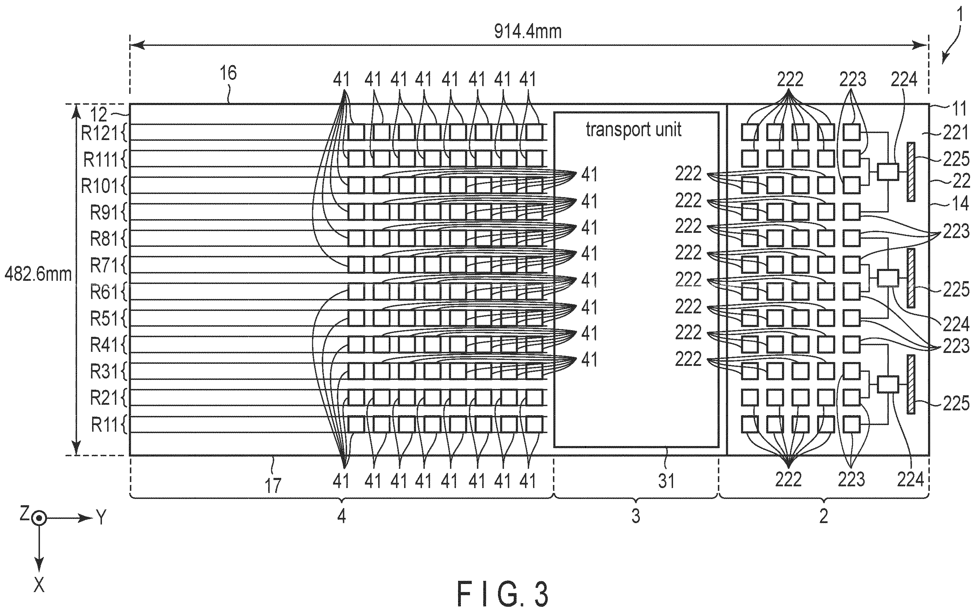

Next, an example of an arrangement of the package stocker 4, the package transport device 3, the drive 22, and the host unit 21 will be described. FIG. 2 is a side view illustrating an example of an arrangement of the package stocker 4, the package transport device 3, the drive 22, and the host unit 21. FIG. 3 is a plan view illustrating an example of an arrangement of the package stocker 4, the package transport device 3, the drive 22, and the host unit 21.

FIGS. 2 and 3 illustrate a configuration in which the package stocker 4, the package transport device 3, the drive 22, and the host unit 21 are arranged in a server rack 11 disposed in a data center.

In the following description of the present embodiment, an X-axis, a Y-axis, and a Z-axis are defined. The X-axis, the Y-axis, and the Z-axis are orthogonal to each other. An X-Y plane defined by the X-axis and the Y-axis corresponds to, for example, a floor of the data center. The Z-axis corresponds to, for example, the height direction of the data center.

The server rack 11 is a rack for accommodating a computer and a communication device. The size and shape of the server rack 11 are defined, for example, by the Electronic Industries Association of America (EIA).

The server rack 11 includes a front plate (front door) 12, a top plate 13, a back plate 14, a floor plate 15, and side plates 16 and 17. The server rack 11 is, for example, a deep type 19-inch rack having a depth of 36 inches (914.4 mm), a height of 73.5 inches (1868.9 mm), and a width of 19 inches (482.6 mm).

In the server rack 11, the package stocker 4 may be disposed on the front plate (front door) 12 side, and the drive 22 and the host unit 21 may be disposed on the back plate 14 side. Furthermore, the package transport device 3 may be disposed near a central part between the front plate (front door) 12 and the back plate 14.

As illustrated in FIG. 2, the drive 22a and the host unit 21a may be accommodated in a housing 2a. Similarly, the drive 22b and the host unit 21b may be accommodated in a housing 2b.

The drive 22a includes a printed circuit board 221, one or more sockets 222, a controller 223, a PCI Express^{™} (PCIe^{™}) switch 224, and a PCIe connector 225. The socket 222, the controller 223, and the PCIe switch 224 are disposed on the printed circuit board 221. A case where a plurality of sockets 222 are disposed on the printed circuit board 221 will be assumed below.

Each of the sockets 222 is a socket on which a semiconductor package 41 is able to be detachably mounted.

The controller 223 is a memory controller that controls one or more nonvolatile memory dies included in the semiconductor package 41 mounted on each of the sockets 222. The controller 223 may be implemented with a large scale integration (LSI) such as a system-on-a-chip (SoC). The number of controllers 223 disposed on the printed circuit board 221 may be one, or two or more. Each of the controllers 223 on the printed circuit board 221 is connected to the PCIe switch 224. The number of PCIe switches 224 disposed on the printed circuit board 221 may be one, or two or more. Each of the PCIe switches 224 is electrically connected to the corresponding PCIe connector 225.

One or more PCIe connectors 225 are disposed on the back surface of the printed circuit board 221 of the drive 22a. The printed circuit board 221 is connected to a system board of the host unit 21a via the one or more PCIe connectors 225.

A processor, a memory, a system controller, a communication interface controller, and the like are provided on the system board of the host unit 21a. The host unit 21a is communicatively connected to the drive 22a via the one or more PCIe connectors 225. The host unit 21a reads or writes data from or to any nonvolatile memory die within the semiconductor package 41 mounted on any socket 222, via the controller 223.

Since a configuration of each of the drive 22b and the host unit 21b is similar to the configuration of each of the drive 22a and the host unit 21a, a detailed description of the configuration of each of the drive 22b and the host unit 21b will be omitted here.

As illustrated in FIG. 2, the package transport device 3 may include a pillar 32 extending in the vertical direction (Z-axis direction) and some transport units 31. Each of the transport units 31 is movable in an up-down direction along the pillar 32. Each of the transport units 31 has an arm (not illustrated) such as a robot hand, and can grip any semiconductor package 41 by using the arm.

For example, when transporting a semiconductor package 41 having been stored at a certain storage location in the package stocker 4 to the drive 22a, one transport unit 31 moves to a height corresponding to the storage location of the semiconductor package 41, which is to be transported, and grips the semiconductor package 41, which is to be transported. Then, the one transport unit 31 moves to a height corresponding to the drive 22a, and mounts the semiconductor package 41, which is to be transported, on one socket 222 of the drive 22a.

Note that, in a case where another semiconductor package 41 is present between the package transport device 3 and the semiconductor package 41 to be transported, first, one transport unit 31 grips this another semiconductor package 41 and moves to an upper portion or a lower portion while gripping this another semiconductor package. Then, another transport unit 31 grips the semiconductor package 41, which is to be transported, and mounts the semiconductor package 41, which is to be transported, on one socket 222 of the drive 22a. Thus, even if multiple semiconductor packages 41 are stored to be arranged along a direction from the package transport device 3 toward the front plate 12 (i.e., the -Y direction illustrated in FIG. 2), it is possible to transport any semiconductor package 41 among the multiple semiconductor packages 41.

As illustrated in FIG. 2, the package stocker 4 includes one or more pairs of rails (rail pair R11, rail pair R12, ...) on which a plurality of semiconductor packages 41 can be placed.

Next, an example of a configuration of the drive 22 and the package stocker 4 will be described in detail with reference to the plan view of FIG. 3.

The drive 22 includes, for example, 48 pieces of the sockets 222 arranged in 12 rows × 4 columns, 12 pieces of the controllers 223, three PCIe switches 224, and three PCIe connectors 225 respectively connected to the three PCIe switches 224. Each of the 12 pieces of the controllers 223 controls the four semiconductor packages 41 mounted on the corresponding four sockets 222 in one row. Each of the three PCIe switches 224 is connected to the corresponding four controllers 223. Each of the three PCIe switches 224 communicates with the corresponding four controllers 223.

The package stocker 4 includes a plurality of pairs of rails (here, 12 pieces of rail pairs R11 to R121). In each of the rail pairs R11 to R121, some semiconductor packages 41 can be placed. Each of the rail pairs R11 to R121 includes a pair of rails extending parallel to each other along the Y-axis direction. A semiconductor package 41 that is placed on a certain rail pair can slide and move along the rail pair.

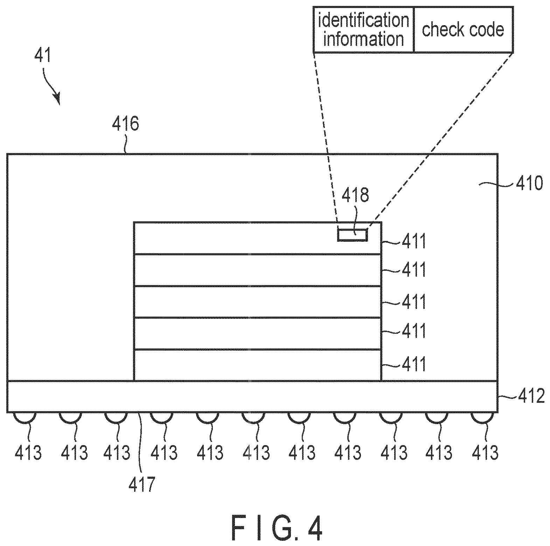

Next, a configuration of the semiconductor package 41 will be described. FIG. 4 is a diagram illustrating an example of the configuration of the semiconductor package 41 used in the storage system 1 according to the present embodiment.

The semiconductor package 41 is, for example, a ball grid array (BGA) package. The semiconductor package 41 includes a plurality of nonvolatile memory dies 411, a package board 412, a plurality of ball-type metal terminals 413, a first surface (front surface) 416, and a second surface (back surface) 417 opposite to the first surface 416.

The plurality of nonvolatile memory dies 411 are stacked in the vertical direction on the surface of the package board 412. The plurality of nonvolatile memory dies 411 are covered and sealed with, for example, a molding resin 410. Each of the nonvolatile memory dies 411 includes channel terminals corresponding to one channel. The channel terminals corresponding to one channel include a chip enable signal terminal, a plurality of I/O terminals, a plurality of control signal terminals, and the like.

The upper surface of the molding resin 410 forms the first surface 416 of the semiconductor package 41. The lower surface of the package board 412 forms the second surface 417 of the semiconductor package 41.

The plurality of ball-type metal terminals 413 are disposed on the second surface 417. The plurality of ball-type metal terminals 413 include a plurality of signal terminals corresponding to a plurality of channels. The ball-type metal terminals 413 are connected to the channel terminals of the plurality of nonvolatile memory dies 411 included in the semiconductor package 41.

A part of the storage area of at least one of the plurality of nonvolatile memory dies 411 included in the semiconductor package 41 is used as an identification information storage area 418. The identification information storage area 418 stores identification information for identifying this semiconductor package 41. As the identification information, an identifier (package identifier) that is capable of uniquely identifying each semiconductor package 41 may be used. The package identifier may be stored in the identification information storage area 418 together with a check code. The check code is a code for verifying the integrity of the package identifier. The check code is, for example, a cyclic redundancy code (CRC), another type of parity different from the CRC, or a hash value calculated from the identification information.

By storing the pair of the identification information (package identifier) and the check code in the identification information storage area 418, it is possible to verify the integrity of a value read as the identification information from the identification information storage area 418.

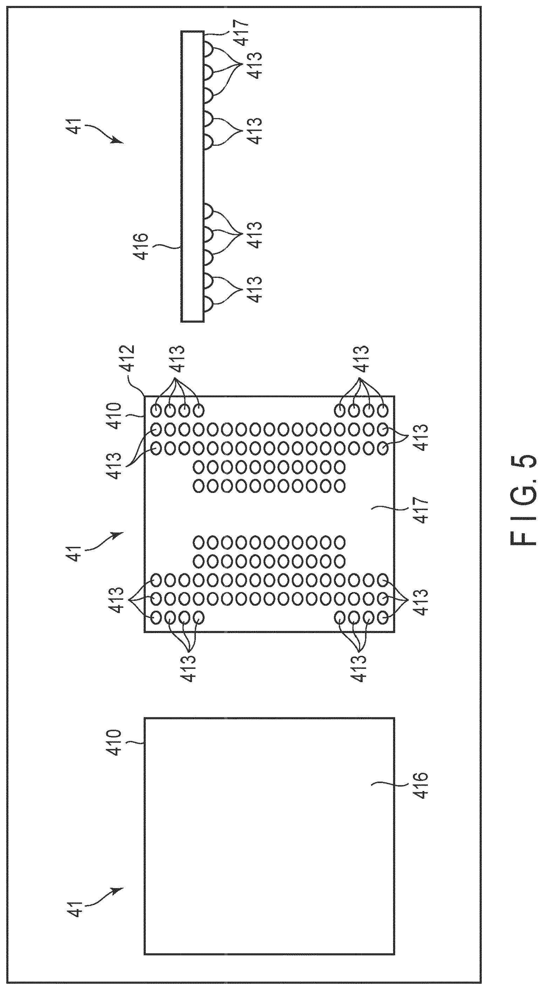

FIG. 5 is a diagram illustrating shapes of a front surface, a back surface, and a side surface of the semiconductor package 41. The left part of FIG. 5 is a plan view of the semiconductor package 41 as viewed from the upper surface side, and the central part of FIG. 5 is a plan view of the semiconductor package 41 as viewed from the lower surface side. In addition, the right part of FIG. 5 is a side view of the semiconductor package 41.

The front surface 416 of the semiconductor package 41 (that is, the upper surface of the molding resin 410) is used as a marking surface. A plurality of ball-type metal terminals 413 are disposed on the back surface 417 of the semiconductor package 41 (that is, the lower surface of the package board 412). Note that, on the back surface 417 of the semiconductor package 41, there is an area where no ball-type metal terminal 413 is disposed. Specifically, no ball-type metal terminal 413 is disposed in the outermost peripheral area of the back surface 417.

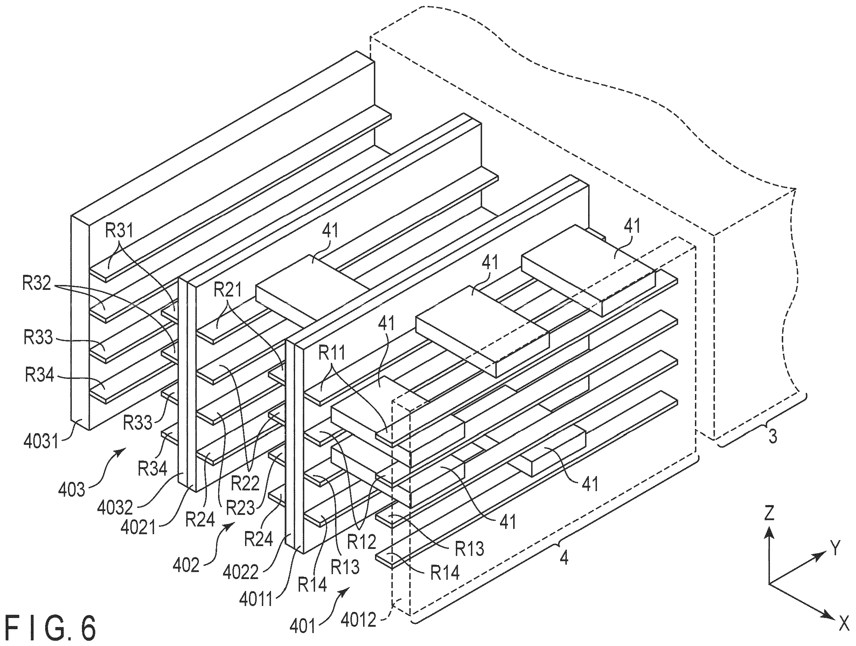

Next, a configuration of the package stocker 4 will be described. FIG. 6 is a perspective view illustrating a plurality of pairs of rails included in the package stocker 4.

FIG. 6 illustrates a case where three rail units 401 to 403 are provided in the package stocker 4.

The rail unit 401 includes two side walls 4011 and 4012 facing each other at a distance, and four rail pairs R11 to R14 disposed inside the two side walls 4011 and 4012. The rail pair R11 includes a pair of rails that are opposed to each other at a distance and extend parallel to each other. By using such a rail structure having a gap between the rails, it is possible to support the semiconductor package 41 while avoiding the ball-type metal terminals 413 disposed on the back surface of the semiconductor package 41 from contacting with the rails. That is, only the outermost peripheral area of the back surface of the semiconductor package 41, where the ball-type metal terminal 413 is not provided, comes into contact with the rail pair R11. Each of the other rail pairs R12 to R14 has a configuration similar to that of the rail pair R11.

The rail unit 402 includes two side walls 4021 and 4022 facing each other at a distance, and four rail pairs R21 to R24 disposed inside the two side walls 4021 and 4022. The rail pair R21 includes a pair of rails that are opposed to each other at a distance and extend parallel to each other. Each of the other rail pairs R22 to R24 has a configuration similar to that of the rail pair R21.

The rail unit 403 includes two side walls 4031 and 4032 facing each other at a distance, and four rail pairs R31 to R34 disposed inside the two side walls 4031 and 4032. The rail pair R31 includes a pair of rails that are opposed to each other at a distance and extend parallel to each other. Each of the other rail pairs R32 to R34 has a configuration similar to that of the rail pair R31.

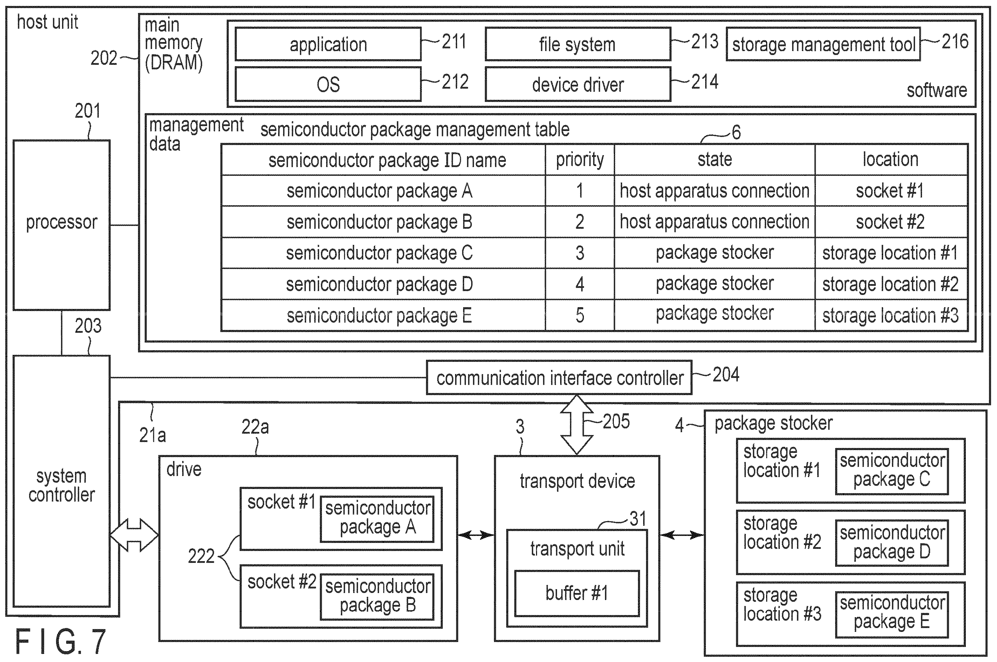

Next, a configuration of the host unit 21 will be described. FIG. 7 is a block diagram illustrating an example of a configuration of the host unit 21. Here, the host unit 21a, which is one of a plurality of host units 21 provided in the storage system 1, will be described.

The host unit 21a includes a processor 201, a main memory 202, a system controller 203, a communication interface controller 204, and the like. The processor 201, the main memory 202, the system controller 203, and the communication interface controller 204 are mounted on the system board of the host unit 21a.

The main memory 202 is, for example, a dynamic random access memory (DRAM).

The communication interface controller 204 communicates with the package transport device 3 via a communication interface 205. As the communication interface 205, for example, an interface conforming to a standard of Ethernet may be used. In this case, the communication interface controller 204 may be, for example, a network interface controller (NIC). Note that the communication interface controller 204 may also be used for communication with the management server 5.

The processor 201 executes various programs (software) loaded on the main memory 202. These programs may include, for example, an application program 211, an operating system (OS) 212, a file system 213, a device driver 214 for controlling the drive 22a, a storage management tool 216, and the like. The storage management tool 216 is a program for managing each of the semiconductor packages 41 and controlling the transport of each of the semiconductor packages 41.

In the following description, description that a program executes a certain process means that the host unit 21a (more specifically, the processor 201) executes the process by executing the program.

The host unit 21a (more specifically, the processor 201) can manage a semiconductor package management table 6 under the control of the storage management tool 216. The semiconductor package management table 6 is management data for the plurality of semiconductor packages 41. The semiconductor package management table 6 may be stored in the main memory 202.

The host unit 21a is configured to assign a unique semiconductor package identification name to each semiconductor package 41. The host unit 21a uses the semiconductor package management table 6 to manage the semiconductor package identification name of each of the semiconductor packages 41, the priority of each of the semiconductor packages 41, the state of each of the semiconductor packages 41, and the location of each of the semiconductor packages. A semiconductor package 41 having a certain semiconductor package identification name may be described below by using the semiconductor package identification name. For example, a semiconductor package 41 having a semiconductor package identification name "semiconductor package A" may be referred to as a semiconductor package A.

FIG. 7 illustrates an example in which the host unit 21a identifies each of the plurality of semiconductor packages 41 used in the storage system 1 by using each of a semiconductor package A, a semiconductor package B, ..., and a semiconductor package E, which are semiconductor package identification names.

The host unit 21a stores the priority of each of the plurality of semiconductor packages 41 in the semiconductor package management table 6. Then, the host unit 21a instructs the package transport device 3 to transport a semiconductor package 41, based on the priority managed in the semiconductor package management table 6.

The host unit 21a stores, in the semiconductor package management table 6, information indicating whether each of the plurality of semiconductor packages 41 has been connected to the host unit 21a, has been stored in the package stocker 4, or has been held in a transport unit 31 of the package transport device 3, as the state of each of the semiconductor packages 41.

Here, a state in which a certain semiconductor package 41 has been connected to the host unit 21a means a state in which this semiconductor package 41 has been mounted on a socket 222 of the drive 22a. Therefore, when a certain semiconductor package 41 has been connected to the host unit 21a, the host unit 21a can recognize that this semiconductor package 41 has been mounted on the socket 222, which is included in the drive 22a connected to the host unit 21a. Then, the host unit 21a can recognize that it is possible to read and write data from and to a nonvolatile memory die 411 of this semiconductor package 41.

In addition, a state in which a certain semiconductor package 41 has been stored in the package stocker 4 means that this semiconductor package 41 has been placed on any rail pair of the package stocker 4. Therefore, when a certain semiconductor package 41 has been stored in the package stocker 4, this semiconductor package 41 is not mounted on a socket 222 provided in the drive 22a, so that the host unit 21a can recognize that it is not possible to read and write data from and to a nonvolatile memory die 411 of this semiconductor package 41.

The host unit 21a stores location information of the semiconductor package 41 in the semiconductor package management table 6 as information indicating a location where a respective one of the plurality of semiconductor packages 41 is mounted or stored.

When a certain semiconductor package 41 is connected to the host unit 21a, the host unit 21a stores, in the semiconductor package management table 6, a socket number indicating a socket 222 on which this semiconductor package 41 is mounted, as the location information of this semiconductor package 41.

In addition, when a certain semiconductor package 41 is stored in the package stocker 4, the host unit 21a stores, in the semiconductor package management table 6, a storage location number indicating a location in the package stocker 4 where this semiconductor package 41 is stored, as the location information of this semiconductor package 41.

In the example illustrated in FIG. 7, a semiconductor package 41 having the semiconductor package identification name "semiconductor package A" has the highest priority (priority = 1st). The semiconductor package 41 having the semiconductor package identification name "semiconductor package A" has been mounted on a socket #1 of the drive 22a. A semiconductor package 41 having the semiconductor package identification name "semiconductor package B" has the second highest priority (priority = 2nd). The semiconductor package 41 having the semiconductor package identification name "semiconductor package B" has been mounted on a socket #2 of the drive 22a. Further, a semiconductor package 41 having the semiconductor package identification name "semiconductor package C" has the third highest priority (priority = 3rd). The semiconductor package 41 having the semiconductor package identification name "semiconductor package C" has been stored in a storage location #1 of the package stocker 4. A semiconductor package 41 having the semiconductor package identification name "semiconductor package D" has the fourth highest priority (priority = 4th). The semiconductor package 41 having the semiconductor package identification name "semiconductor package D" has been stored in a storage location #2 of the package stocker 4. A semiconductor package 41 having the semiconductor package identification name "semiconductor package E" has the fifth highest priority (priority = 5th). The semiconductor package 41 having the semiconductor package identification name "semiconductor package E" has been stored in a storage location #3 of the package stocker 4.

Further, a distance between the storage location #2 and the package transport device 3 is longer than a distance between the storage location #1 and the package transport device 3. In addition, a distance between the storage location #3 and the package transport device 3 is longer than the distance between the storage location #2 and the package transport device 3. Therefore, the semiconductor package C stored in the storage location #1 can be more easily taken out by the transport unit 31 than the semiconductor package D stored in the storage location #2. Further, the semiconductor package D stored in the storage location #2 can be more easily taken out by the transport unit 31 than the semiconductor package E stored in the storage location #3. The host unit 21a may instruct the package transport device 3 to store a semiconductor package 41 having a higher priority in a storage location where the semiconductor package 41 can be more easily taken out, according to the priority of each of the semiconductor packages 41.

Further, the host unit 21a may use a transport unit 31 as a buffer. At this time, the host unit 21a may instruct the package transport device 3 such that the transport unit 31 holds a semiconductor package 41 having the highest priority among a plurality of semiconductor packages 41 stored in the package stocker 4.

Note that the storage management tool 216 also executes a process for managing data and its amount stored in each of the semiconductor packages 41 which are not mounted on any socket 222 of the drive 22a (also referred to as offline packages). For example, the storage management tool 216 executes a process for managing data and its amount stored in each of the semiconductor packages 41 stored in the package stocker 4. The storage management tool 216 can report the data and its amount stored in each of the offline packages to the OS 212 or the file system 213. Thus, the OS 212 or the file system 213 can manage not only the data stored in each of the semiconductor packages 41 that are currently mounted on the sockets 222 of the drive 22a but also the data and its amount stored in each of the offline packages.

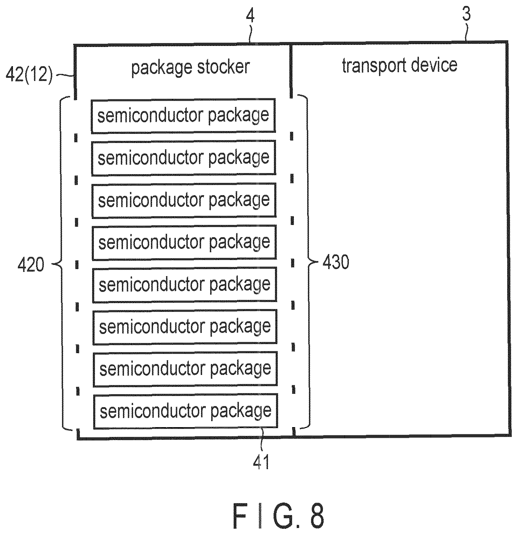

Next, a package loading/unloading slot used when a semiconductor package 41 is added to the package stocker 4 and when a semiconductor package 41 is ejected from the package stocker 4 will be described. FIG. 8 is a diagram illustrating a package loading/unloading slot of the package stocker 4.

The package stocker 4 includes a package loading/unloading slot 420 used to add a semiconductor package 41 to the package stocker 4 from the outside of the package stocker 4, and to eject a semiconductor package 41 from the package stocker 4 to the outside of the package stocker 4. The package loading/unloading slot 420 is an opening provided in the front surface 42 of the package stocker 4. The front surface 42 corresponds to the front surface 12 of the server rack 11.

A semiconductor package 41 is added to the package stocker 4 from the outside of the package stocker 4 through the package loading/unloading slot 420 provided in the package stocker 4. The added semiconductor package 41 is stored in the package stocker 4 together with a plurality of semiconductor packages 41 already stored.

Further, an unnecessary semiconductor package 41 is ejected from the package stocker 4 to the outside of the package stocker 4 through the package loading/unloading slot 420 provided in the package stocker 4.

The package stocker 4 includes a package loading/unloading slot 430 provided in a surface on a side facing the package transport device 3 in addition to the package loading/unloading slot 420 provided in the front surface 42 of the package stocker 4. The package loading/unloading slot 430 is used to store a semiconductor package 41 in the package stocker 4 and to take out a semiconductor package 41 from the package stocker 4. The package transport device 3 executes an operation of storing a semiconductor package 41 in the package stocker 4 through the package loading/unloading slot 430 and an operation of taking out a semiconductor package 41 from the package stocker 4 through the package loading/unloading slot 430. The package loading/unloading slot 430 is provided, for example, in the back surface of the package stocker 4 and is located on the opposite side of the package loading/unloading slot 420. In addition, although not illustrated here, a plurality of pairs of rails extend in a direction from the package loading/unloading slot 420 of the package stocker 4 toward the package transport device 3, that is, in a direction from the package loading/unloading slot 420 toward the package loading/unloading slot 430.

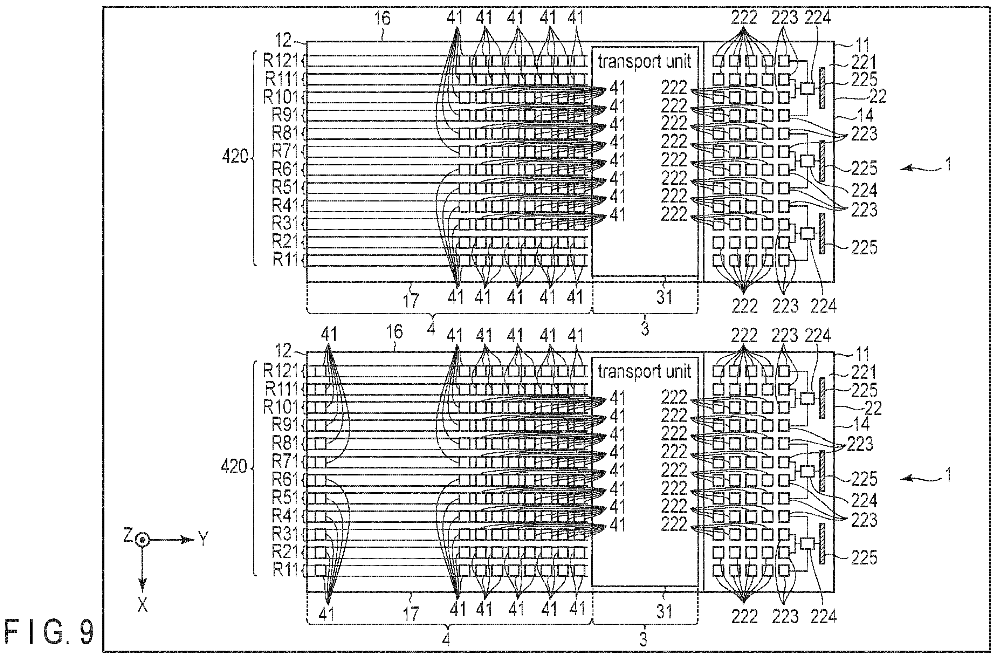

Next, an operation of adding a semiconductor package 41 to the package stocker 4 from the outside will be described. FIG. 9 is a diagram illustrating an operation of adding a new semiconductor package 41 to the package stocker 4 through the package loading/unloading slot 420 of the package stocker 4.

The upper part of FIG. 9 is a plan view of a server rack 11 before a new semiconductor package is added. The lower part of FIG. 9 is a plan view of the server rack 11 after 12 pieces of new semiconductor packages are added.

As can be seen from FIG. 9, the package transport device 3 opposes the package loading/unloading slot 420 provided in the front surface 12 of the server rack 11. Each of the 12 pieces of rail pairs R11 to R121 extends in a direction (Y direction) from the package loading/unloading slot 420 toward the package transport device 3.

As illustrated in the upper part of FIG. 9, 96 pieces of semiconductor packages 41 are already placed on the 12 pieces of the rail pairs R11 to R121. The 96 pieces of the semiconductor packages 41 are semiconductor packages already stored in the package stocker 4.

Here, it is assumed that 12 pieces of semiconductor packages 41 are added to the package stocker 4. In this case, as illustrated in the lower part of FIG. 9, the 12 pieces of semiconductor packages 41 are respectively placed on the rail pairs R11 to R121 through the package loading/unloading slot 420 by, for example, a robot or an operator. As a result, the 12 pieces of the semiconductor packages 41 are stored in the package stocker 4.

As described above, in the package stocker 4, the plurality of rail pairs R11 to R121 each extending in the direction from the package loading/unloading slot 420 toward the package transport device 3 are provided. Therefore, it is possible to easily add and eject a semiconductor package 41 through the package loading/unloading slot 420.

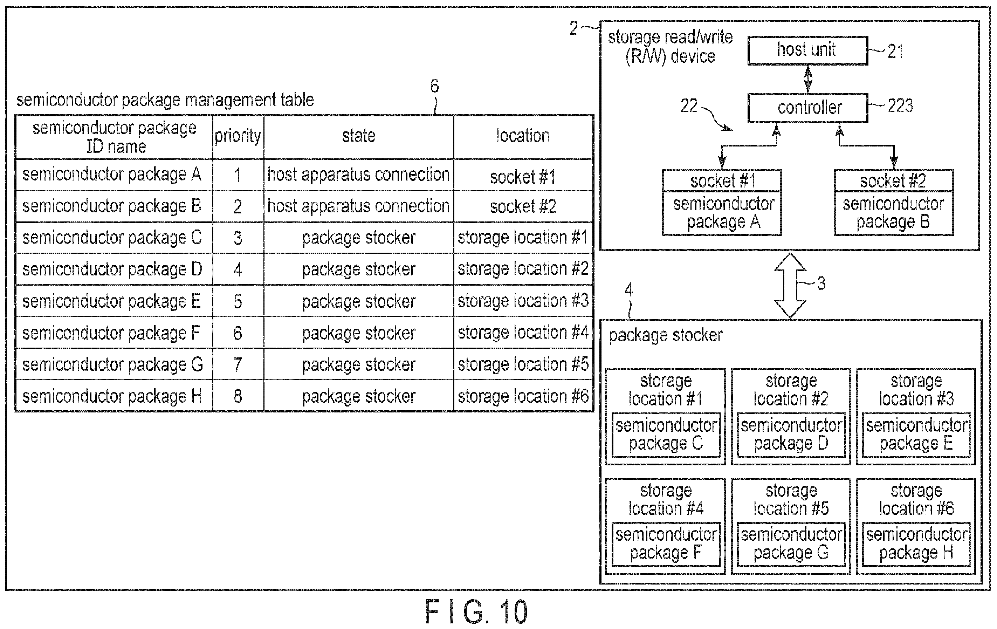

Next, transporting and mounting/detaching operations of a semiconductor package 41 controlled by the host unit 21 will be described. FIG. 10 is a diagram illustrating an operation of changing a location of a semiconductor package 41 between the package stocker 4 and a socket 222 of the drive 22 based on change in the priority of the semiconductor package 41, which is executed in the storage system 1 according to the present embodiment.

The host unit 21 manages the priority of each of the semiconductor packages 41 provided in the storage system 1 by using the semiconductor package management table 6. Then, the host unit 21 instructs the package transport device 3 to transport and mount/detach a semiconductor package 41 based on the priority of each of the semiconductor packages 41 provided in the storage system 1.

In the example illustrated in FIG. 10, the host unit 21 manages eight semiconductor packages 41 including a semiconductor package A, a semiconductor package B, ..., and a semiconductor package H. The host unit 21 instructs the package transport device 3 to mount the semiconductor package A having the highest priority among the managed semiconductor packages 41 on, for example, the socket #1, and to mount the semiconductor package B having the second highest priority among the managed semiconductor packages on, for example, the socket #2. As a result, information indicating that the semiconductor package A and the semiconductor package B are respectively mounted on the socket #1 and the socket #2 is stored in the semiconductor package management table 6. As described above, when the number of sockets provided in the drive 22 is two, the two semiconductor packages A to B having the priorities of 1st to 2nd are mounted on the two sockets #1 to #2 of the drive 22, respectively. The priorities of 1st to 2nd correspond to the priority of the first level.

In addition, the six semiconductor packages 41 (semiconductor packages C to H) having the priorities of 3rd to 8th are stored in the package stocker 4. The package stocker 4 may include at least two types of storage locations, i.e., a first storage location and a second storage location. The distance between the first storage location and the package transport device 3 is shorter than the distance between the second storage location and the package transport device 3. The first storage location includes, for example, storage locations #1 to #3. The second storage location includes, for example, storage locations #4 to #6. For the package transport device 3, the storage locations #1 to #3 are storage locations where a semiconductor package 41 can be more easily taken out than the storage locations #4 to #6.

Among the six semiconductor packages 41 stored in the package stocker 4, the three semiconductor packages C to E having the priorities of 3rd to 5th are stored in the storage locations #1 to #3 included in the first storage location. The priorities of 3rd to 5th correspond to the priority of the second level which is lower than the priority of the first level.

In addition, among the six semiconductor packages 41 stored in the package stocker 4, the three semiconductor packages F to H having the priorities of 6th to 8th are stored in the storage locations #4 to #6 included in the second storage location. The priorities of 6th to 8th correspond to the priority of the third level which is lower than the priority of the second level.

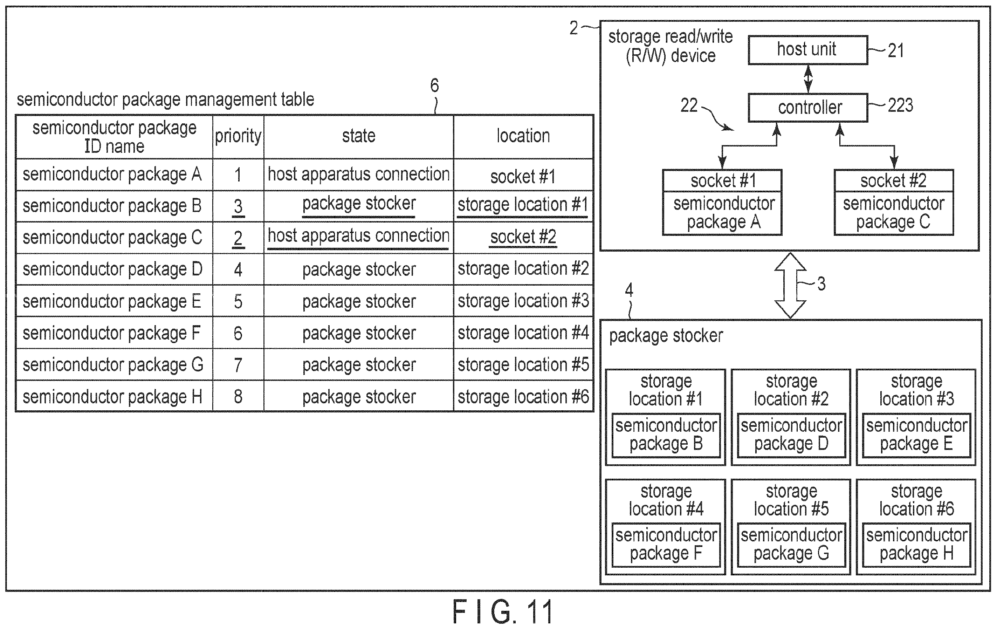

Here, an operation of the host unit 21 when the priority of the semiconductor package C stored in the package stocker 4 exceeds the priority of the semiconductor package B will be described. FIG. 11 is another diagram illustrating an operation of changing a location of a semiconductor package 41 between the package stocker 4 and a socket 222 of the drive 22 based on change in the priority of the semiconductor package 41, which is executed in the storage system 1 according to the present embodiment.

For example, it is assumed that the priority of the semiconductor package C increases from 3rd to 2nd and the priority of the semiconductor package B decreases from 2nd to 3rd. First, the host unit 21 instructs the package transport device 3 to detach the semiconductor package B from the socket #2, to transport the semiconductor package C to the drive 22, to mount the semiconductor package C on the socket #2, and to transport the detached semiconductor package B to, for example, the storage location #1 of the package stocker 4. The package transport device 3 detaches the semiconductor package B from the socket #2, transports the semiconductor package C to the socket #2 from which the semiconductor package B has been detached, mounts the semiconductor package C on the socket #2, and transports the detached semiconductor package B to the storage location #1 of the package stocker 4.

Then, the host unit 21 updates the semiconductor package management table 6. Specifically, the host unit 21 stores, in the semiconductor package management table 6, information indicating that the semiconductor package B is stored in the storage location #1 of the package stocker 4, and information indicating that the semiconductor package C is mounted on the socket #2.

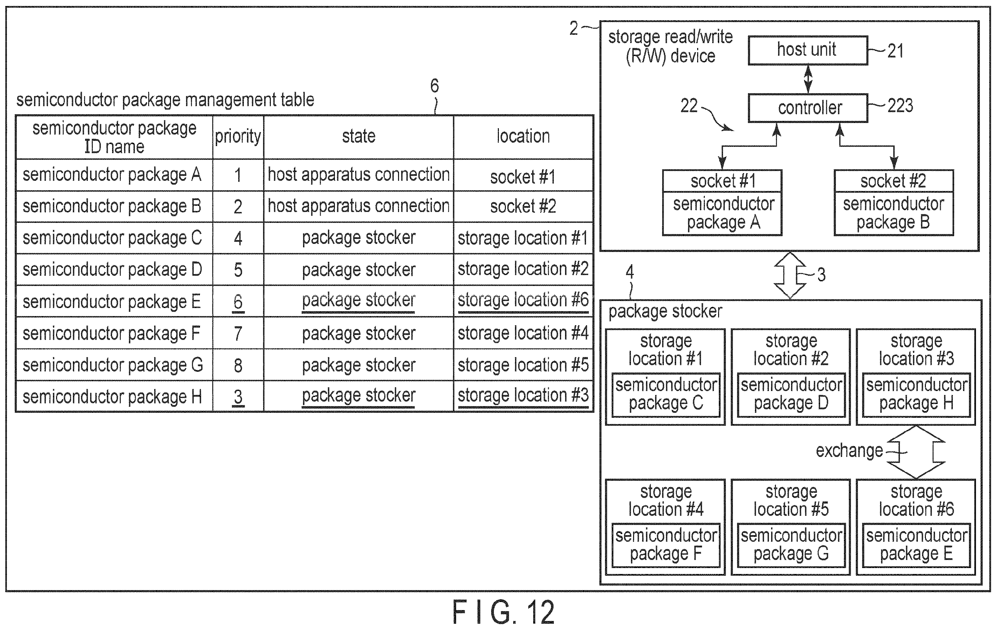

Next, an operation of changing a storage location in the package stocker 4 where a semiconductor package 41 is stored will be described. FIG. 12 is a diagram illustrating an operation of changing a location of a semiconductor package 41 in the package stocker 4 based on change in the priority of the semiconductor package 41, which is executed in the storage system 1 according to the present embodiment.

Here, for example, it is assumed that, in the state illustrated in FIG. 10, the priority of the semiconductor package H increases from 8th to 3rd, and the priorities of the semiconductor packages C to G decreases from the priorities of 3rd to 7th to the priorities of 4th to 8th. The new priority (3rd) of the semiconductor package H belongs to the priority of the second level, and the new priority (6th) of the semiconductor package E belongs to the priority of the third level. Therefore, the host unit 21 instructs the package transport device 3 to exchange the storage location of the semiconductor package H and the storage location of the semiconductor package E with each other. First, the package transport device 3 takes out the semiconductor package E from the storage location #3 of the package stocker 4. Then, the package transport device 3 further takes out the semiconductor package H from the storage location #6 of the package stocker 4. Thereafter, the package transport device 3 stores the semiconductor package E in the storage location #6 of the package stocker 4. Then, the package transport device 3 stores the semiconductor package H in the storage location #3 of the package stocker 4.

Then, the host unit 21 updates the semiconductor package management table 6. Specifically, the host unit 21 stores, in the semiconductor package management table 6, information indicating that the semiconductor package E is stored in the storage location #6 of the package stocker 4, and information indicating that the semiconductor package H is stored in the storage location #3 of the package stocker 4.

By the above operation, the host unit 21 can control such that a semiconductor package 41 having a higher priority among the semiconductor packages 41 stored in the package stocker 4 is stored in a storage location (here, the storage location #1) where the package transport device 3 can easily take out the semiconductor package 41. As a result, when the priority of the semiconductor package 41 stored in the storage location #1 of the package stocker 4 exceeds the priority of the second level, it is possible to shorten the time required to transport this semiconductor package 41 from the package stocker 4 to a socket 222 of the drive 22.

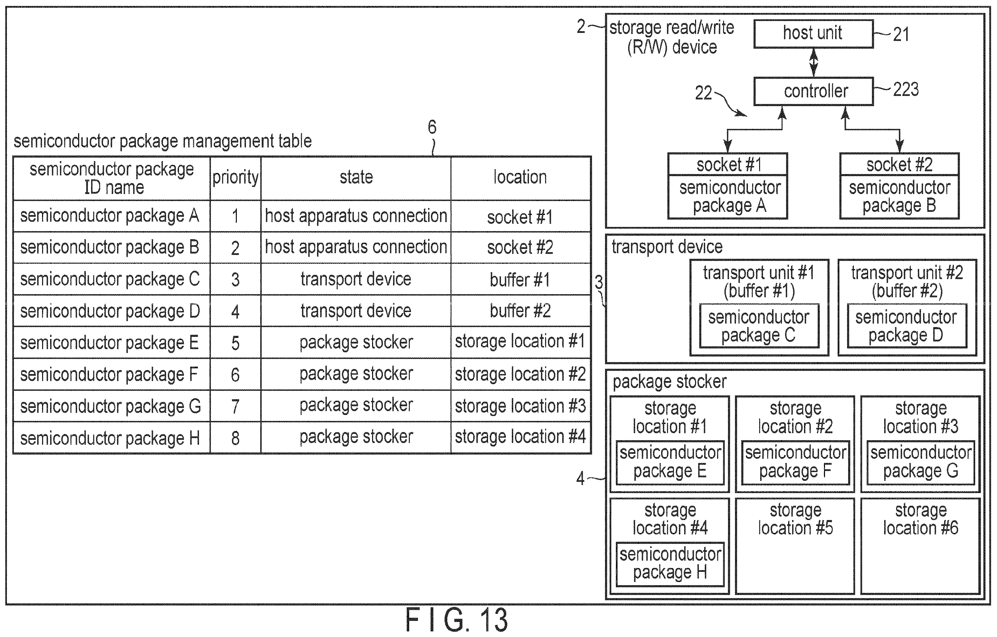

Next, the transporting and mounting/detaching operations of a semiconductor package 41 controlled by the host unit 21 when a buffer of the package transport device 3 is available will be described. FIG. 13 is a diagram illustrating an operation of changing a location of a semiconductor package 41 among the package stocker 4, the package transport device 3, and a socket 222 of the drive 22, based on change in the priority of the semiconductor package 41, which is executed in the storage system according to the present embodiment.

The host unit 21 manages eight semiconductor packages 41 including a semiconductor package A, a semiconductor package B, ..., and a semiconductor package H. The host unit 21 instructs the package transport device 3 to mount the semiconductor package A having the highest priority among the managed semiconductor packages 41 on, for example, the socket #1 of the drive 22 and to mount the semiconductor package B having the second highest priority among the managed semiconductor packages 41 on, for example, the socket #2 of the drive 22. The package transport device 3 transports the semiconductor package A to the socket #1 of the drive 22, and mounts the semiconductor package A on the socket #1. In addition, the package transport device 3 transports the semiconductor package B to the socket #2 of the drive 22, and mounts the semiconductor package B on the socket #2. The host unit 21 stores information indicating that the semiconductor package A and the semiconductor package B are respectively mounted on the socket #1 and the socket #2, in the semiconductor package management table 6.

As described above, when the number of sockets provided in the drive 22 is two, the two semiconductor packages A to B having the priorities of 1st to 2nd are mounted on the two sockets #1 and #2 of the drive 22, respectively. The priorities of 1st to 2nd correspond to the priority of the first level.

In addition, the host unit 21 instructs the package transport device 3 to hold the two semiconductor packages C and D having the priorities of 3rd to 4th. The priorities of 3rd to 4th correspond to the priority of the second level which is lower than the priority of the first level.

The package transport device 3 (for example, the transport unit #1) that has received the instruction holds the semiconductor package C. In addition, the package transport device 3 (for example, the transport unit #2) that has received the instruction holds the semiconductor package D. Thus, the two semiconductor packages C to D having the priorities of 3rd to 4th are held in the package transport device 3. That is, the transport unit #1 that holds the semiconductor package C is used as a buffer #1 of the package transport device 3, and the transport unit #2 that holds the semiconductor package D is used as a buffer #2 of the package transport device 3.

As a result, the host unit 21 stores information indicating that the semiconductor package C and the semiconductor package D are respectively held in the transport unit #1 (buffer #1) and the transport unit #2 (buffer #2), in the semiconductor package management table 6.

In addition, the four semiconductor packages E to H having the priorities of 5th to 8th are stored in the package stocker 4. Among the four semiconductor packages 41 stored in the package stocker 4, the three semiconductor packages E to G having the priorities of 5th to 7th are stored in the storage locations #1 to #3 included in the first storage location. The priorities of 5th to 7th correspond to the priority of the third level which is lower than the priority of the second level.

Among the four semiconductor packages 41 stored in the package stocker 4, the semiconductor package H having the priority of 8th is stored in any one of the storage locations #4 to #6 (for example, the storage location #4) included in the second storage location.

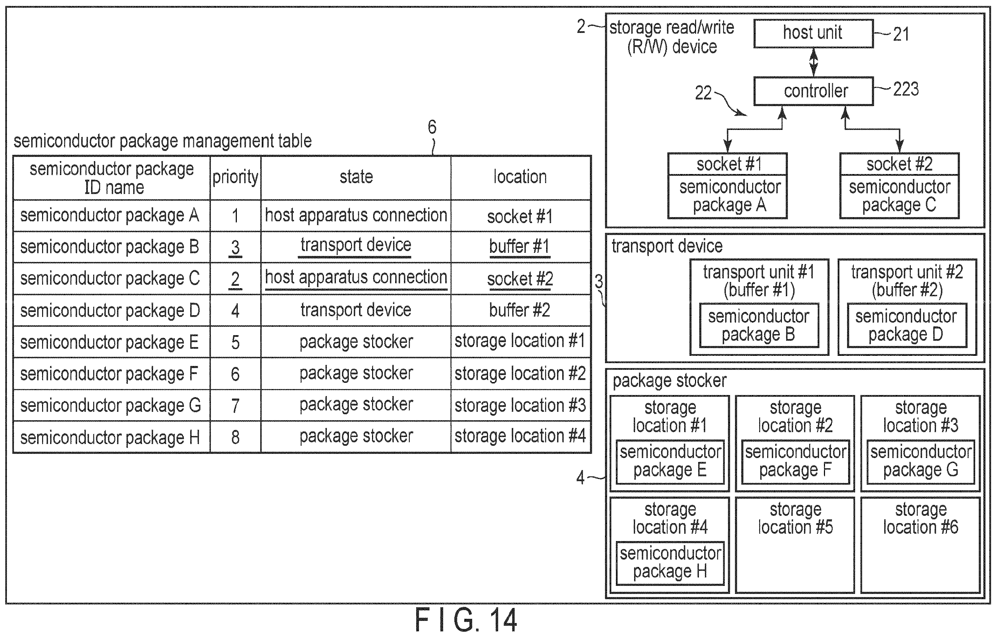

Here, an operation of the host unit 21 when the priority of the semiconductor package C held in the buffer #1 of the package transport device 3 exceeds the priority of the semiconductor package B will be described. FIG. 14 is a diagram illustrating an operation of changing a location of a semiconductor package 41 between the package transport device 3 and a socket 222 of the drive 22 based on change in the priority of the semiconductor package 41, which is executed in the storage system 1 according to the present embodiment.

For example, it is assumed that the priority of the semiconductor package C increases from 3rd to 2nd, and the priority of the semiconductor package B decreases from 2nd to 3rd. First, the host unit 21 instructs the package transport device 3 to detach the semiconductor package B from the socket #2, to transport the semiconductor package C to the drive 22, to mount the semiconductor package C on the socket #2, and to hold the detached semiconductor package B in the package transport device 3. The package transport device 3 detaches the semiconductor package B from the socket #2. Then, the package transport device 3 transports the semiconductor package C held by the transport unit #1 to the socket #2 from which the semiconductor package B has been detached, and mounts the semiconductor package C on the socket #2. The detached semiconductor package B is maintained in a state of being held in the package transport device 3 (for example, the transport unit #1).

In response to the above operation, the host unit 21 updates the semiconductor package management table 6. Specifically, the host unit 21 stores, in the semiconductor package management table 6, information indicating that the semiconductor package B is held in the buffer #1 of the package transport device 3 and information indicating that the semiconductor package C is mounted on the socket #2.

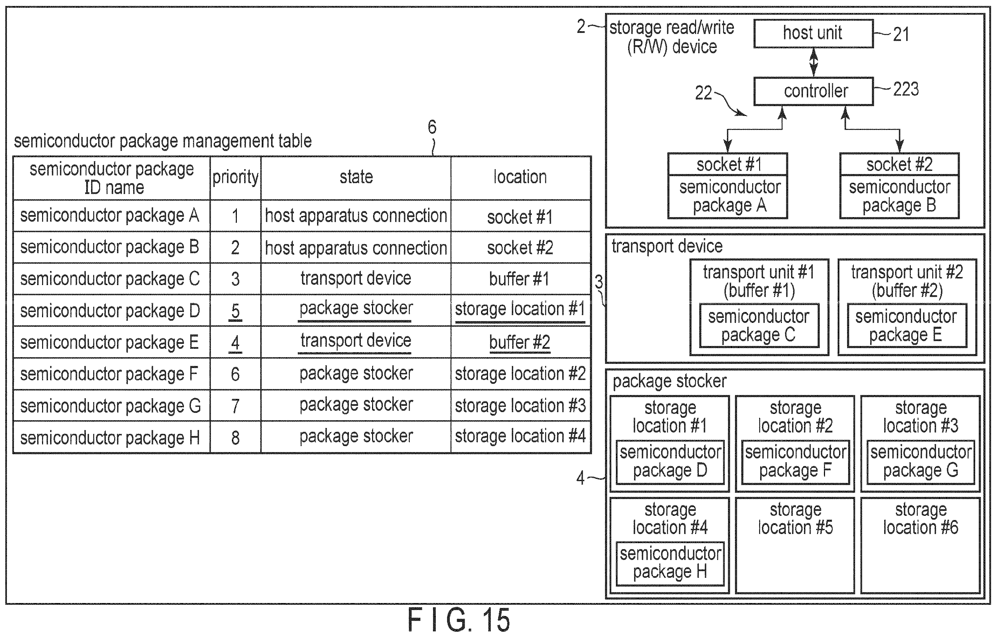

Next, an exchange operation when the priority of a semiconductor package 41 stored in the package stocker 4 exceeds the priority of a semiconductor package 41 held in a buffer of the package transport device 3 will be described. FIG. 15 is a diagram illustrating an operation of changing a location of a semiconductor package 41 between the package stocker 4 and the package transport device 3 based on change in the priority of the semiconductor package 41, which is executed in the storage system 1 according to the present embodiment.

Here, for example, it is assumed that, in the state illustrated in FIG. 13, the priority of the semiconductor package E increases from 5th to 4th and the priority of the semiconductor package D decreases from 4th to 5th. The new priority (4th) of the semiconductor package E belongs to the priority of the second level, and the new priority (5th) of the semiconductor package D belongs to the priority of the third level. Therefore, the host unit 21 instructs the package transport device 3 to exchange the location of the semiconductor package E and the location of the semiconductor package D with each other. Specifically, first, the host unit 21 instructs the package transport device 3 to transport the semiconductor package D to the storage location #1 of the package stocker 4, and further instructs the package transport device 3 to hold the semiconductor package E in the transport unit #2. The package transport device 3 that has received the instruction transports the semiconductor package D held by the transport unit #2 to the storage location #1 of the package stocker 4. Then, the transport unit #2 exchanges the semiconductor package E stored in the storage location #1 of the package stocker 4 with the semiconductor package D held in the transport unit #2. The transport unit #2 then holds the semiconductor package E as the buffer #2.

In response to the above operation, the host unit 21 updates the semiconductor package management table 6. Specifically, the host unit 21 stores, in the semiconductor package management table 6, information indicating that the semiconductor package D is stored in the storage location #1 of the package stocker 4, and information indicating that the semiconductor package E is held in the transport unit #2 (buffer #2) of the package transport device 3.

By the above operation, the host unit 21 can cause the package transport device 3 to hold, in advance, a semiconductor package 41 having a higher priority among the semiconductor packages 41 stored in the package stocker 4. As a result, when the priority of the semiconductor package 41 held in the transport unit 31 exceeds the priority of the semiconductor package 41 connected to a socket 222, it is possible to eliminate the time required for the package transport device 3 to take out the semiconductor package 41 from the package stocker 4. That is, by using a buffer of the package transport device 3, it is possible to greatly reduce the time required for moving the semiconductor package 41 as compared with adjustment of the storage location in the package stocker 4.

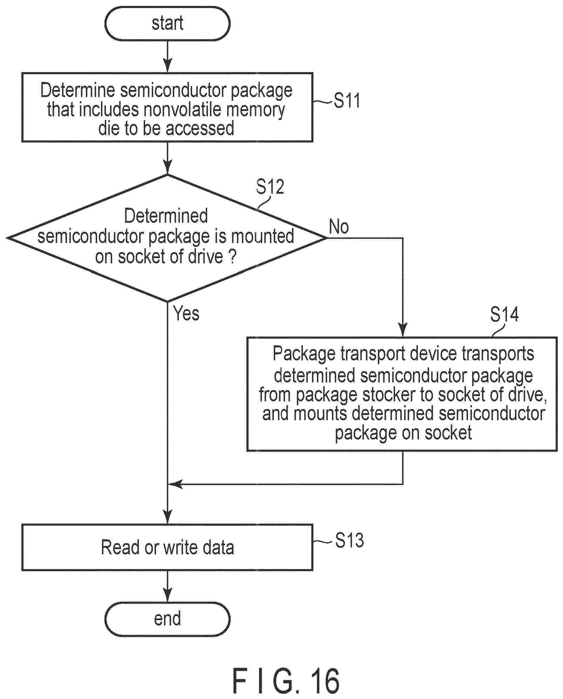

Next, a process of the reading or writing of data from or to a nonvolatile memory die 411 of a semiconductor package 41 will be described. FIG. 16 is a flowchart illustrating a procedure of the process of the reading or writing of data, which is executed by the host unit 21 of the storage system 1 according to the present embodiment.

First, the host unit 21 determines a semiconductor package 41 that includes a nonvolatile memory die 411 to be accessed (Step S11). Here, the nonvolatile memory die 411 to be accessed is determined, based on a read request or a write request which is received from the application program 211. Then, a semiconductor package 41 that includes this nonvolatile memory die 411 to be accessed is determined in Step S11.

The host unit 21 determines whether or not the semiconductor package 41 determined in Step S11 is mounted on a socket 222 of the drive 22 (Step S12). In Step S12, the host unit 21 may determine whether or not the determined semiconductor package 41 is mounted on a socket 222 of the drive 22 by referring to the semiconductor package management table 6.

When the determined semiconductor package 41 is mounted on a socket 222 of the drive 22 (Yes in Step S12), the host unit 21 executes, via the controller 223, the reading or writing of data from or to the nonvolatile memory die 411 to be accessed, which is included in the determined semiconductor package 41 (Step S13).

When the determined semiconductor package 41 is not mounted on any socket 222 of the drive 22 (No in Step S12), the host unit 21 causes the package transport device 3 to transport the determined semiconductor package 41 from the package stocker 4 to the drive 22, and to mount the semiconductor package 41 on the socket 222 (Step S14).

When the semiconductor package 41 is mounted on the socket 222 by the package transport device 3, the host unit 21 reads the package identifier stored in the semiconductor package 41 via the controller 223, and checks whether or not the read package identifier coincides with the package identifier of the determined semiconductor package 41. When the read package identifier coincides with the package identifier of the determined semiconductor package 41, the host unit 21 executes, via the controller 223, the reading or writing of data from or to the nonvolatile memory die 411 to be accessed, which is included in the determined semiconductor package 41 (Step S13).

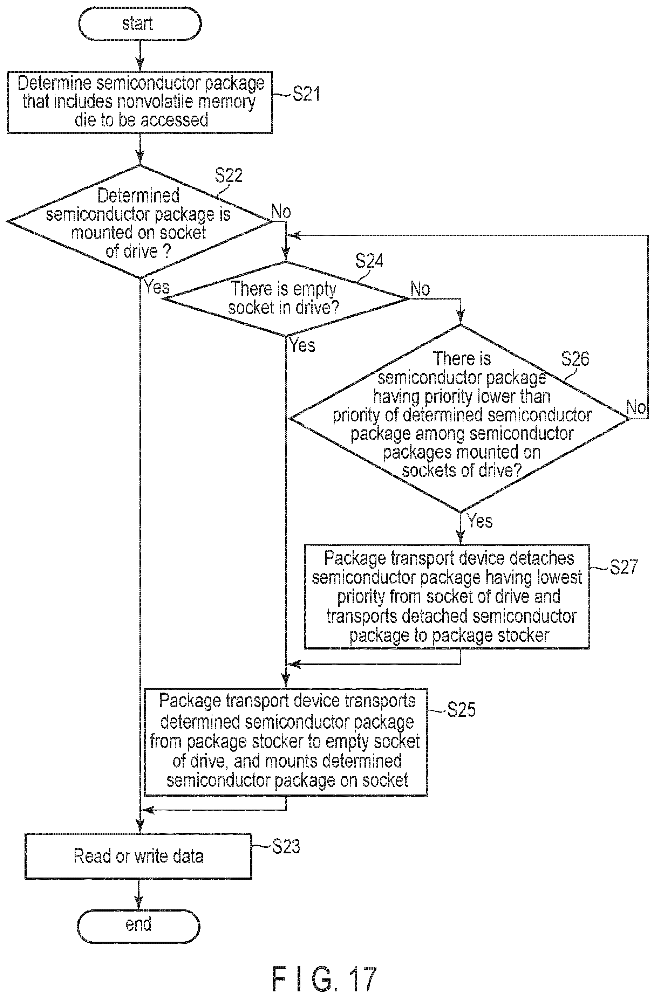

FIG. 17 is a flowchart illustrating details of a procedure of the process of reading or writing data, which is executed by the host unit 21 of the storage system 1 according to the present embodiment.

First, the host unit 21 determines a semiconductor package 41 that includes a nonvolatile memory die 411 to be accessed (Step S21).

The host unit 21 determines whether or not the semiconductor package 41 determined in Step S21 is mounted on a socket 222 of the drive 22 (Step S22). In Step S22, the host unit 21 may check whether or not the determined semiconductor package 41 is mounted on the socket 222 of the drive 22 by referring to the semiconductor package management table 6.

When the determined semiconductor package 41 is mounted on the socket 222 of the drive 22 (Yes in Step S22), the host unit 21 executes, via the controller 223, the reading or writing of data from or to the nonvolatile memory die 411 to be accessed, which is included in the determined semiconductor package 41 (Step S23).

When the determined semiconductor package 41 is not mounted on any socket 222 of the drive 22 (No in Step S22), the host unit 21 checks whether or not there is an empty socket in the drive 22 (Step S24). The empty socket is a socket 222 on which no semiconductor package 41 is mounted.

When there is an empty socket in the drive 22 (Yes in Step S24), the host unit 21 causes the package transport device 3 to transport the determined semiconductor package 41 from the package stocker 4 to the drive 22, and to mount the transported semiconductor package on the empty socket (Step S25). In this case, the host unit 21 instructs the package transport device 3 to take out the determined semiconductor package 41 from the package stocker 4 and to mount the determined semiconductor package 41 on the empty socket.

When the semiconductor package 41 is mounted on the socket 222 by the package transport device 3, the host unit 21 reads the package identifier stored in the semiconductor package 41 via the controller 223, and checks whether or not the read package identifier coincides with the package identifier of the determined semiconductor package 41.

When the read package identifier coincides with the package identifier of the determined semiconductor package 41, the host unit 21 stores information indicating that the determined semiconductor package 41 is mounted on the socket 222 of the drive 22, in the semiconductor package management table 6.

Then, the host unit 21 executes, via the controller 223, the reading or writing of data from or to the nonvolatile memory die 411 to be accessed, which is included in the determined semiconductor package 41 (Step S23).

When there is no empty socket in the drive 22 (No in Step S24), the host unit 21 determines whether or not there is a semiconductor package 41 having a priority lower than the priority of the determined semiconductor package 41 among the semiconductor packages 41 mounted on the sockets 222 of the drive 22 (Step S26).

When there is no semiconductor package 41 having a priority lower than the priority of the determined semiconductor package 41 among the semiconductor packages 41 mounted on the sockets 222 of the drive 22 (No in Step S26), the host unit 21 executes the process of Step S24 again. The host unit 21 waits until the priority of each semiconductor package 41 is changed and thus there is a semiconductor package 41 having a priority lower than the priority of the determined semiconductor package 41 among the semiconductor packages 41 mounted on the sockets 222 of the drive 22.

When there is a semiconductor package 41 having a priority lower than the priority of the determined semiconductor package 41 among the semiconductor packages 41 mounted on the sockets 222 of the drive 22 (Yes in Step S26), the host unit 21 causes the package transport device 3 to detach a semiconductor package 41 having the lowest priority among the semiconductor packages 41 mounted on the sockets 222 of the drive 22 from the corresponding socket 222, and to transport the detached semiconductor package 41 to the package stocker 4 (Step S27). As a result, the socket 222 from which the semiconductor package 41 has been detached becomes an empty socket.

Then, the host unit 21 causes the package transport device 3 to transport the determined semiconductor package 41 from the package stocker 4 to the drive 22, and to mount the transported semiconductor package 41 to the empty socket (Step S25). In this case, the host unit 21 instructs the package transport device 3 to take out the determined semiconductor package 41 from the package stocker 4 and to mount the determined semiconductor package 41 on the socket 222.

When the semiconductor package 41 is mounted on the socket 222 by the package transport device 3, the host unit 21 reads the package identifier stored in the semiconductor package 41 via the controller 223, and checks whether or not the read package identifier coincides with the package identifier of the determined semiconductor package 41.

When the read package identifier coincides with the package identifier of the determined semiconductor package 41, the host unit 21 stores information indicating that the determined semiconductor package 41 is mounted on the socket 222 of the drive 22, in the semiconductor package management table 6.

Then, the host unit 21 executes, via the controller 223, the reading or writing of data from or to the nonvolatile memory die 411 to be accessed, which is included in the determined semiconductor package 41 (Step S23).

As a result, even when there is no empty socket in the drive 22, the host unit 21 can mount the determined semiconductor package 41 on a socket 222 by detaching a semiconductor package 41 having a priority lower than the priority of the determined semiconductor package 41 from the socket 222.

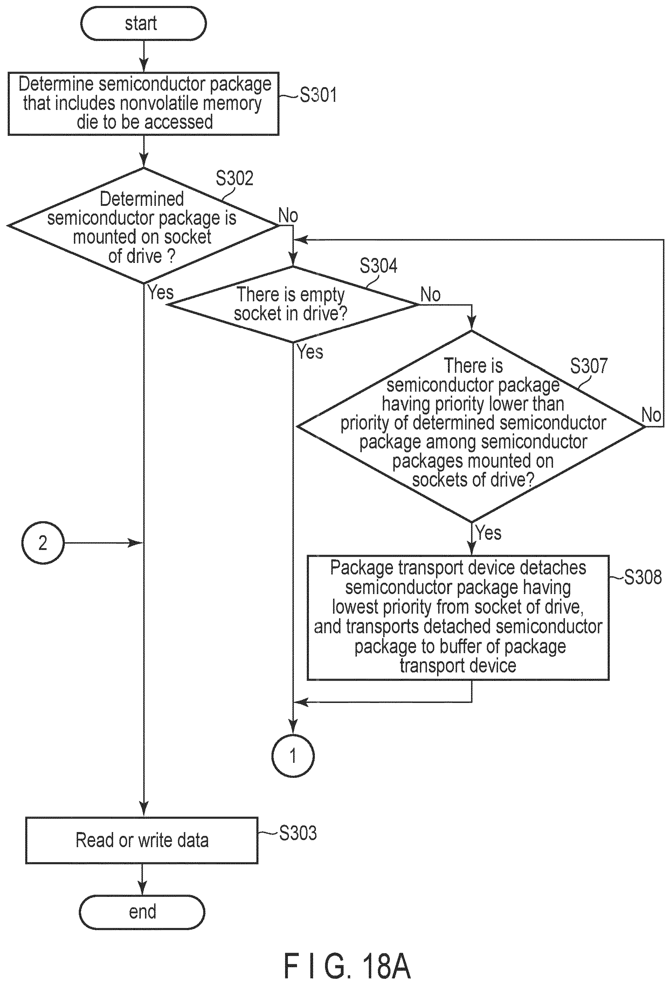

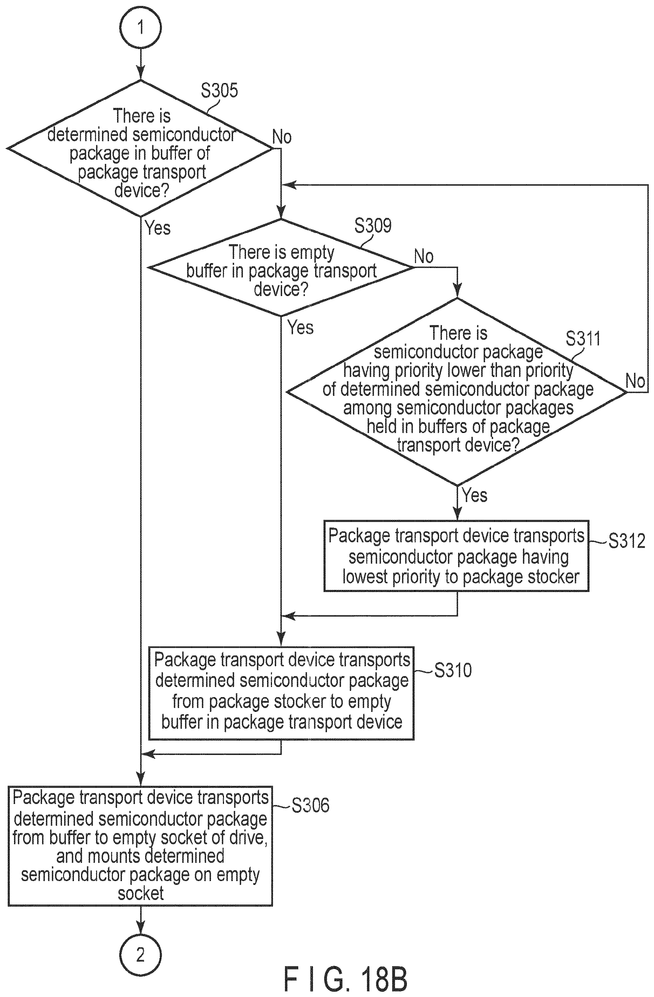

Next, a process of reading or writing data from or to a nonvolatile memory die 411 of a semiconductor package 41 when a buffer of the package transport device 3 is available will be described. FIGS. 18A and 18B are flowcharts illustrating another procedure of the process of reading or writing data from or to the nonvolatile memory die 411, which is executed by the host unit 21 of the storage system 1 according to the present embodiment.

First, the host unit 21 determines a semiconductor package 41 that includes a nonvolatile memory die 411 to be accessed (Step S301).

The host unit 21 determines whether or not the semiconductor package 41 determined in Step S301 is mounted on a socket 222 of the drive 22 (Step S302). The host unit 21 may determine whether or not the determined semiconductor package 41 is mounted on the socket 222 of the drive 22 by referring to the semiconductor package management table 6.

When the determined semiconductor package 41 is mounted on a socket 222 of the drive 22 (Yes in Step S302), the host unit 21 executes, via the controller 223, the reading or writing of data from or to the nonvolatile memory die 411 to be accessed, which is included in the determined semiconductor package 41 (Step S303).

When the determined semiconductor package 41 is not mounted on any socket 222 of the drive 22 (No in Step S302), the host unit 21 checks whether or not there is an empty socket in the drive 22 (Step S304).

When there is an empty socket in the drive 22 (Yes in Step S304), the host unit 21 executes the process of Step S305 in FIG. 18B.

When there is no empty socket in the drive 22 (No in Step S304), the host unit 21 determines whether or not there is a semiconductor package 41 having a priority lower than the priority of the determined semiconductor package 41 among the semiconductor packages 41 mounted on the sockets 222 of the drive 22 (Step S307).

When there is no semiconductor package 41 having a priority lower than the priority of the determined semiconductor package 41 among the semiconductor packages 41 mounted on the sockets 222 of the drive 22 (No in Step S307), the host unit 21 executes the process of Step S304 again. The host unit 21 waits until the priority of each semiconductor package 41 is changed and thus there is a semiconductor package 41 having a priority lower than the priority of the determined semiconductor package 41 among the semiconductor packages 41 mounted on the sockets 222 of the drive 22.

When there is a semiconductor package 41 having a priority lower than the priority of the determined semiconductor package 41 among the semiconductor packages 41 mounted on the sockets 222 of the drive 22 (Yes in Step S307), the host unit 21 causes the package transport device 3 to detach the semiconductor package 41 having a priority lower than the priority of the determined semiconductor package 41 from the socket 222, and to transport the detached semiconductor package 41 to a buffer of the package transport device 3 (Step S308). As a result, the semiconductor package 41 detached from the socket 222 is not stored in the package stocker 4 but is held in the package transport device 3. In addition, the socket 222 from which the semiconductor package 41 has been detached becomes an empty socket. Then, the host unit 21 executes the process of Step S305 in FIG. 18B.

The host unit 21 determines whether or not the determined semiconductor package 41 is present in a buffer of the package transport device 3, that is, whether or not the determined semiconductor package 41 is held in the package transport device 3 (Step S305). The host unit 21 may determine whether or not the determined semiconductor package 41 is held in the package transport device 3 by referring to the semiconductor package management table 6.

When the determined semiconductor package 41 is present in a buffer of the package transport device 3, that is, when the determined semiconductor package 41 is held in any one of the transport units 31 of the package transport device 3 (Yes in Step S305), the host unit 21 causes the package transport device 3 to transport the determined semiconductor package 41 from the buffer of the package transport device 3 to the drive 22, and to mount the transported semiconductor package 41 on the empty socket (Step S306). In this case, the host unit 21 instructs a transport unit 31 that has been holding the determined semiconductor package 41 to mount the determined semiconductor package 41 on the socket 222.

When the semiconductor package 41 is mounted on the socket 222 by the transport unit 31, the host unit 21 reads the package identifier stored in the semiconductor package 41 via the controller 223, and checks whether or not the read package identifier coincides with the package identifier of the determined semiconductor package 41.

When the read package identifier coincides with the package identifier of the determined semiconductor package 41, the host unit 21 stores information indicating that the determined semiconductor package 41 is mounted on the socket 222 of the drive 22, in the semiconductor package management table 6.

Then, the host unit 21 executes, via the controller 223, the reading or writing of data from or to the nonvolatile memory die 411 to be accessed, which is included in the determined semiconductor package 41 (Step S303 in FIG. 18A).

When the determined semiconductor package 41 is not present in any buffer of the package transport device 3, that is, when the determined semiconductor package 41 is not held in any transport unit 31 of the package transport device 3 (No in Step S305), the host unit 21 checks whether or not there is an empty buffer in the package transport device 3 (Step S309). The empty buffer of the package transport device 3 is a transport unit 31 that is not holding a semiconductor package 41.

When there is an empty buffer in the package transport device 3, that is, when there is a transport unit 31 that is not holding a semiconductor package 41 (Yes in Step S309), the host unit 21 causes the package transport device 3 to transport the determined semiconductor package 41 from the package stocker 4 to the empty buffer in the package transport device 3, that is, to a transport unit 31 that is not holding a semiconductor package 41 (Step S310). In this case, the host unit 21 may instruct a transport unit 31 that is not holding a semiconductor package 41 to take out the determined semiconductor package 41 from the package stocker 4. As a result, the determined semiconductor package 41 is held by the transport unit 31, and thus the determined semiconductor package 41 is present in a buffer of the package transport device 3.

Then, the host unit 21 causes the package transport device 3 to transport the determined semiconductor package 41 from the buffer of the package transport device 3 to the drive 22, and to mount the transported semiconductor package on the empty socket (Step S306). In this case, the host unit 21 instructs the transport unit 31 that has been holding the determined semiconductor package 41 to mount the determined semiconductor package 41 on the socket 222.

When the semiconductor package 41 is mounted on the socket 222 by the transport unit 31, the host unit 21 reads the package identifier stored in the semiconductor package 41 via the controller 223, and checks whether or not the read package identifier coincides with the package identifier of the determined semiconductor package 41.

When the read package identifier coincides with the package identifier of the determined semiconductor package 41, the host unit 21 stores information indicating that the determined semiconductor package 41 is mounted on the socket 222 of the drive 22, in the semiconductor package management table 6.

Then, the host unit 21 executes, via the controller 223, the reading or writing of data from or to the nonvolatile memory die 411 to be accessed, which is included in the determined semiconductor package 41 (Step S303 in FIG. 18A).

When there is no empty buffer in the package transport device 3 (No in Step S309), the host unit 21 determines whether or not there is a semiconductor package 41 having a priority lower than the priority of the determined semiconductor package 41 among the semiconductor packages 41 held in the buffers of the package transport device 3 (Step S311).

When there is no semiconductor package 41 having a priority lower than the priority of the determined semiconductor package 41 among the semiconductor packages 41 held in the buffers of the package transport device 3 (No in Step S311), the host unit 21 executes the process of Step S309 again. The host unit 21 waits until the priority of each semiconductor package 41 is changed and thus there is a semiconductor package 41 having a priority lower than the priority of the determined semiconductor package 41 among the semiconductor packages 41 held in the buffers of the package transport device 3.

When there is a semiconductor package 41 having a priority lower than the priority of the determined semiconductor package 41 among the semiconductor packages 41 held in the buffers of the package transport device 3 (Yes in Step S311), the host unit 21 causes the package transport device 3 to transport a semiconductor package 41 having the lowest priority among the semiconductor packages 41 held in the buffers of the package transport device 3 to the package stocker 4 (Step S312). In Step S312, the host unit 21 may instruct a transport unit 31 that has been holding the semiconductor package 41 having the lowest priority to transport the semiconductor package 41 to the package stocker 4. As a result, this transport unit 31 becomes an empty buffer that is not holding a semiconductor package 41.

Then, the host unit 21 causes the package transport device 3 to transport the determined semiconductor package 41 from the package stocker 4 to the empty buffer of the package transport device 3 (Step S310). In this case, the host unit 21 may instruct the transport unit 31 that has become the empty buffer to take out the determined semiconductor package 41 from the package stocker 4. As a result, the determined semiconductor package 41 is held by this transport unit 31, and thus the determined semiconductor package 41 is present in a buffer of the package transport device 3.

Then, the host unit 21 causes the package transport device 3 to transport the determined semiconductor package 41 from the buffer of the package transport device 3 to the drive 22, and to mount the transported semiconductor package on the empty socket (Step S306).

When the semiconductor package 41 is mounted on the socket 222 by the transport unit 31, the host unit 21 reads the package identifier stored in the semiconductor package 41 via the controller 223, and checks whether or not the read package identifier coincides with the package identifier of the determined semiconductor package 41.

When the read package identifier coincides with the package identifier of the determined semiconductor package 41, the host unit 21 stores information indicating that the determined semiconductor package 41 is mounted on the socket 222 of the drive 22, in the semiconductor package management table 6.

Then, the host unit 21 executes, via the controller 223, the reading or writing of data from or to the nonvolatile memory die 411 to be accessed, which is included in the determined semiconductor package 41 (Step S303 in FIG. 18A).

As described above, according to the first embodiment, the drive 22 includes at least one socket 222 on which a semiconductor package 41 is able to be detachably mounted, and the controller 223 that controls a nonvolatile memory die 411 of the semiconductor package 41 mounted on the socket 222.

The host unit 21, which is communicatively connected to the drive 22, may execute the reading or writing of data from or to the nonvolatile memory die 411 of the semiconductor package 41 connected to the socket 222. The host unit 21 determines a semiconductor package 41 that includes a nonvolatile memory die 411 to be accessed, among the plurality of semiconductor packages 41 managed in the storage system 1.

When the semiconductor package 41 that includes the nonvolatile memory die 411 to be accessed is mounted on a socket 222 of the drive 22, the host unit 21 executes, via the controller 223, the reading or writing of data from or to the nonvolatile memory die 411 to be accessed.

When the semiconductor package 41 that includes the nonvolatile memory die 411 to be accessed is not mounted on a socket 222 of the drive 22 and is stored in the package stocker 4, the host unit 21 causes the package transport device 3 to transport the semiconductor package 41 including the nonvolatile memory die 411 to be accessed, and to mount the semiconductor package 41 on the socket 222.

As described above, in the storage system 1, a semiconductor package 41 that includes one or more nonvolatile memory dies 411 is mounted on a socket 222 of the drive 22. As a result, it is possible to use the semiconductor package 41 mounted on the socket 222 of the drive 22, as a storage device accessible by the host unit 21. Therefore, the host unit 21 can read or write data from or to a nonvolatile memory die 411 included in any semiconductor package 41 among the plurality of semiconductor packages 41 managed in the storage system 1, by simply exchanging a semiconductor package 41 connected to the socket 222 of the drive 22 with another semiconductor package 41.

### (Second Embodiment)

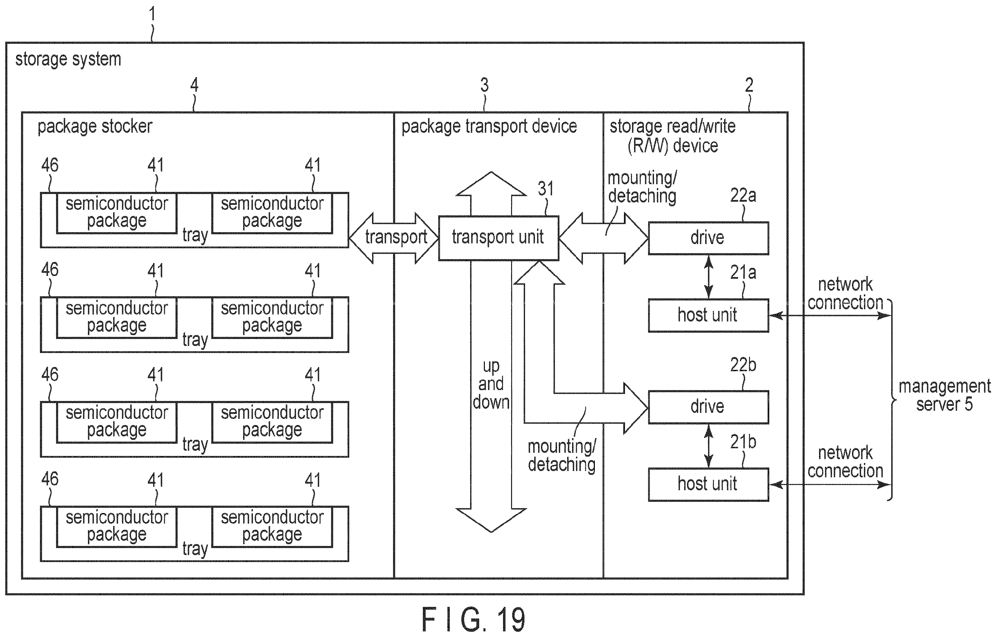

Next, a configuration of collectively transporting and mounting/detaching a plurality of semiconductor packages 41 will be described. FIG. 19 is a block diagram illustrating an example of a configuration of a storage system 1 according to the present embodiment. The storage system 1 illustrated in FIG. 19 is mainly different from the storage system 1 in the first embodiment illustrated in FIG. 1 in that a tray 46 that accommodates a plurality of semiconductor packages 41 is used as a unit for transporting and mounting/detaching the semiconductor packages 41. Other components are similar to those of the storage system 1 in the first embodiment. Differences from the storage system 1 in the first embodiment will be mainly described below.

A package stocker 4 is configured to store a plurality of trays 46, each of the plurality of trays 46 accommodating a predetermined number of semiconductor packages 41. The shape of the tray 46 may be a box shape or a plate shape. The number of semiconductor packages 41 accommodated in one tray 46 is two or more. In the tray 46, the predetermined number of semiconductor packages 41 are accommodated. The semiconductor packages 41 are accommodated in the tray 46 in a factory. A tray 46 that has been accommodating the predetermined number of semiconductor packages 41 is shipped from the factory and used in a data center.

A drive 22 includes at least the predetermined number of sockets 222 on which the predetermined number of semiconductor packages 41 accommodated in the tray 46 are able to be collectively and detachably mounted. For example, when the tray 46 is configured to accommodate 16 pieces of semiconductor packages 41, the drive 22 includes at least 16 pieces of sockets 222. The 16 pieces of the sockets 222 form a socket group on which the 16 pieces of semiconductor packages 41 accommodated in one tray are able to be collectively and detachably mounted. The 16 pieces of the semiconductor packages 41 accommodated in the tray 46 are collectively mounted on the 16 pieces of the sockets 222. In addition, when the tray 46 is configured to accommodate 48 pieces of semiconductor packages 41, the drive 22 includes at least 48 pieces of sockets 222. The 48 pieces of the sockets 222 form a socket group on which the 48 pieces of semiconductor packages 41 accommodated in one tray are able to be collectively and detachably mounted. The 48 pieces of the semiconductor packages 41 accommodated in the tray 46 are collectively mounted on the 48 pieces of the sockets 222. The number of sockets 222 included in the drive 22 may correspond to two or more trays 46.

A package transport device 3 transports a tray 46 between the package stocker 4 and the drive 22. For example, when a tray 46 is configured to accommodate 16 pieces of semiconductor packages 41, the package transport device 3 collectively transports the 16 pieces of the semiconductor packages 41 between the package stocker 4 and the drive 22 by transporting the tray 46.

Next, a basic operation of the storage system 1 will be described. A host unit 21 has a location management function and a transport control function. The location management function is a function of managing locations where a plurality of trays 46 are respectively present. The transport control function is a function of controlling the transport of a tray 46 that accommodates the predetermined number of semiconductor packages 41, by controlling the package transport device 3.

A tray identifier (also referred to as a tray identification name) is assigned to each of the plurality of trays 46. For example, a barcode such as a two-dimensional barcode may be marked on each of the plurality of trays 46, or a seal on which a barcode such as a two-dimensional barcode is printed may be attached to each of the plurality of trays 46. The barcode includes information representing the tray identifier.

The host unit 21 may manage a correspondence between the tray identifier and a location where a tray 46 identified by this tray identifier is present. In addition, the host unit 21 may also manage a correspondence between a tray identifier and the predetermined number of semiconductor packages 41 that have been accommodated in the tray 46 identified by this tray identifier.

A location where a certain tray 46 may be present is, for example, the predetermined number of sockets 222 among the plurality of sockets 222 included in the drive 22 or any one tray storage location among the plurality of tray storage locations included in the package stocker 4.

The host unit 21 determines a semiconductor package 41 that includes a nonvolatile memory die to be accessed, among the plurality of semiconductor packages 41. The host unit 21 further determines a tray 46 that accommodates the determined semiconductor package 41.

The host unit 21 identifies the location where the determined tray 46 is present, whereby the host unit 21 may determine whether or not the predetermined number of semiconductor packages 41 accommodated in the determined tray 46 are mounted on the predetermined number of sockets 222 of the drive 22.

When the predetermined number of semiconductor packages 41 accommodated in the determined tray 46 are mounted on the predetermined number of sockets 222 of the drive 22, the host unit 21 executes, via the controller 223 in the drive 22, the reading or writing of data from or to the nonvolatile memory die 411 to be accessed.

When the predetermined number of semiconductor packages 41 accommodated in the determined tray 46 are not mounted on the predetermined number of sockets 222 of the drive 22, the host unit 21 causes the package transport device 3 to transport the determined tray 46 to the drive 22, and to mount the predetermined number of semiconductor packages 41 accommodated in the determined tray 46 on the predetermined number of sockets 222 of the drive 22. In this case, the host unit 21 may transmit a transport request described below, to the package transport device 3.

For example, this transport request specifies a location in the package stocker 4 where the determined tray 46 is stored (also referred to as a tray storage location) as a transport source location, and also specifies the predetermined number of sockets 222 of the drive 22 as a transport destination location. A transport unit 31 of the package transport device 3 transports the tray 46 present at the specified transport source location to the specified transport destination location. Then, the transport unit 31 collectively mounts the predetermined number of semiconductor packages 41 accommodated in this tray 46 to the predetermined number of sockets 222 of the transport destination location.

As described above, by managing the location of each tray 46, it is possible to reduce the processing amount required for location management as compared with a case of managing the location of each semiconductor package 41. Furthermore, since the predetermined number of semiconductor packages 41 accommodated in the tray 46 are collectively transported, it is possible to reduce the number of times of transport required as compared with a case of transporting the individual semiconductor packages 41 one by one.

Furthermore, the host unit 21 may also have a function of managing a priority of each of the plurality of trays 46 that is determined based on the priority of each of the plurality of semiconductor packages 41. The algorithm for determining the priority of each of the plurality of trays 46 is not limited to a specific algorithm, and the priority of each of the plurality of trays 46 can be determined based on various conditions. For example, the host unit 21 may determine the priority of each of the plurality of trays 46 such that a tray 46 in which an average priority of the predetermined number of semiconductor packages 41 accommodated therein is higher has a higher priority. Alternatively, the host unit 21 may determine the priority of each of the plurality of trays 46, based on the highest priority among the priorities of the predetermined number of semiconductor packages 41 accommodated therein.

The host unit 21 can also control the location where each of the plurality of trays 46 is present, based on the priority of each of the plurality of trays 46. For example, the host unit 21 may control the location where each of the plurality of trays 46 is present, based on the priority of each of the plurality of trays 46, such that the predetermined number of semiconductor packages 41 accommodated in a tray 46 having a priority of a first level are mounted on the predetermined number of sockets 222 of the drive 22, and a tray 46 having a priority of a second level, which is lower than the priority of the first level, is stored in the package stocker 4.

Note that some of the transport units 31 included in the package transport device 3 may be used as buffers that temporarily hold trays 46. In this case, a tray 46 having the priority of the second level, which is lower than the priority of the first level, is held in a transport unit 31 included in the package transport device 3. Then, a tray 46 having a priority of a third level, which is lower than the priority of the second level, is stored in the package stocker 4.

A transport unit 31 holding a tray 46 having the priority of the second level may be moved to a specific evacuation location so as not to interfere with the transporting operation by another transport unit 31.

In addition, the storage location in the package stocker 4 may be changed according to the priority of the tray 46. For example, the host unit 21 may control the location where each of the plurality of trays 46 is present, based on the priority of each of the plurality of trays 46, such that the predetermined number of semiconductor packages 41 on a tray 46 having the priority of the first level are mounted on the predetermined number of sockets 222 of the drive 22, a tray 46 having the priority of the second level, which is lower than the priority of the first level, is held in the package transport device 3, a tray 46 having the priority of the third level, which is lower than the priority of the second level, is stored in a first storage location included in the package stocker 4, and a tray 46 having a priority of a fourth level, which is lower than the priority of the third level, is stored in a second storage location included in the package stocker 4. Here, the first storage location is a storage location in the package stocker 4 which is closer to the package transport device 3 than the second storage location is.

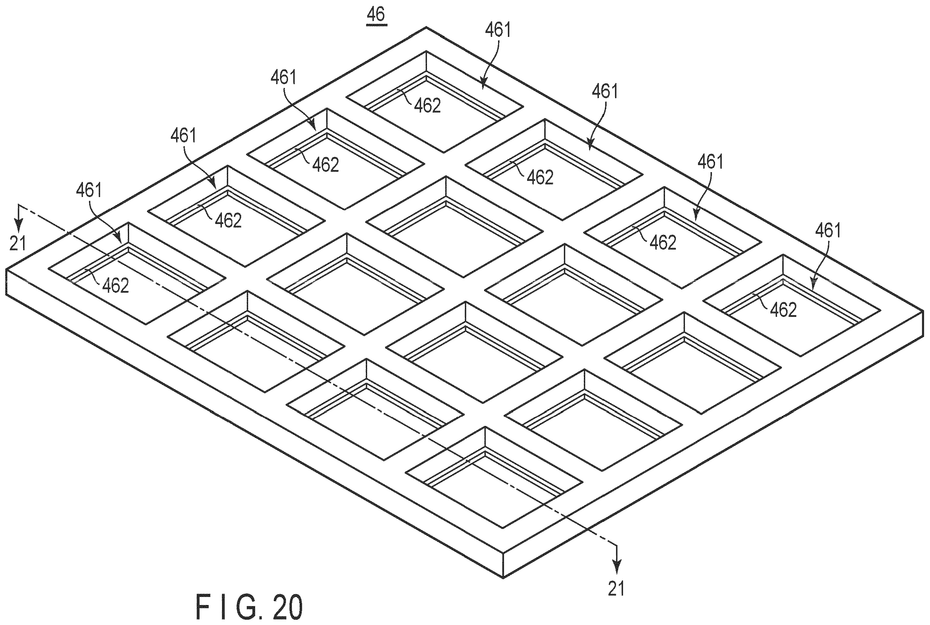

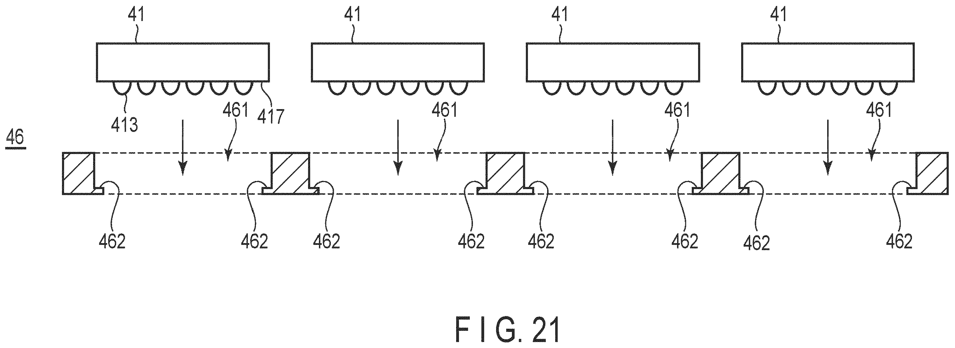

Next, a configuration of a tray 46 will be described. FIG. 20 is a perspective view illustrating an example of the configuration of the tray 46 capable of accommodating a plurality of semiconductor packages 41. FIG. 21 is a cross-sectional view of the tray 46 taken along line 21-21 in FIG. 20.

The tray 46 includes the predetermined number of recesses 461 capable of accommodating the predetermined number of semiconductor packages 41. For example, when the tray 46 has a structure capable of accommodating 16 pieces of semiconductor packages 41, the tray 46 includes 16 pieces of recesses 461.

As illustrated in FIG. 21, a support member 462 is provided at the inner peripheral part in the vicinity of the bottom surface of each of the predetermined number of recesses 461. The support member 462 supports the outermost peripheral area of a back surface 417 of the semiconductor package 41 accommodated in the recess 461. Further, an opening through which a plurality of ball-type metal terminals 413 of the semiconductor package 41 are exposed is formed in the bottom surface of each of the predetermined number of recesses 461, that is, in the lower surface of the tray 46. That is, each of the predetermined number of recesses 461 is a cavity capable of accommodating the semiconductor package 41, and an opening through which the plurality of ball-type metal terminals 413 of the semiconductor package 41 are exposed is formed at the bottom of the cavity.

Therefore, the outermost peripheral area of the back surface 417 of the semiconductor package 41 accommodated in the recess 461 abuts on the support member 462, whereby the semiconductor package 41 is held in the tray 46. Further, the plurality of ball-type metal terminals 413 provided on the back surface 417 of the semiconductor package 41 are exposed to the external environment through the opening provided in the lower surface of the tray 46 without coming into contact with the support member 462. In this case, each semiconductor package 41 may be accommodated in the tray 46 such that the plurality of ball-type metal terminals 413 protrude from the lower surface of the tray 46 through the opening provided in the lower surface of the tray 46.

As described above, the tray 46 has the lower surface in which the opening through which the plurality of ball-type metal terminals 413 of each of the predetermined number of semiconductor packages 41 are exposed is formed. Therefore, the predetermined number of semiconductor packages 41 can be mounted on the predetermined number of sockets 222 while the semiconductor packages 41 are accommodated in the tray 46.

In addition, the lower surface of the tray 46 in which the opening through which the plurality of ball-type metal terminals 413 of each of the predetermined number of semiconductor packages 41 are exposed is formed is a flat surface without unevenness. Thus, the tray 46 is smoothly movable along a rail pair of the package stocker 4.

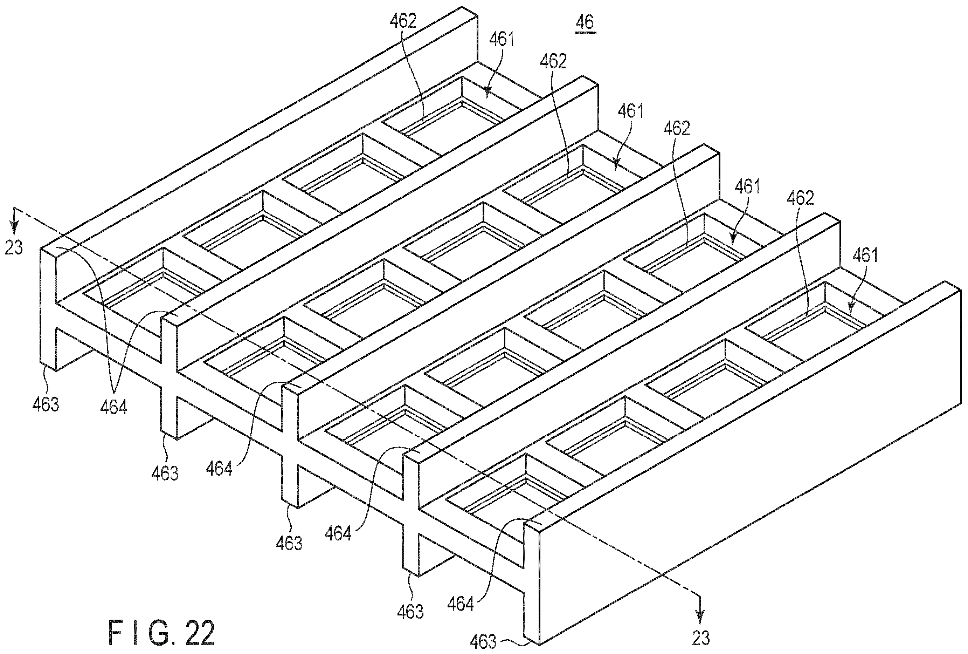

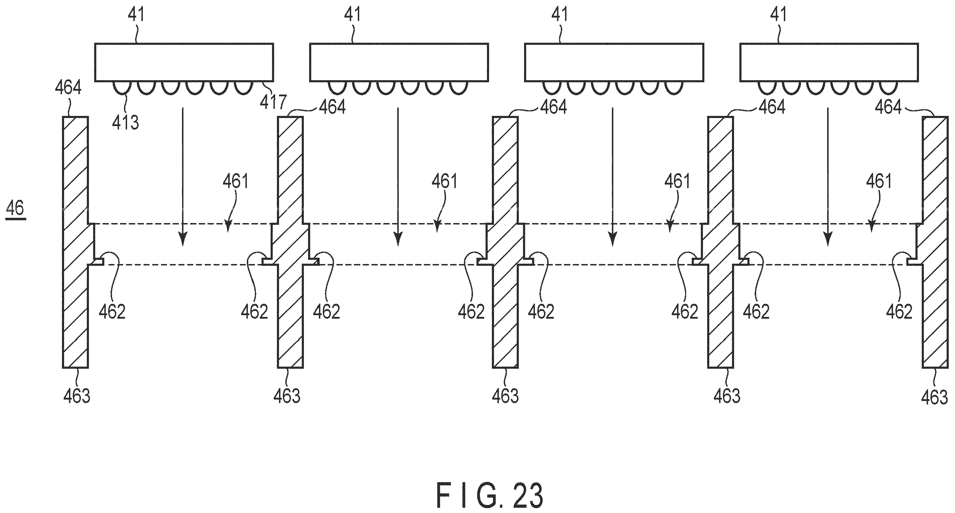

Next, a configuration of a tray 46 capable of assisting alignment between the predetermined number of semiconductor packages 41 accommodated in the tray 46 and the predetermined number of sockets 222 of the drive 22 will be described. FIG. 22 is a perspective view illustrating an example of the configuration of a tray 46 in which protrusions are provided on each of an upper surface and a lower surface. FIG. 23 is a cross-sectional view of the tray 46 taken along line 23-23 in FIG. 22.

The tray 46 includes the predetermined number of recesses 461 capable of accommodating the predetermined number of semiconductor packages 41. For example, when the tray 46 has a structure capable of accommodating 16 pieces of semiconductor packages 41, the tray 46 includes 16 pieces of recesses 461.

As illustrated in FIG. 23, a support member 462 is provided at the inner peripheral part in the vicinity of the bottom surface of each of the predetermined number of recesses 461. The support member 462 supports the outermost peripheral area of a back surface 417 of the semiconductor package 41 accommodated in the recess 461. Further, an opening through which a plurality of ball-type metal terminals 413 of the semiconductor package 41 are exposed is formed in the bottom surface of each of the predetermined number of recesses 461, that is, in the lower surface of the tray 46. That is, each of the predetermined number of recesses 461 is a cavity capable of accommodating the semiconductor package 41, and an opening through which the plurality of ball-type metal terminals 413 of the semiconductor package 41 are exposed is formed at the bottom of the cavity.

Therefore, the outermost peripheral area of the back surface 417 of the semiconductor package 41 accommodated in the recess 461 abuts on the support member 462, whereby the semiconductor package 41 is held in the tray 46. Further, the plurality of ball-type metal terminals 413 provided on the back surface 417 of the semiconductor package 41 are exposed to the external environment through the opening provided in the lower surface of the tray 46 without coming into contact with the support member 462. In this case, each semiconductor package 41 may be accommodated in the tray 46 such that the plurality of ball-type metal terminals 413 protrude from the lower surface of the tray 46 through the opening provided in the lower surface of the tray 46.

Further, the lower surface of the tray 46 has one or more protrusions 463. Each protrusion 463 may be used as a member for the alignment between the predetermined number of semiconductor packages 41 accommodated in the tray 46 and the predetermined number of sockets 222 of the drive 22.

Further, the upper surface of the tray 46 has one or more protrusions 464. When the predetermined number of semiconductor packages 41 accommodated in the tray 46 are mounted on the predetermined number of sockets 222 of the drive 22, the tray 46 may be covered with a lid member in order to maintain a stable contact state between the predetermined number of semiconductor packages 41 and the predetermined number of sockets 222. Each protrusion 464 provided on the upper surface of the tray 46 may be used as a member for the alignment between the tray 46 and the lid member.

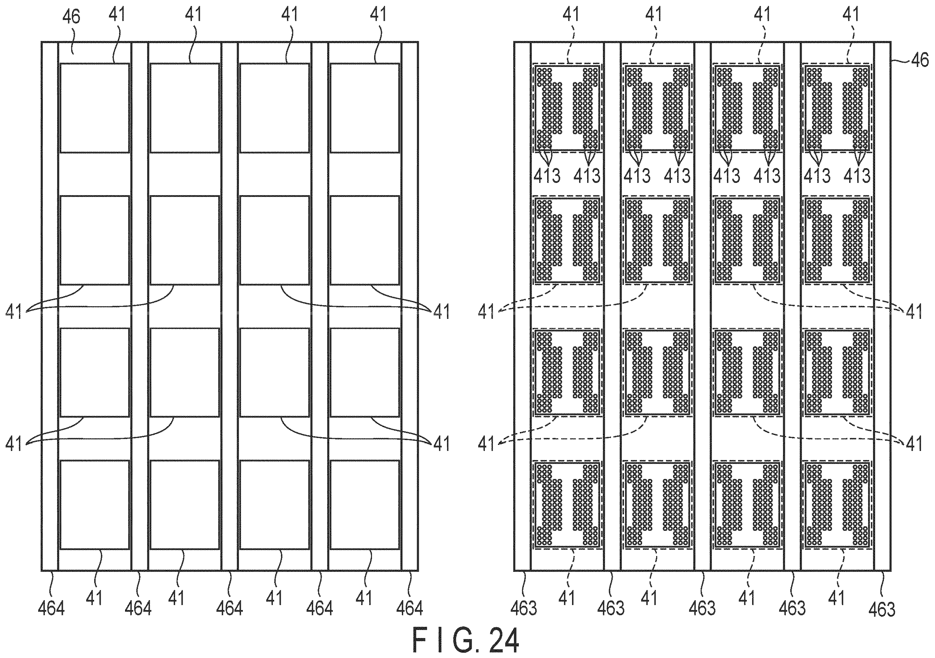

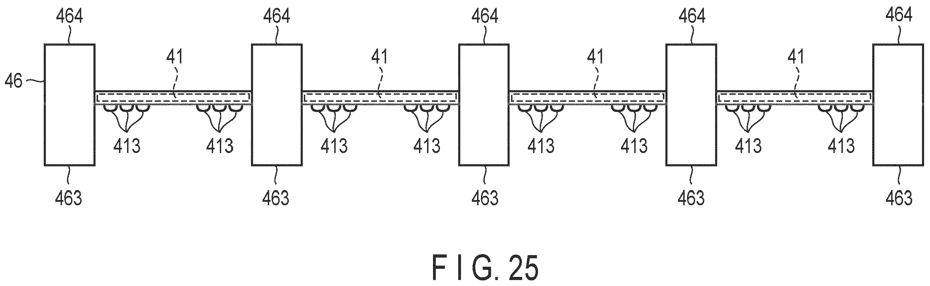

FIG. 24 is a plan view illustrating shapes of the upper surface and the lower surface of the tray 46 described with reference to FIGS. 22 and 23. The left part of FIG. 24 is a plan view of the tray 46 as viewed from the upper surface side. The right part of FIG. 24 is a plan view of the tray 46 as viewed from the lower surface side. In addition, FIG. 25 is a side view of the tray 46.

As can be seen from the right part of FIG. 24 and FIG. 25, the lower surface of the tray 46 has an opening through which the plurality of ball-type metal terminals 413 of each semiconductor package 41 are exposed, and has the plurality of protrusions 463.

Further, as can be seen from FIG. 25, the tip of each protrusion 463 has a flat surface without unevenness. When the tray 46 is placed on the rail pair of the package stocker 4, the tip of each protrusion 463 serves as a contact surface that abuts on the rail pair. Since the contact surface has a flat surface without unevenness, the tray 46 can be smoothly slid along the rail pair.

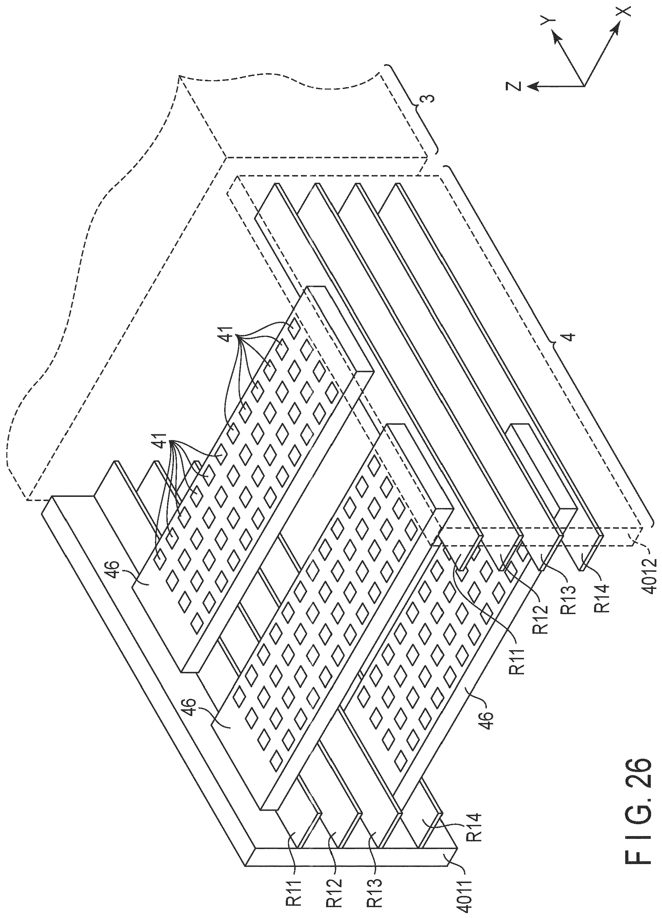

Next, a configuration of the package stocker 4 capable of storing a plurality of trays 46 will be described. FIG. 26 is a perspective view illustrating a rail structure of the package stocker 4 on which a plurality of trays 46 can be placed.

FIG. 26 illustrates a case where each of the trays 46 accommodates 48 pieces of semiconductor packages 41, which is equal to the number of sockets 222 provided in the drive 22.

The package stocker 4 includes two side walls 4011 and 4012 facing each other at a distance and four rail pairs R11 to R14 disposed inside the two side walls 4011 and 4012. The rail pair R11 includes a pair of rails that are opposed to each other at a distance and extend parallel to each other. By using such a rail structure having a gap between the rails, it is possible to support the tray 46 while avoiding the ball-type metal terminal 413 of the semiconductor package 41 exposed from the lower surface of the tray 46 from contacting with the rails. Each of the other rail pairs R12 to R14 has a configuration similar to that of the rail pair R11.

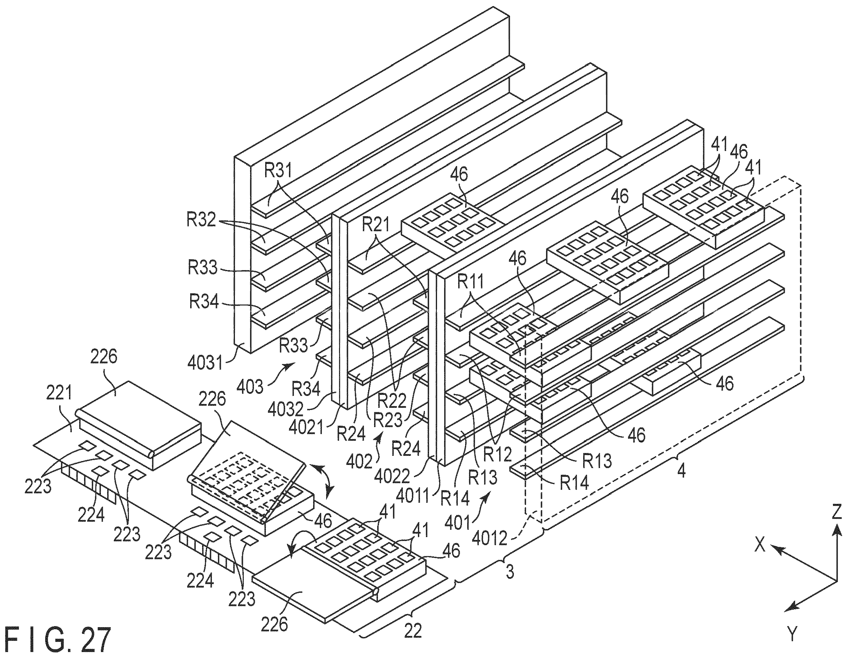

FIG. 27 is a perspective view illustrating another example of the rail structure of the package stocker 4 on which the plurality of trays 46 can be placed.

FIG. 27 illustrates a case where three rail units 401 to 403 are provided in the package stocker 4. The number of the sockets 222 provided in the drive 22 is, for example, 48. The number of the semiconductor packages 41 accommodated in the tray 46 is, for example, 16. In this case, the 48 pieces of the sockets 222 provided in the drive 22 are classified into three groups each including 16 pieces of the sockets 222. The 16 pieces of semiconductor packages 41 accommodated in a certain tray 46 are collectively mounted on the 16 pieces of sockets 222 provided in a certain group. Then, the tray 46 is covered with a lid member 226 corresponding to this group. The lid member 226 corresponding to each group may be attached to a printed circuit board 221 of the drive 22 so as to be openable and closable via a hinge mechanism.

The rail unit 401 includes two side walls 4011 and 4012 facing each other at a distance, and four rail pairs R11 to R14 disposed inside the two side walls 4011 and 4012. The rail pair R11 includes a pair of rails that are opposed to each other at a distance and extend parallel to each other. By using such a rail structure having a gap between the rails, it is possible to support the tray 46 while avoiding the ball-type metal terminal 413 of the semiconductor package 41 exposed from the lower surface of the tray 46 from contacting with the rails. Each of the other rail pairs R12 to R14 has a configuration similar to that of the rail pair R11.

The rail unit 402 includes two side walls 4021 and 4022 facing each other at a distance, and four rail pairs R21 to R24 disposed inside the two side walls 4021 and 4022. The rail pair R21 includes a pair of rails that are opposed to each other at a distance and extend parallel to each other. Each of the other rail pairs R22 to R24 has a configuration similar to that of the rail pair R21.

The rail unit 403 includes two side walls 4031 and 4032 facing each other at a distance, and four rail pairs R31 to R34 disposed inside the two side walls 4031 and 4032. The rail pair R31 includes a pair of rails that are opposed to each other at a distance and extend parallel to each other. Each of the other rail pairs R32 to R34 has a configuration similar to that of the rail pair R31.

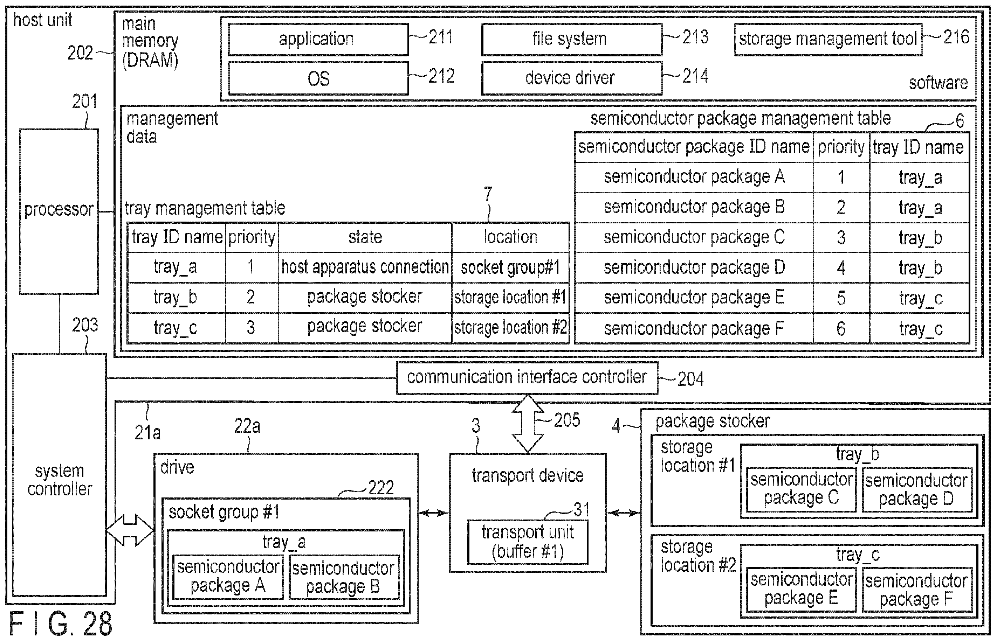

Next, a configuration of the host unit 21 that controls the transport of the tray 46 will be described. FIG. 28 is a block diagram illustrating an example of the configuration of the host unit 21 that controls the transport of the tray 46. Here, the host unit 21a, which is one of a plurality of host units 21 provided in the storage system 1, will be described.

The host unit 21a includes a processor 201, a main memory 202, a system controller 203, a communication interface controller 204, and the like. Among these components, the components other than management data in the main memory 202 are the same as the components of the host unit 21a described with reference to FIG. 7, and thus the description thereof will be omitted.

The host unit 21a (more specifically, the processor 201) that controls the transport of the tray 46 can manage a semiconductor package management table 6 and a tray management table 7 under the control of a storage management tool 216. The semiconductor package management table 6 is management data for the plurality of semiconductor packages 41. The tray management table 7 is management data for a plurality of trays 46. The semiconductor package management table 6 and the tray management table 7 may be stored in the main memory 202.

The host unit 21a is configured to assign a unique semiconductor package identification name to each semiconductor package 41. The host unit 21a uses the semiconductor package management table 6 to manage the semiconductor package identification name of each of the semiconductor packages 41, the priority of each of the semiconductor packages 41, and the identification name of a tray 46 in which each of the semiconductor packages 41 is accommodated. FIG. 28 illustrates an example in which the host unit 21a identifies each of the plurality of semiconductor packages 41 used in the storage system 1 by using each of a semiconductor package A, a semiconductor package B, ..., and a semiconductor package F which are semiconductor package identification names, and identifies each of the plurality of trays 46 used in the storage system 1 by using each of a tray_a, a tray_b, and a tray_c which are tray identification names. The tray 46 having a certain tray identification name may be described by using the tray identification name. For example, the tray 46 having the tray identification name "tray_a" may be referred to as a tray_a.

The host unit 21a stores the priority of each of the plurality of semiconductor packages 41 in the semiconductor package management table 6. The host unit 21a may determine the priority of each of the semiconductor packages 41, based on the access frequency with respect to a nonvolatile memory die 411 provided in each of the semiconductor packages 41, or the like. In addition, the host unit 21a may instruct the package transport device 3 to transport a semiconductor package 41, based on the priority managed in the semiconductor package management table 6.

The host unit 21a stores the tray identification name of each of the trays 46 in the semiconductor package management table 6 as information indicating which tray 46 each of the plurality of semiconductor packages 41 is accommodated in. Here, the tray_a accommodates a semiconductor package A and a semiconductor package B. The tray_b accommodates a semiconductor package C and a semiconductor package D. The tray_c accommodates a semiconductor package E and a semiconductor package F.

Further, the host unit 21a manages the tray identification name of each of the trays 46, the priority of each of the trays 46, the state of each of the trays 46, and the location of each of the tray 46 by using the tray management table 7. FIG. 28 illustrates an example in which the host unit 21a identifies each of the plurality of trays 46 used in the storage system 1 by using each of the tray_a, the tray_b, and the tray_c which are tray identification names.

The host unit 21a stores the priority of each of the plurality of trays 46 in the tray management table 7. Then, the host unit 21a instructs the package transport device 3 to transport a tray 46, based on the priority managed in the tray management table 7. The host unit 21a may determine the priority of each of the trays 46, based on the priority of each of the semiconductor packages 41 accommodated in each of the trays 46.

The host unit 21a stores, in the tray management table 7, information indicating whether each of the plurality of trays 46 has been connected to the host unit 21a, has been stored in the package stocker 4, or has been held in a transport unit 31 of the package transport device 3, as the state of each of the trays 46.

Here, a state in which a certain tray 46 has been connected to the host unit 21a means a state in which the predetermined number of semiconductor packages 41 accommodated in this tray 46 have been mounted on the predetermined number of sockets 222 of the drive 22a. Therefore, when a certain tray 46 has been connected to the host unit 21a, the host unit 21a can recognize that the predetermined number of semiconductor packages 41 accommodated in this tray 46 have been mounted on the predetermined number of sockets 222 of the drive 22a. Then, the host unit 21a can recognize that it is possible to read and write data from and to a nonvolatile memory die 411 of each of the predetermined number of semiconductor packages 41 accommodated in this tray 46.

In the example illustrated in FIG. 28, a semiconductor package 41 having the semiconductor package identification name "semiconductor package A" has the highest priority (priority = 1st). The semiconductor package A is accommodated in a tray 46 having the tray identification name "tray_a". A semiconductor package 41 having the semiconductor package identification name "semiconductor package B" has the second highest priority (priority = 2nd). The semiconductor package B is accommodated in the tray_a. Further, a semiconductor package 41 having the semiconductor package identification name "semiconductor package C" has the third highest priority (priority = 3rd). The semiconductor package C is accommodated in a tray 46 having the tray identification name "tray_b". A semiconductor package 41 having the semiconductor package identification name "semiconductor package D" has the fourth highest priority (priority = 4th). The semiconductor package D is accommodated in the tray_b. A semiconductor package 41 having the semiconductor package identification name "semiconductor package E" has the fifth highest priority (priority = 5th). The semiconductor package E is accommodated in a tray 46 having the tray identification name "tray_c". A semiconductor package 41 having the semiconductor package identification name "semiconductor package F" has the sixth highest priority (priority = 6th). The semiconductor package F is accommodated in the tray_c.

The tray_a has the highest priority (priority = 1st). The predetermined number of semiconductor packages 41 (here, the semiconductor packages A and B) accommodated in the tray_a are mounted on a socket group #1 of the drive 22a. The tray_b has the second highest priority (priority = 2nd). The tray_b is stored in a storage location #1 of the package stocker 4. The tray_c has the third highest priority (priority = 3rd). The tray_c is stored in a storage location #2 of the package stocker 4.

A distance between the storage location #1 and the package transport device 3 is shorter than a distance between the storage location #2 and the package transport device 3. Therefore, the tray_b stored in the storage location #1 can be more easily taken out by the transport unit 31 than the tray_c stored in the storage location #2. The host unit 21a may instruct the package transport device 3 to store a tray 46 having a higher priority in a storage location where the tray 46 can be more easily taken out, according to the priority of each of the trays 46.

Further, the host unit 21a may use the transport unit 31 as a buffer. At this time, the host unit 21a may instruct the package transport device 3 such that the transport unit 31 holds a tray 46 having the highest priority among a plurality of trays 46 stored in the package stocker 4.

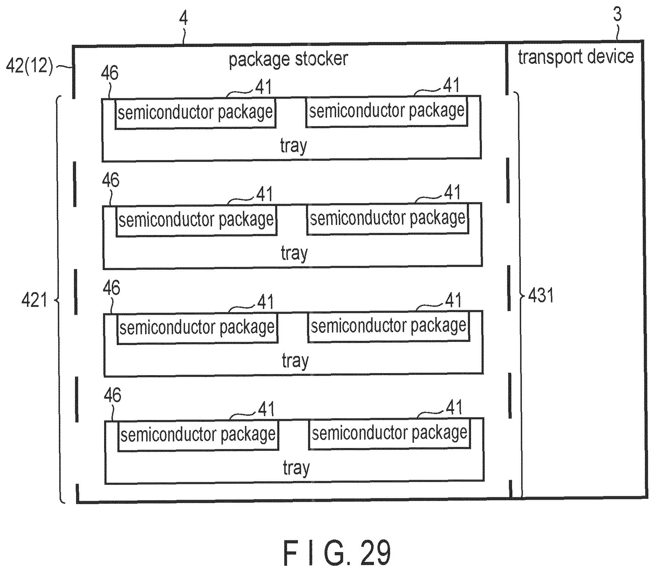

Next, a tray loading/unloading slot used when a tray 46 is added to the package stocker 4 and when a tray 46 is ejected from the package stocker 4 will be described. FIG. 29 is a diagram illustrating a tray loading/unloading slot of the package stocker 4.

The package stocker 4 includes a tray loading/unloading slot 421 used to add a tray 46 to the package stocker 4 from the outside of the package stocker 4, and to eject a tray 46 from the package stocker 4 to the outside of the package stocker 4. The tray loading/unloading slot 421 is an opening provided in a front surface 42 of the package stocker 4. The front surface 42 corresponds to the front surface 12 of the server rack 11.

A tray 46 is added to the package stocker 4 from the outside of the package stocker 4 through the tray loading/unloading slot 421 provided in the package stocker 4. The added tray 46 is stored in the package stocker 4 together with a plurality of trays 46 already stored.

Further, an unnecessary tray 46 is ejected from the package stocker 4 to the outside of the package stocker 4 through the tray loading/unloading slot 421 provided in the package stocker 4.

The package stocker 4 includes a tray loading/unloading slot 431 provided in a surface on a side facing the package transport device 3 in addition to the tray loading/unloading slot 421 provided in the front surface 42 of the package stocker 4. The tray loading/unloading slot 431 is used to store a tray 46 in the package stocker 4 and to take out a tray 46 from the package stocker 4. The package transport device 3 executes an operation of storing a tray 46 in the package stocker 4 through the tray loading/unloading slot 431 and an operation of taking out a tray 46 from the package stocker 4 through the tray loading/unloading slot 431. The tray loading/unloading slot 431 is provided, for example, in the back surface of the package stocker 4 and is located on the opposite side of the tray loading/unloading slot 421. In addition, although not illustrated here, a plurality of pairs of rails extend in a direction from the tray loading/unloading slot 421 of the package stocker 4 toward the package transport device 3, that is, in a direction from the tray loading/unloading slot 421 toward the tray loading/unloading slot 431.

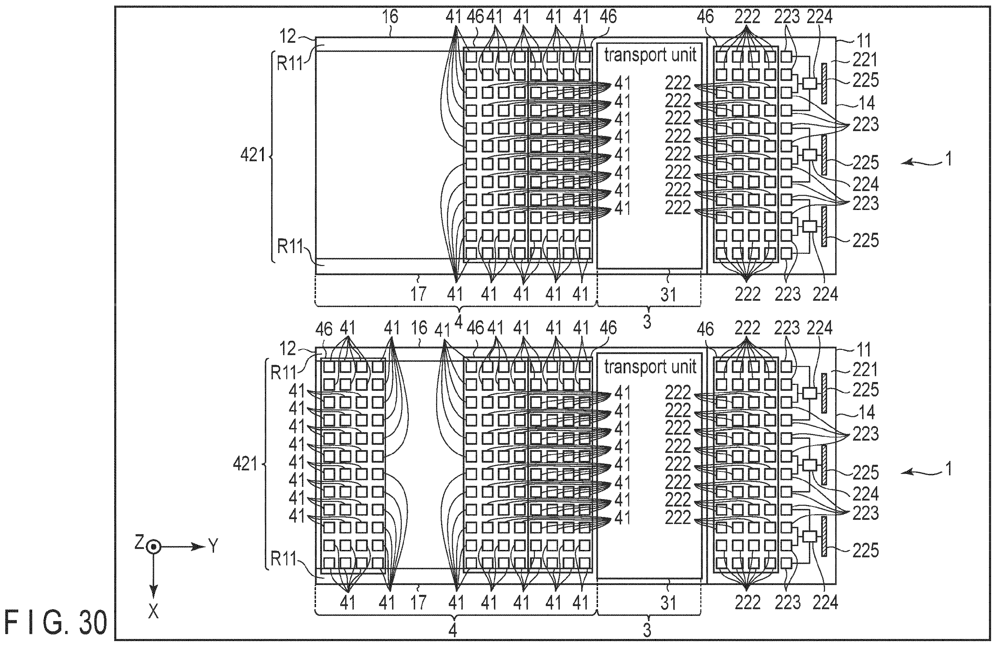

Next, an operation of adding a tray 46 to the package stocker 4 from the outside will be described. FIG. 30 is a diagram illustrating an operation of adding a new tray 46 to the package stocker 4 from the tray loading/unloading slot 421 of the package stocker 4.

The upper part of FIG. 30 is a plan view of a server rack 11 before a new tray 46 is added. The lower part of FIG. 30 is a plan view of the server rack 11 after a new tray 46 that accommodates 48 pieces of semiconductor packages 41 is added.

As can be seen from FIG. 30, the package transport device 3 opposes the tray loading/unloading slot 421 provided in the front surface 12 of the server rack 11. The rail pair R11 extends in a direction (Y-direction) from the tray loading/unloading slot 421 toward the package transport device 3.

As illustrated in the upper part of FIG. 30, two trays 46 each accommodating 48 pieces of semiconductor packages 41 are placed on the rail pair R11.

Here, it is assumed that a tray 46 that accommodates 48 pieces of semiconductor packages 41 is added to the package stocker 4. In this case, as illustrated in the lower part of FIG. 30, the tray 46 that accommodates the 48 pieces of semiconductor packages 41 is placed on the rail pair R11 through the tray loading/unloading slot 421 by, for example, a robot or an operator. As a result, the tray 46 is stored in the package stocker 4.

As described above, in the package stocker 4, the rail pair R11 extending in a direction from the tray loading/unloading slot 421 toward the package transport device 3 is provided. Therefore, it is possible to easily add and eject a tray 46 through the tray loading/unloading slot 421.

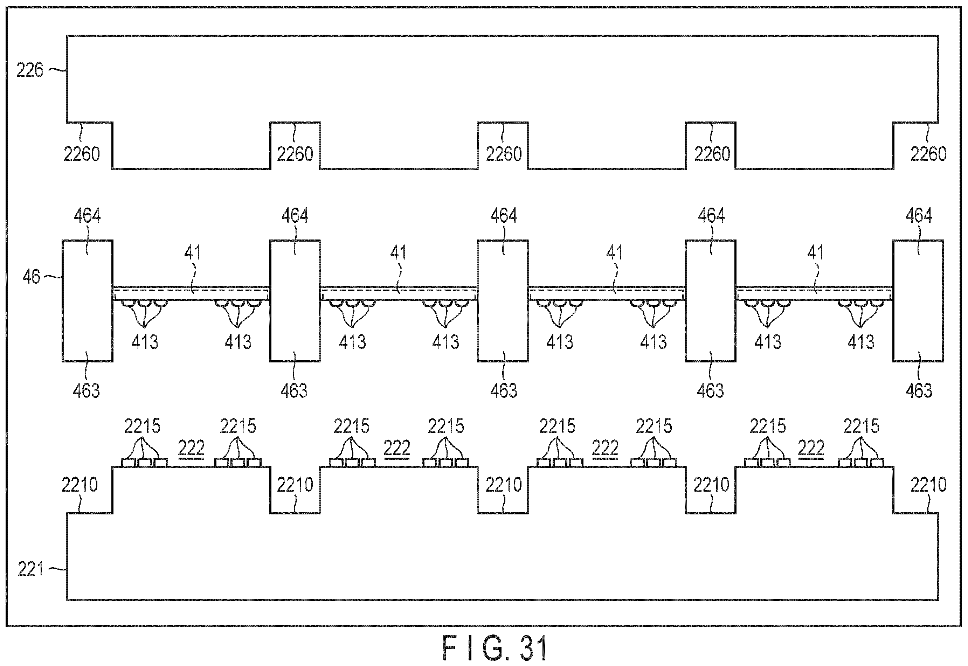

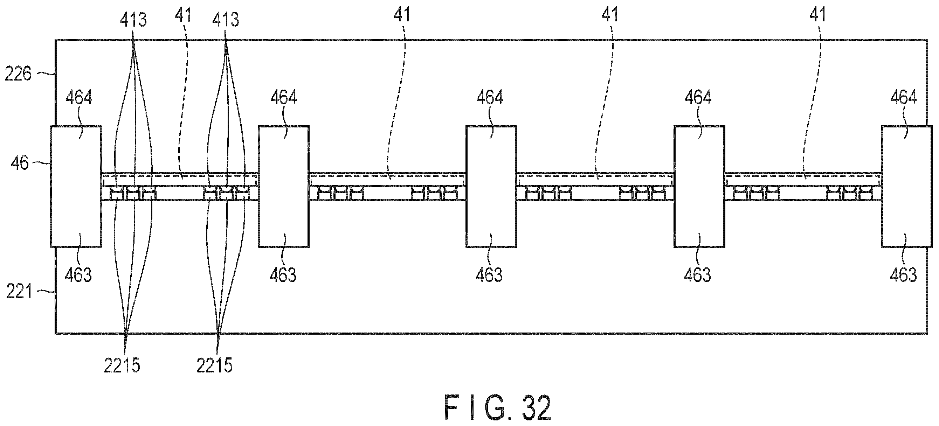

Next, the alignment between the predetermined number of semiconductor packages 41 accommodated in a tray 46 and the predetermined number of sockets 222 of the drive 22 will be described. FIG. 31 is a diagram illustrating a relationship among a recessed portion provided in a board of the drive 22, a protrusion provided on the lower surface of the tray 46, a protrusion provided on the upper surface of the tray 46, and a recessed portion provided in the lid member 226. In addition, FIG. 32 is a diagram illustrating a state in which the protrusion on the lower surface of the tray 46 is fitted into the recessed portion provided in the board of the drive 22 and the recessed portion of the lid member 226 is fitted into the protrusion on the upper surface of the tray 46.

This board of the drive 22 is, for example, the printed circuit board 221 of the drive 22. In this case, at least the predetermined number of sockets 222 are disposed on the printed circuit board 221 of the drive 22. Each of the sockets 222 includes a plurality of terminals 2215 provided on the printed circuit board 221. The printed circuit board 221 also includes one or more recessed portions 2210.

The lid member 226 has a lower surface including one or more recessed portions 2260.

When collectively mounting the predetermined number of semiconductor packages 41 accommodated in the tray 46 on the predetermined number of sockets 222, as illustrated in FIG. 32, each of the protrusions 463 provided on the lower surface of the tray 46 is fitted into the corresponding recessed portion 2210 of the printed circuit board 221. As a result, the predetermined number of semiconductor packages 41 accommodated in the tray 46 are aligned with the predetermined number of sockets 222 of the drive 22. As a result, the plurality of ball-type metal terminals 413 of each of the semiconductor packages 41 accommodated in the tray 46 are respectively brought into contact with the plurality of terminals 2215 of the corresponding socket 222 on the printed circuit board 221.

Thereafter, as illustrated in FIG. 32, the tray 46 placed on the printed circuit board 221 is covered with the lid member 226 so that each of the protrusions 464 on the upper surface of the tray 46 placed on the printed circuit board 221 is fitted into the corresponding recessed portion 2260 of the lid member 226. As a result, the lower surface of the lid member 226 comes into contact with the upper surfaces of each of the predetermined number of semiconductor packages 41 accommodated in the tray 46. As a result, the plurality of ball-type metal terminals 413 of each of the predetermined number of semiconductor packages 41 accommodated in the tray 46 are pressed against the plurality of terminals 2215 on the printed circuit board 221.

Note that, although the case where the printed circuit board 221 of the drive 22 is used as the board including the recessed portion 2210 has been described here, the board including the recessed portion 2210 may be another board different from the printed circuit board 221 (also referred to as a socket board). In this case, said another board includes: the predetermined number of sockets each including a plurality of terminals 2215; and one or more recessed portions 2210.

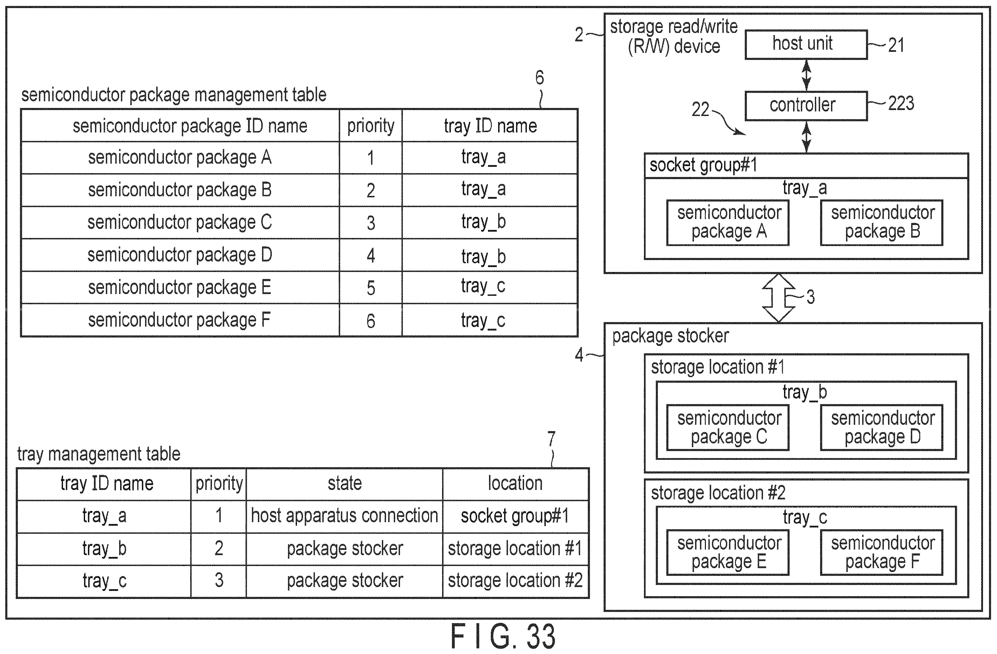

Next, transporting and mounting/detaching operations of a tray 46 controlled by the host unit 21 will be described. FIG. 33 is a diagram illustrating an operation of changing a location of a tray 46 between the package stocker 4 and sockets 222 of the drive 22 based on change in the priority of the tray 46, which is executed in the storage system 1 according to the present embodiment.

It is assumed below that the total number of sockets 222 provided in the drive 22 is equal to the number of semiconductor packages 41 accommodated in a tray 46. The number of sockets 222, which is equal to the number of semiconductor packages 41 accommodated in the tray 46, is referred to as a socket group #1 below. In addition, for simplification of illustrations, it is assumed below that the number of semiconductor packages 41 accommodated in the tray 46 is two.

The host unit 21 manages the priority of each of the trays 46 provided in the storage system 1 by using the tray management table 7. The priority of each of the trays 46 provided in the storage system 1 may be determined based on the priority of each of the semiconductor packages 41 provided in the storage system 1. The host unit 21 instructs the package transport device 3 to transport and mount/detach a tray 46 based on the priority of each of the trays 46 provided in the storage system 1.

In the example illustrated in FIG. 33, the host unit 21 manages six semiconductor packages 41 including a semiconductor package A, a semiconductor package B, ..., and a semiconductor package F. In addition, the host unit 21 manages three trays 46 of a tray_a, a tray_b, and a tray_c. Here, the semiconductor package A is a semiconductor package 41 having the highest priority, and is accommodated in the tray_a. The semiconductor package B is a semiconductor package 41 having the second highest priority, and is accommodated in the tray_a. The semiconductor package C is a semiconductor package 41 having the third highest priority, and is accommodated in the tray_b. The semiconductor package D is a semiconductor package 41 having the fourth highest priority, and is accommodated in the tray_b. The semiconductor package E is a semiconductor package 41 having the fifth highest priority, and is accommodated in the tray_c. The semiconductor package F is a semiconductor package 41 having the sixth highest priority, and is accommodated in the tray_c.

Here, it is assumed that the host unit 21 determines the priority of the tray_a, in which an average priority of the predetermined number of semiconductor packages 41 accommodated is the highest, to be the priority of 1st, determines the priority of the tray_b, in which the average priority of the predetermined number of semiconductor packages 41 accommodated is the second highest, to be the priority of 2nd, and determines the priority of the tray_c, in which the average priority of the predetermined number of semiconductor packages 41 accommodated is the third highest, to be the priority of 3rd.

The host unit 21 instructs the package transport device 3 to transport the tray_a having the highest priority to the drive 22, and to mount the semiconductor packages A and B accommodated in the tray_a on the two sockets 222 of the drive 22, that is, the socket group #1. The package transport device 3 transports the tray_a to the drive 22, and collectively mounts the semiconductor packages A and B accommodated in the tray_a on the socket group #1 of the drive 22. The host unit 21 stores information indicating that the tray_a that accommodates the semiconductor packages A and B is present in the socket group #1, in the tray management table 7.

As described above, when the total number of the sockets 222 provided in the drive 22 is equal to the number of the semiconductor packages 41 accommodated in the tray 46, the semiconductor packages A and B accommodated in the tray_a having the priority of 1st are respectively mounted on the two sockets 222 of the socket group #1 of the drive 22. In this case, the priority of 1st corresponds to the priority of the first level.

In addition, the two trays 46 (tray_b, tray_c) having the priorities of 2nd to 3rd are stored in the package stocker 4. The package stocker 4 may include at least two types of storage locations: a first storage location and a second storage location. The distance between the first storage location and the package transport device 3 is shorter than the distance between the second storage location and the package transport device 3. The first storage location includes, for example, a storage location #1. The second storage location includes, for example, a storage location #2. The storage location #1 is a storage location where it is easy for the package conveyance device 3 to take out a tray 46 as compared with the storage location #2.

Among the two trays 46 stored in the package stocker 4, the tray_b having the priority of 2nd is stored in the storage location #1 included in the first storage location. The priority of 2nd corresponds to the priority of the second level, which is lower than the priority of the first level.

Further, among the two trays 46 stored in the package stocker 4, the tray_c having the priority of 3rd is stored in the storage location #2 included in the second storage location. The priority of 3rd corresponds to the priority of the third level, which is lower than the priority of the second level.

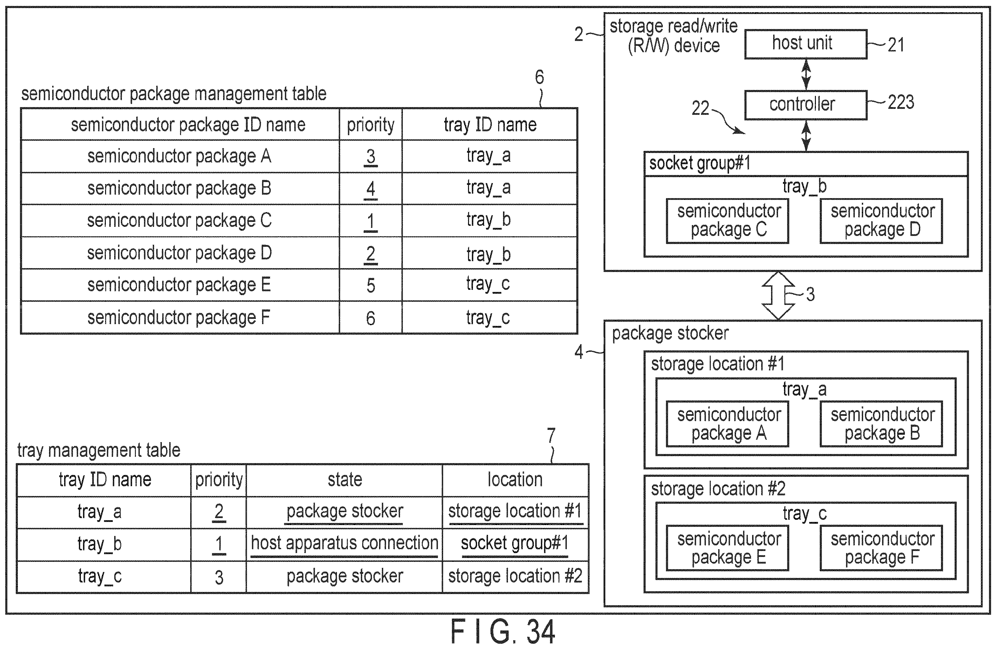

Here, an operation of the host unit 21 when the priority of the tray_b stored in the package stocker 4 exceeds the priority of the tray_a will be described. FIG. 34 is another diagram for illustrating an operation of changing a location of a tray 46 between the package stocker 4 and sockets 222 of the drive 22 based on change in the priority of the tray 46, which is executed in the storage system 1 according to the present embodiment.

For example, it is assumed that the priority of the semiconductor package A decreases from 1st to 3rd, the priority of the semiconductor package B decreases from 2nd to 4th, the priority of the semiconductor package C increases from 3rd to 1st, and the priority of the semiconductor package D increases from 4th to 2nd. The host unit 21 updates the priority of each of the plurality of semiconductor packages 41 by using a predetermined algorithm based on the frequency of access requests and the like.

The host unit 21 updates the priority of each of the plurality of trays 46 in response to the update of the priority of each of the plurality of semiconductor packages 41. Here, since all the priorities of the semiconductor packages C and D accommodated in the tray_b exceed the priorities of the semiconductor packages A and B accommodated in the tray_a, the host unit 21 updates the priority of each of the tray_a and the tray_b such that the priority of the tray_b becomes higher than the priority of the tray_a. As a result, the tray_b has the highest priority (priority = 1), and the tray_a has the second highest priority (priority = 2).

Then, the host unit 21 instructs the package transport device 3 to detach the semiconductor packages A and B accommodated in the tray_a from the two sockets 222 of the socket group #1, to transport the tray_b to the drive 22, to mount the semiconductor packages C and D accommodated in the tray_b on the two sockets 222 of the socket group #1, and to transport the detached tray_a to, for example, the storage location #1 of the package stocker 4. The package transport device 3 collectively detaches the semiconductor packages A and B accommodated in the tray_a from the two sockets 222 of the socket group #1 by detaching the tray_a from the socket group #1. Then, the package transport device 3 transports the tray_b to the drive 22, collectively mounts the semiconductor packages C and D accommodated in the tray_b on the two sockets 222 of the socket group #1 from which the semiconductor packages A and B accommodated in the tray_a have been detached. Then, the package transport device 3 transports the detached tray_a to the storage location #1 of the package stocker 4.

Then, the host unit 21 updates the tray management table 7. Specifically, the host unit 21 stores, in the tray management table 7, information indicating that the tray_a is stored in the storage location #1 of the package stocker 4 and information indicating that the tray_b is present in the socket group #1 of the drive 22.

As described above, differing from the case of transporting each semiconductor package 41, the host unit 21 can instruct the package transport device 3 to transport each tray 46 that accommodates a plurality of semiconductor packages 41. As a result, since the plurality of semiconductor packages 41 can be collectively mounted on the plurality of sockets 222, it is possible to reduce the frequency of transmitting an instruction from the host unit 21 to the package transport device 3 and the frequency of executing the transporting and mounting/detaching operations by the package transport device 3.

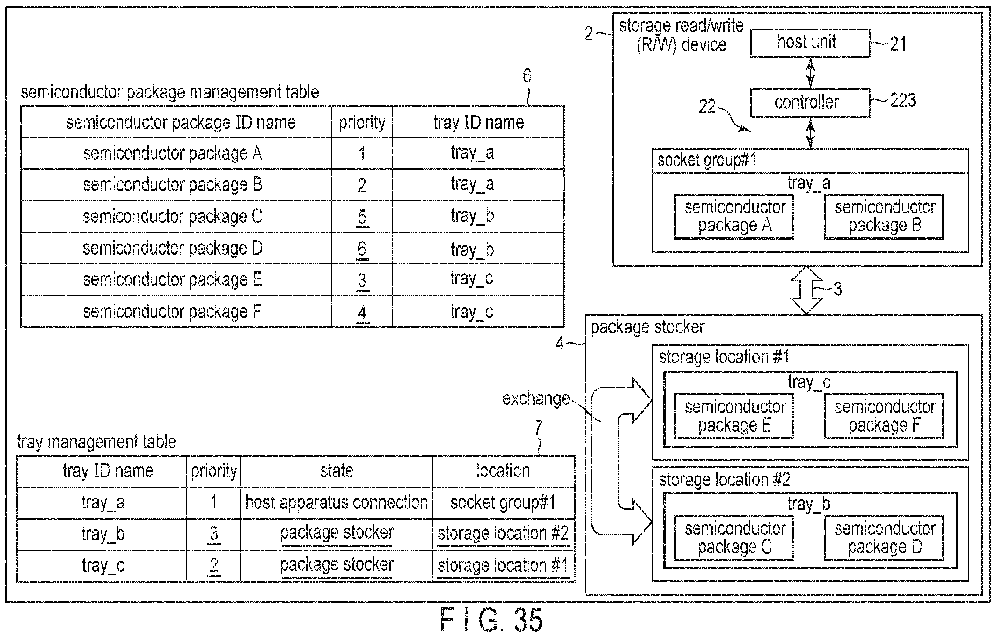

Next, an operation of changing a storage location in the package stocker 4 where a tray 46 is stored will be described. FIG. 35 is a diagram for illustrating an operation of changing the location of a tray 46 in the package stocker 4 based on change in the priority of the tray 46, which is executed in the storage system 1 according to the present embodiment.

Here, it is assumed that, in the state illustrated in FIG. 33, for example, the priority of the tray_c increases from 3rd to 2nd and the priority of the tray_b decreases from 2nd to 3rd. The new priority (2nd) of the tray_c belongs to the priority of the second level, and the new priority (3rd) of the tray_b belongs to the priority of the third level. Therefore, the host unit 21 instructs the package transport device 3 to exchange the storage location of the tray_c and the storage location of the tray_b with each other. First, the package transport device 3 takes out the tray_b from the storage location #1 of the package stocker 4. Then, the package transport device 3 further takes out the tray_c from the storage location #2 of the package stocker 4. Thereafter, the package transport device 3 stores the tray_b in the storage location #2 of the package stocker 4. Then, the package transport device 3 stores the tray_c in the storage location #1 of the package stocker 4.

Then, the host unit 21 updates the tray management table 7. Specifically, the host unit 21 stores, in the tray management table 7, information indicating that the tray_b is stored in the storage location #2 of the package stocker 4 and information indicating that the tray_c is stored in the storage location #1 of the package stocker 4.

By the above operation, the host unit 21 can control a tray 46 having a higher priority among the trays 46 stored in the package stocker 4 to be stored in a storage location (here, the storage location #1) where the package transport device 3 can more easily take out this tray 46. Therefore, when the priority of this tray 46 stored in the storage location #1 of the package stocker 4 exceeds the second level of priority, it is possible to shorten the time required to transport this tray 46 from the package stocker 4 to the drive 22.

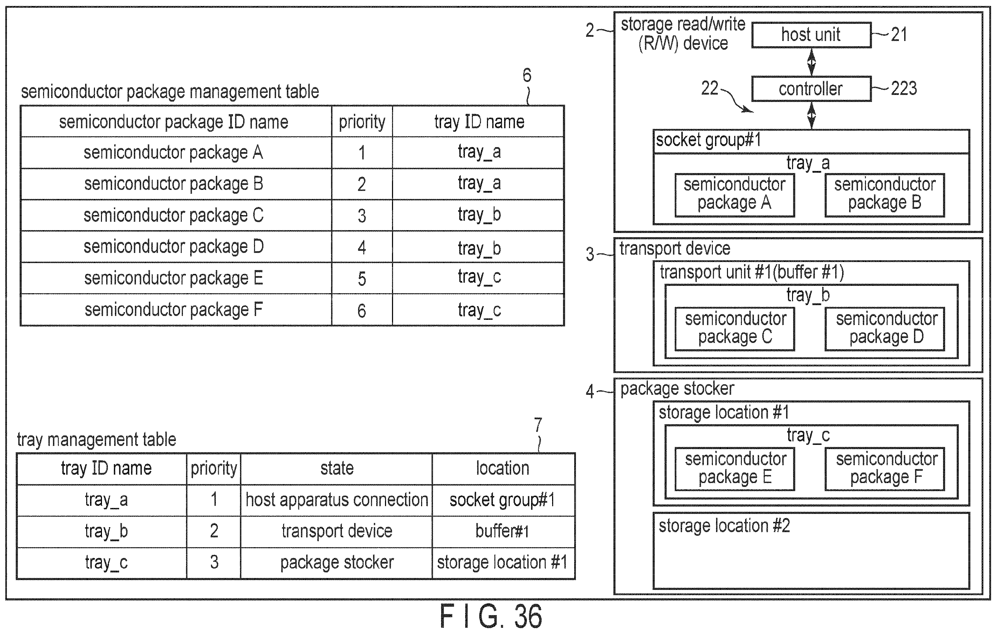

Next, the transporting and mounting/detaching operations of a tray 46 controlled by the host unit 21 when a buffer of the package transport device 3 is available will be described. FIG. 36 is a diagram for illustrating an operation of changing a location of a tray 46 among the package stocker 4, the package transport device 3, and the socket 222 of the drive 22, based on change in the priority of the tray 46, which is executed in the storage system 1 according to the present embodiment.

The host unit 21 manages six semiconductor packages 41 including a semiconductor package A, a semiconductor package B, ..., and a semiconductor package F. In addition, the host unit 21 manages three trays 46 of a tray_a, a tray_b, and a tray_c. Here, the semiconductor package A is a semiconductor package 41 having the highest priority, and is accommodated in the tray_a. The semiconductor package B is a semiconductor package 41 having the second highest priority, and is accommodated in the tray_a. The semiconductor package C is a semiconductor package 41 having the third highest priority, and is accommodated in the tray_b. The semiconductor package D is a semiconductor package 41 having the fourth highest priority, and is accommodated in the tray_b. The semiconductor package E is a semiconductor package 41 having the fifth highest priority, and is accommodated in the tray_c. The semiconductor package F is a semiconductor package 41 having the sixth highest priority, and is accommodated in the tray_c.

Here, it is assumed that the host unit 21 determines the priority of the tray_a, in which the average priority of the predetermined number of semiconductor packages 41 accommodated is the highest, to be 1st, determines the priority of the tray_b, in which the average priority of the predetermined number of semiconductor packages 41 accommodated is the second highest, to be 2nd, and sets the priority of the tray_c, in which the average priority of the predetermined number of semiconductor packages 41 accommodated is the third highest, to be 3rd.

The host unit 21 instructs the package transport device 3 to transport the tray_a having the highest priority to the drive 22, and to mount the semiconductor packages A and B accommodated in the tray_a on two sockets 222 of the drive 22, that is, the socket group #1. The package transport device 3 transports the tray_a to the drive 22, and collectively mounts the semiconductor packages A and B accommodated in the tray_a on the socket group #1 of the drive 22. The host unit 21 stores information indicating that the tray_a that accommodates the semiconductor packages A and B is present in the socket group #1, in the tray management table 7.

As described above, when the total number of the sockets 222 provided in the drive 22 is equal to the number of the semiconductor packages 41 accommodated in a tray 46, the semiconductor packages A and B accommodated in the tray_a having the priority of 1st are respectively mounted on the two sockets 222 of the socket group #1 of the drive 22. In this case, the priority of 1st corresponds to the priority of the first level.

In addition, the host unit 21 instructs the package transport device 3 to hold the tray b having the priority of 2nd. The priority of 2nd corresponds to the priority of the second level, which is lower than the priority of the first level.

The package transport device 3 (for example, a transport unit #1) that has received the instruction holds the tray_b. Thus, the tray 46 having the priority of 2nd is held in the package transport device 3. That is, the transport unit #1 that holds the tray_b is used as a buffer (buffer #1) of the package transport device 3.

The host unit 21 stores information indicating that the tray_b is held in the transport unit #1 (buffer #1), in the tray management table 7.

In addition, the tray c having the third priority is stored in the package stocker 4. The host unit 21 causes the package transport device 3 to store the tray_c in the storage location #1 included in the first storage location. The host unit 21 stores information indicating that the tray_c is stored in the storage location #1, in the tray management table 7.

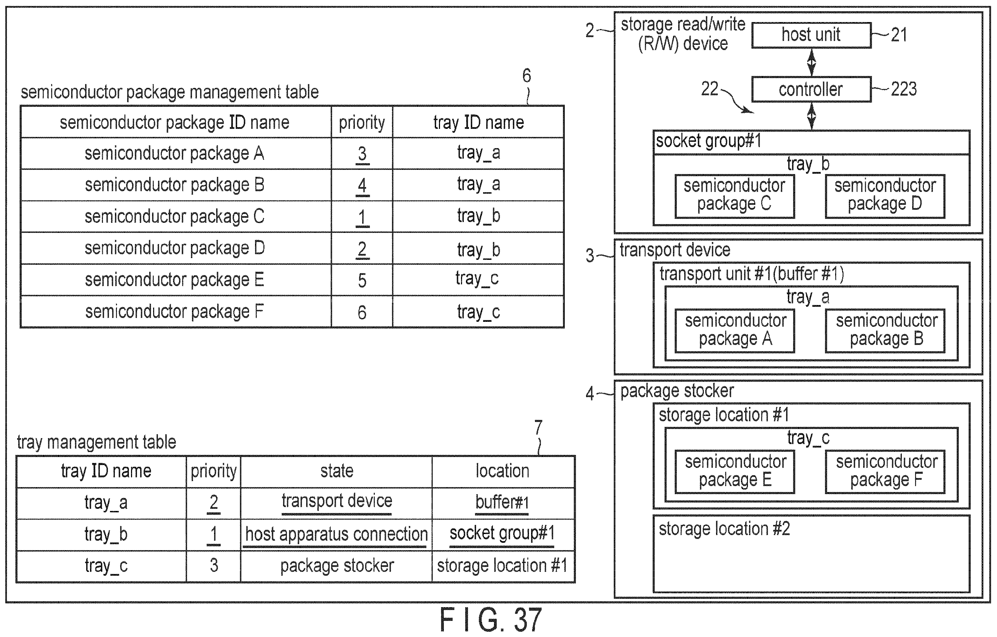

Here, an operation of the host unit 21 when the priority of the tray_b held in the buffer #1 of the package transport device 3 exceeds the priority of the tray_a will be described. FIG. 37 is a diagram for illustrating an operation of changing a location of a tray 46 between the package transport device 3 and the socket 222 of the drive 22 based on change in the priority of the tray 46, which is executed in the storage system 1 according to the present embodiment.

For example, it is assumed that the priority of the semiconductor package A decreases from 1st to 3rd, the priority of the semiconductor package B decreases from 2nd to 4th, the priority of the semiconductor package C increases from 3rd to 1st, and the priority of the semiconductor package D increases from 4th to 2nd. The host unit 21 updates the priority of each of the plurality of semiconductor packages 41 by using a predetermined algorithm based on the frequency of access requests and the like.

The host unit 21 updates the priority of each of the plurality of trays 46 in response to the update of the priority of each of the plurality of semiconductor packages 41. Here, since all the priorities of the semiconductor packages C and D accommodated in the tray_b exceed the priorities of the semiconductor packages A and B accommodated in the tray_a, the host unit 21 updates the priority of each of the tray_a and the tray_b so that the priority of the tray_b is higher than the priority of the tray_a. As a result, the tray_b has the highest priority (priority = 1), and the tray_a has the second highest priority (priority = 2).

Then, the host unit 21 instructs the package transport device 3 to detach the semiconductor packages A and B accommodated in the tray_a from the two sockets 222 of the socket group #1, to transport the tray_b to the drive 22, to mount the semiconductor packages C and D accommodated in the tray_b on the two sockets 222 of the socket group #1, and to hold the detached tray_a in the package transport device 3. The package transport device 3 collectively detaches the semiconductor packages A and B accommodated in the tray_a from the two sockets 222 of the socket group #1 in the drive 22 by detaching the tray_a from the socket group #1. Then, the package transport device 3 transports the tray_b held in the transport unit #1 to the drive 22, and collectively mounts the semiconductor packages C and D accommodated in the tray_b on the two sockets 222 of the socket group #1 from which the semiconductor packages A and B accommodated in the tray_a have been detached. The detached tray_a is maintained in a state of being held in the package transport device 3 (for example, the transport unit #1).

In response to the above operation, the host unit 21 updates the tray management table 7. Specifically, the host unit 21 stores, in the tray management table 7, information indicating that the tray_a is held in the transport unit #1 (buffer #1) of the package transport device 3 and information indicating that the tray_b is present in the socket group #1.

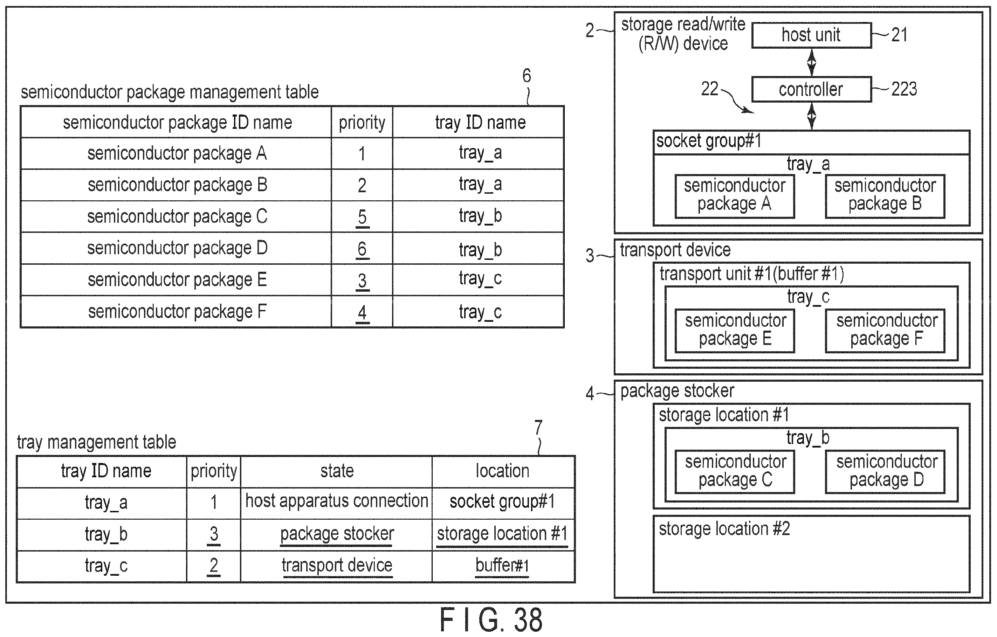

Next, an exchange operation when the priority of a tray 46 stored in the package stocker 4 exceeds the priority of a tray 46 held in a buffer of the package transport device 3 will be described. FIG. 38 is a diagram for illustrating an operation of changing a location of a tray 46 between the package stocker 4 and the package transport device 3 based on change in the priority of the tray 46, which is executed in the storage system 1 according to the present embodiment.

Here, it is assumed that, in the state illustrated in FIG. 36, for example, the priority of the tray_c increases from 3rd to 2nd and the priority of the tray_b decreases from 2nd to 3rd. The new priority (2nd) of the tray_c belongs to the priority of the second level, and the new priority (3rd) of the tray_b belongs to the priority of the third level. Therefore, the host unit 21 instructs the package transport device 3 to exchange the location of the tray_b and the location of the tray_c with each other. Specifically, first, the host unit 21 instructs the package transport device 3 to transport the tray_b to the storage location #1 of the package stocker 4, and further instructs the package transport device 3 to hold the tray c in the transport unit #1. The package transport device 3 that has received the instruction transports the tray_b held in the transport unit #1 to the storage location #1 of the package stocker 4. Then, the transport unit #1 exchanges the tray_c stored in the storage location #1 of the package stocker 4 with the tray_b held therein. The transport unit #1 (buffer #1) then holds the tray_c.

In response to the above operation, the host unit 21 updates the tray management table 7. Specifically, the host unit 21 stores, in the tray management table 7, information indicating that the tray_b is stored in the storage location #1 of the package stocker 4 and information indicating that the tray_c is held in the transport unit #1 (buffer #1) of the package transport device 3.

By the above operation, the host unit 21 can cause the package transport device 3 to hold, in advance, the semiconductor packages 41 accommodated in a tray 46 having a higher priority among the trays 46 stored in the package stocker 4. As a result, when the priority of the tray 46 held in the package transport device 3 exceeds the priority of a tray 46 present in the socket group #1 of the drive 22, it is possible to eliminate the time required for the package transport device 3 to take out the tray 46 from the package stocker 4.

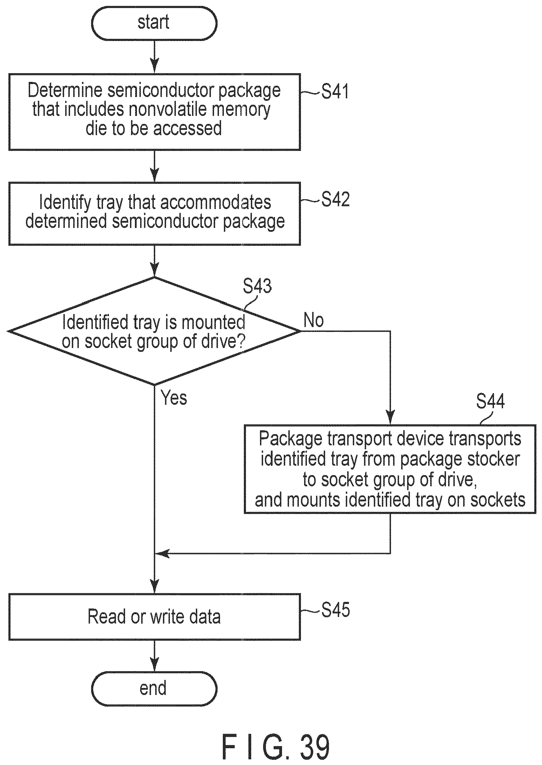

Next, a process of the reading or writing of data from or to a nonvolatile memory die 411 of a semiconductor package 41 accommodated in a tray 46 will be described. FIG. 39 is a flowchart illustrating a procedure of the process of reading or writing data from or to a nonvolatile memory die 411 provided in any one of a predetermined number of semiconductor packages 41 accommodated in a tray 46, the process being executed by the host unit 21 of the storage system 1 according to the present embodiment.

First, the host unit 21 determines a semiconductor package 41 that includes a nonvolatile memory die 411 to be accessed (Step S41). Here, the nonvolatile memory die 411 to be accessed is determined based on a read request or a write request received from the application program 211. Then, the semiconductor package 41 that includes the nonvolatile memory die 411 to be accessed is determined in Step S41.

Then, in Step S42, the host unit 21 identifies a tray 46 that accommodates the semiconductor package 41 determined in Step S41. In Step S42, the host unit 21 acquires the tray identification name of the tray 46 that accommodates the determined semiconductor package 41, by referring to the semiconductor package management table 6. As a result, the host unit 21 can identify the tray 46 that accommodates the determined semiconductor package 41.

The host unit 21 determines whether or not the tray 46 identified in Step S42 is mounted on a socket group of the drive 22, that is, whether or not the predetermined number of semiconductor packages 41 accommodated in the identified tray 46 are mounted on the predetermined number of sockets 222 of the drive 22 (Step S43). In Step S43, the host unit 21 acquires information indicating the state of the identified tray 46 by referring to the tray management table 7. As a result, the host unit 21 can determine whether or not the identified tray 46 is mounted on the socket group of the drive 22.

When the identified tray 46 is mounted on the socket group of the drive 22 (Yes in Step S43), the host unit 21 executes, via the controller 223, the reading or writing of data from or to the nonvolatile memory die 411 to be accessed, which is included in the determined semiconductor package 41 accommodated in the identified tray 46 (Step S45).

When the identified tray 46 is not mounted on the socket group of the drive 22 (No in Step S43), the host unit 21 causes the package transport device 3 to transport the identified tray 46 from the package stocker 4 to the drive 22, and to mount the predetermined number of semiconductor packages 41 accommodated in the identified tray 46 on the predetermined number of sockets 222 of the drive 22 (Step S44).

When the predetermined number of semiconductor packages 41 accommodated in the tray 46 are mounted on the predetermined number of sockets 222 by the package transport device 3, the host unit 21 reads the tray identifier (tray identification name) from the barcode of the tray 46 by using a barcode reader in the drive 22. Then, the host unit 21 determines whether or not the read tray identification name coincides with the tray identification name of the identified tray 46.

When the read tray identification name coincides with the tray identification name of the identified tray 46, the host unit 21 may further read the package identifier stored in the determined semiconductor package 41 accommodated in the tray 46 via the controller 223, and determine whether or not the read package identifier coincides with the package identifier of the determined semiconductor package 41. Then, when the read package identifier coincides with the package identifier of the determined semiconductor package 41, the host unit 21 executes, via the controller 223, the reading or writing of data from or to the semiconductor memory die 411 to be accessed, which is included in the determined semiconductor package 41 accommodated in the identified tray 46 (Step S45).

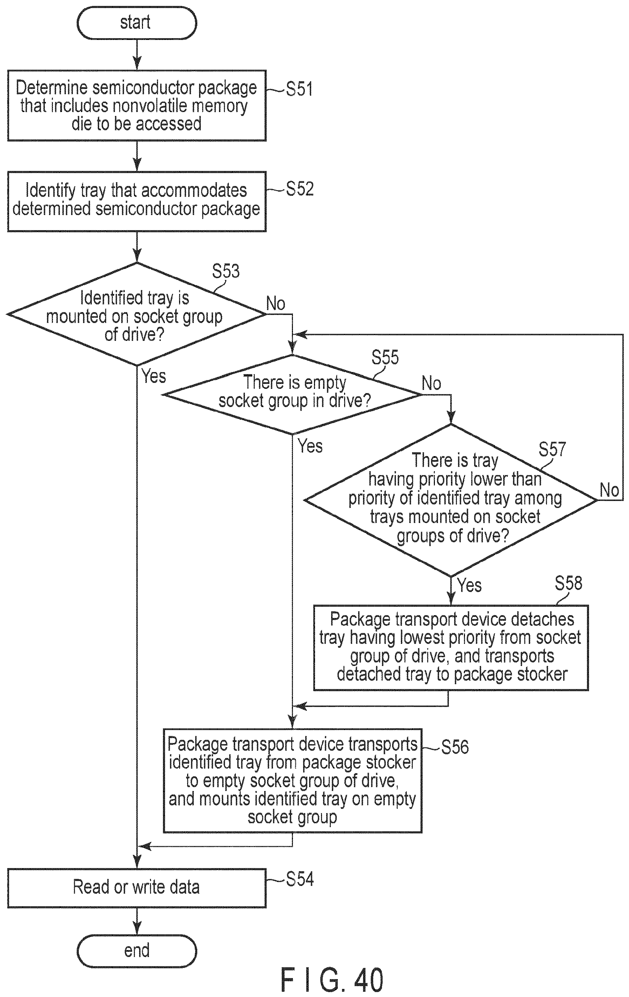

FIG. 40 is a flowchart illustrating details of a procedure of the process of reading or writing data from or to a nonvolatile memory die 411 included in any one of a predetermined number of semiconductor packages 41 accommodated in a tray 46, the process being executed by the host unit 21 of the storage system 1 according to the present embodiment.

First, the host unit 21 determines a semiconductor package 41 that includes the nonvolatile memory die 411 to be accessed (Step S51).

In Step S52, the host unit 21 identifies a tray 46 that accommodates the semiconductor package 41 determined in Step S51. In Step S52, the host unit 21 acquires the tray identification name of the tray 46 that accommodates the determined semiconductor package 41, by referring to the semiconductor package management table 6. As a result, the host unit 21 can identify the tray 46 that accommodates the determined semiconductor package 41.

The host unit 21 determines whether or not the tray 46 identified in Step S52 is mounted on a socket group of the drive 22, that is, whether or not the predetermined number of semiconductor packages 41 accommodated in the identified tray 46 are mounted on the predetermined number of sockets 222 of the drive 22 (Step S53). In Step S53, the host unit 21 acquires information indicating the state of the tray 46 identified in Step S52, by referring to the tray management table 7. As a result, the host unit 21 can determine whether or not the identified tray 46 is mounted on a socket group of the drive 22.

When the identified tray 46 is mounted on a socket group of the drive 22 (Yes in Step S53), the host unit 21 executes, via the controller 223, the reading or writing of data from or to the nonvolatile memory die 411 to be accessed, which is included in the determined semiconductor package 41 accommodated in the identified tray 46 (Step S54).

When the identified tray 46 is not mounted on a socket group of the drive 22 (No in Step S53), the host unit 21 checks whether or not there is an empty socket group in the drive 22 (Step S55). The empty socket group is the predetermined number of sockets 222 on which no semiconductor packages 41 are mounted.

When there is an empty socket group in the drive 22 (Yes in Step S55), the host unit 21 causes the package transport device 3 to transport the identified tray 46 from the package stocker 4 to the drive 22, and to mount the predetermined number of semiconductor packages 41 accommodated in the identified tray 46 on the predetermined number of sockets 222 of the empty socket group (Step S56). In this case, the host unit 21 instructs the package transport device 3 to take out the identified tray 46 from the package stocker 4, to transport the identified tray 46 to the drive 22, and to mount the transported tray 46 on the empty socket group.

When the predetermined number of semiconductor packages 41 accommodated in the tray 46 are mounted on the predetermined number of sockets 222 of the drive 22 by the package transport device 3, the host unit 21 reads the tray identifier (tray identification name) from the barcode of the tray 46 by using the barcode reader in the drive 22. Then, the host unit 21 determines whether or not the read tray identification name coincides with the tray identification name of the identified tray 46.

When the read tray identification name coincides with the tray identification name of the identified tray 46, the host unit 21 stores information indicating that the identified tray 46 is mounted on the socket group of the drive 22, in the tray management table 7.

When the read tray identification name coincides with the tray identification name of the identified tray 46, the host unit 21 may further read the package identifier stored in the determined semiconductor package 41 accommodated in this tray 46 via the controller 223, and determine whether or not the read package identifier coincides with the package identifier of the determined semiconductor package 41. Then, when the read package identifier coincides with the package identifier of the determined semiconductor package 41, the host unit 21 executes, via the controller 223, the reading or writing of data from or to the semiconductor memory die 411 to be accessed, which is included in the determined semiconductor package 41 accommodated in the identified tray 46 (Step S54).

When there is no empty socket group in the drive 22 (No in Step S55), the host unit 21 determines whether there is a tray 46 having a priority lower than the priority of the identified tray 46 among the trays 46 mounted on the socket groups of the drive 22 (Step S57).

When there is no tray 46 having a priority lower than the priority of the identified tray 46 among the trays 46 mounted on the socket groups of the drive 22 (No in Step S57), the host unit 21 executes the process of Step S55 again. The host unit 21 waits until the priority of each of the trays 46 is changed and thus there is a tray 46 having a priority lower than the priority of the identified tray 46 among the trays 46 mounted on the socket groups of the drive 22.

When there is a tray 46 having a priority lower than the priority of the identified tray 46 among the trays 46 mounted on the socket groups of the drive 22 (Yes in Step S57), the host unit 21 causes the package transport device 3 to detach a tray 46 having the lowest priority among the trays 46 mounted on the socket groups of the drive 22 from the socket group, and to transport the detached tray 46 to the package stocker 4 (Step S58). As a result, the socket group from which the tray 46 has been detached becomes an empty socket group including the predetermined number of sockets.

Then, the host unit 21 causes the package transport device 3 to transport the identified tray 46 from the package stocker 4 to the drive 22, and to mount the predetermined number of semiconductor packages 41 accommodated in the identified tray 46 on the empty socket group (Step 56). In this case, the host unit 21 instructs the package transport device 3 to take out the identified tray 46 from the package stocker 4, and to transport the identified tray 46 to the drive 22, and to mount the transported tray 46 on the socket group.

When the tray 46 is mounted on the socket group by the package transport device 3, the host unit 21 reads the tray identifier (tray identification name) from the barcode of this tray 46 by using the barcode reader in the drive 22. Then, the host unit 21 determines whether or not the read tray identification name coincides with the tray identification name of the identified tray 46.

When the read tray identification name coincides with the tray identification name of the identified tray 46, the host unit 21 stores information indicating that the identified tray 46 is mounted on the socket group of the drive 22, in the tray management table 7.

When the read tray identification name coincides with the tray identification name of the specified tray 46, the host unit 21 may further read the package identifier stored in the determined semiconductor package 41 accommodated in this tray 46 via the controller 223, and determine whether or not the read package identifier coincides with the package identifier of the determined semiconductor package 41. Then, when the read package identifier coincides with the package identifier of the determined semiconductor package 41, the host unit 21 executes, via the controller 223, the reading or writing of data from or to the semiconductor memory die 411 to be accessed, which is included in the determined semiconductor package 41 accommodated in the identified tray 46 (Step S54).

As a result, even when there is no empty socket group in the drive 22, the host unit 21 can mount the predetermined number of semiconductor packages 41 accommodated in the identified tray 46 on the predetermined number of sockets 222 of the drive 22 by detaching the tray 46 having a lower priority than the priority of the identified tray 46 from the socket group.

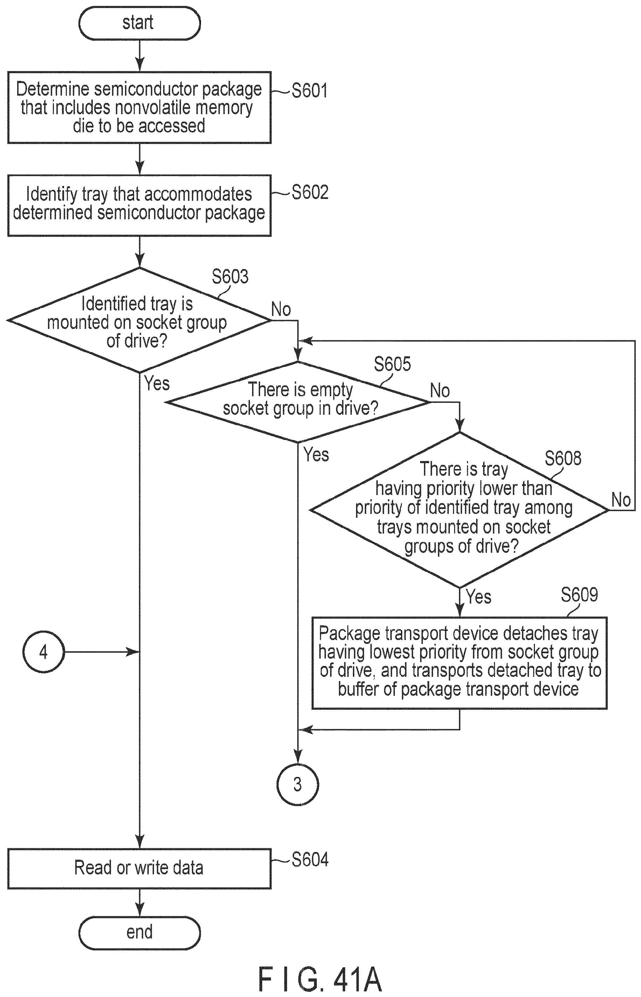

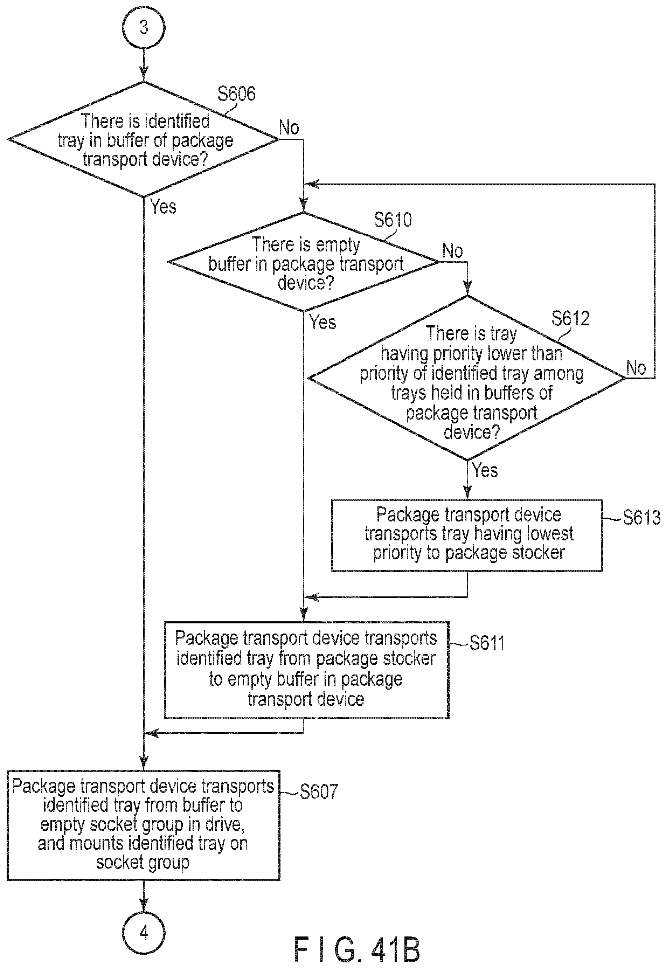

Next, a process of reading or writing data from or to a nonvolatile memory die 411 provided in the determined semiconductor package 41 accommodated in a tray 46 when a buffer of the package transport device 3 is available will be described. FIGS. 41A and 41B are flowcharts illustrating another procedure of the process of reading or writing data from or to the nonvolatile memory die 411, which is executed by the host unit 21 of the storage system 1 according to the present embodiment.

First, the host unit 21 determines a semiconductor package 41 that includes the nonvolatile memory die 411 to be accessed (Step S601).

In Step S602, the host unit 21 identifies a tray 46 that accommodates the semiconductor package 41 determined in Step S601. In Step S602, the host unit 21 acquires the tray identification name of the tray 46 that accommodates the determined semiconductor package 41, by referring to the semiconductor package management table 6. As a result, the host unit 21 can identify the tray 46 that accommodates the determined semiconductor package 41.

The host unit 21 determines whether or not the tray 46 identified in Step S602 is mounted on a socket group of the drive 22, that is, whether or not the predetermined number of semiconductor packages 41 accommodated in the identified tray 46 are mounted on the predetermined number of sockets 222 of the drive 22 (Step S603). In Step S603, the host unit 21 acquires information indicating the state of the tray 46 identified in Step S602, by referring to the tray management table 7. As a result, the host unit 21 can determine whether or not the identified tray 46 is mounted on the socket group of the drive 22.

When the identified tray 46 is mounted on a socket group of the drive 22 (Yes in Step S603), the host unit 21 executes, via the controller 223, the reading or writing of data from or to the nonvolatile memory die 411 to be accessed, which is included in the determined semiconductor package 41 accommodated in the identified tray 46 (Step S604).

When the identified tray 46 is not mounted on a socket group of the drive 22 (No in Step S603), the host unit 21 checks whether or not there is an empty socket group in the drive 22 (Step S605).

When there is an empty socket group in the drive 22 (Yes in Step S605), the host unit 21 executes the process of Step S606 in FIG. 41B.

When there is no empty socket group in the drive 22 (No in Step S605), the host unit 21 determines whether there is a tray 46 having a priority lower than the priority of the identified tray 46 among the trays 46 mounted on the socket groups of the drive 22 (Step S608).

When there is no tray 46 having a priority lower than the priority of the identified tray 46 among the trays 46 mounted on the socket groups of the drive 22 (No in Step S608), the host unit 21 executes the process of Step S605 again. The host unit 21 waits until the priority of each of the trays 46 is changed and thus there is a tray 46 having a priority lower than the priority of the identified tray 46 among the trays 46 mounted on the socket groups of the drive 22.

When there is a tray 46 having a priority lower than the priority of the identified tray 46 among the trays 46 mounted on the socket groups of the drive 22 (Yes in Step S608), the host unit 21 causes the package transport device 3 to detach the tray 46 having a priority lower than the priority of the identified tray 46 from the socket group, and to transport the detached tray 46 to a buffer of the package transport device 3 (Step S609). As a result, the tray 46 detached from the socket group is not stored in the package stocker 4 but is held in the package transport device 3. Further, the socket group from which the tray 46 has been detached becomes an empty socket group. Then, the host unit 21 executes the process of Step S606 in FIG. 41B.

The host unit 21 determines whether or not the identified tray 46 is present in a buffer of the package transport device 3, that is, whether or not the identified tray 46 is held in the package transport device 3 (Step S606).

When the identified tray 46 is present in a buffer of the package transport device 3, that is, when the identified tray 46 is held in any transport unit 31 of the package transport device 3 (Yes in Step S606), the host unit 21 causes the package transport device 3 to transport the identified tray 46 from the buffer of the package transport device 3 to the drive 22, and to mount the predetermined number of semiconductor packages 41 accommodated in the identified tray 46 on the predetermined number of sockets 222 of the empty socket group (Step S607). In this case, the host unit 21 instructs the transport unit 31 that has been holding the identified tray 46 to transport the identified tray 46 to the drive 22, and to mount the predetermined number of semiconductor packages 41 on the predetermined number of sockets 222 of the drive 22.

When the predetermined number of semiconductor packages 41 in the tray 46 are mounted on the predetermined number of sockets 222 of the drive 22 by the transport unit 31, the host unit 21 reads the tray identifier (tray identification name) from the barcode of this tray 46 by using the barcode reader in the drive 22. Then, the host unit 21 determines whether or not the read tray identification name coincides with the tray identification name of the identified tray 46.

When the read tray identification name coincides with the tray identification name of the specified tray 46, the host unit 21 stores information indicating that the identified tray 46 is mounted on the socket group of the drive 22, in the tray management table 7.

When the read tray identification name coincides with the tray identification name of the identified tray 46, the host unit 21 may further read the package identifier stored in the determined semiconductor package 41 accommodated in this tray 46 via the controller 223, and determine whether or not the read package identifier coincides with the package identifier of the determined semiconductor package 41. Then, when the read package identifier coincides with the package identifier of the determined semiconductor package 41, the host unit 21 executes, via the controller 223, the reading or writing of data from or to the semiconductor memory die 411 to be accessed, which is included in the determined semiconductor package 41 accommodated in the identified tray 46 (Step S604 in FIG. 41A).

When the identified tray 46 is not present in any buffer of the package transport device 3, that is, when the specified tray 46 is not held in any transport unit 31 of the package transport device 3 (No in Step S606), the host unit 21 checks whether or not there is an empty buffer in the package transport device 3 (Step S610). The empty buffer of the package transport device 3 is a transport unit 31 that is not holding a tray 46.

When there is an empty buffer in the package transport device 3, that is, when there is a transport unit 31 that is not holding a tray 46 (Yes in Step S610), the host unit 21 causes the package transport device 3 to transport the identified tray 46 from the package stocker 4 to the empty buffer in the package transport device 3, that is, to a transport unit 31 that does not hold the tray 46 (Step S611). In this case, the host unit 21 may instruct the transport unit 31 that is not holding a tray 46 to take out the identified tray 46 from the package stocker 4. Thus, since the identified tray 46 is held by the transport unit 31, the identified tray 46 is present in a buffer of the package transport device 3.

Then, the host unit 21 causes the package transport device 3 to transport the identified tray 46 from the buffer of the package transport device 3 to the drive 22, and to mount the predetermined number of semiconductor packages 41 accommodated in the identified tray 46 on the predetermined number of sockets 222 of the drive 22 (Step S607).

When the predetermined number of semiconductor packages 41 accommodated in the tray 46 are mounted on the predetermined number of sockets 222 of the drive 22 by the transport unit 31, the host unit 21 reads the tray identifier (tray identification name) from the barcode of this tray 46 by using the barcode reader in the drive 22. Then, the host unit 21 determines whether or not the read tray identification name coincides with the tray identification name of the identified tray 46.

When the read tray identification name coincides with the tray identification name of the identified tray 46, the host unit 21 stores information indicating that the identified tray 46 is mounted on the socket group of the drive 22, in the tray management table 7.

When the read tray identification name coincides with the tray identification name of the identified tray 46, the host unit 21 may further read the package identifier stored in the determined semiconductor package 41 accommodated in this tray 46 via the controller 223, and determine whether or not the read package identifier coincides with the package identifier of the determined semiconductor package 41. Then, when the read package identifier coincides with the package identifier of the determined semiconductor package 41, the host unit 21 executes, via the controller 223, the reading or writing of data from or to the semiconductor memory die 411 to be accessed, which is included in the determined semiconductor package 41 accommodated in the identified tray 46 (Step S604 in FIG. 41A).

When there is no empty buffer in the package transport device 3 (No in Step S610), the host unit 21 determines whether or not there is a tray 46 having a priority lower than the priority of the identified tray 46 among the trays 46 held in the buffers of the package transport device 3 (Step S612).

When there is no tray 46 having a priority lower than the priority of the identified tray 46 among the trays 46 held in the buffers of the package transport device 3 (No in Step S612), the host unit 21 executes the process of Step S610 again. The host unit 21 waits until the priority of each of the trays 46 is changed and thus there is a tray 46 having a priority lower than the priority of the identified tray 46 among the trays 46 held in the buffers of the package transport device 3.

When there is a tray 46 having a lower priority than the priority of the identified tray 46 among the trays 46 held in the buffers of the package transport device 3 (Yes in Step S612), the host unit 21 causes the package transport device 3 to transport a tray 46 having the lowest priority among the trays 46 held in the buffers of the package transport device 3 to the package stocker 4 (Step S613). In Step S613, the host unit 21 may instruct the transport unit 31 that has been holding the tray 46 having the lowest priority to transport this tray 46 to the package stocker 4. As a result, this transport unit 31 becomes an empty buffer that is not holding a tray 46.

Then, the host unit 21 causes the package transport device 3 to transport the identified tray 46 from the package stocker 4 to the empty buffer of the package transport device 3. In this case, the host unit 21 may instruct the transport unit 31 that has become the empty buffer to take out the identified tray 46 from the package stocker 4. Thus, since the identified tray 46 is held by the transport unit 31, the identified tray 46 is present in a buffer of the package transport device 3.

Then, the host unit 21 causes the package transport device 3 to transport the identified tray 46 from the buffer of the package transport device 3 to the drive 22, and to mount the predetermined number of semiconductor packages 41 accommodated in the identified tray 46 on the predetermined number of sockets 222 of the drive 22 (Step S607).

When the predetermined number of semiconductor packages 41 accommodated in the tray 46 are mounted on the predetermined number of sockets 222 of the drive 22 by the transport unit 31, the host unit 21 reads the tray identifier (tray identification name) from the barcode of this tray 46 by using the barcode reader in the drive 22. Then, the host unit 21 determines whether or not the read tray identification name coincides with the tray identification name of the identified tray 46.

When the read tray identification name coincides with the tray identification name of the identified tray 46, the host unit 21 stores information indicating that the identified tray 46 is mounted on the socket group of the drive 22, in the tray management table 7.

When the read tray identification name coincides with the tray identification name of the identified tray 46, the host unit 21 may further read the package identifier stored in the determined semiconductor package 41 accommodated in this tray 46 via the controller 223, and determine whether or not the read package identifier coincides with the package identifier of the determined semiconductor package 41. Then, when the read package identifier coincides with the package identifier of the determined semiconductor package 41, the host unit 21 executes, via the controller 223, the reading or writing of data from or to the semiconductor memory die 411 to be accessed, which is included in the determined semiconductor package 41 accommodated in the identified tray 46 (Step S604 in FIG. 41A).

As described above, the storage system 1 according to the second embodiment can collectively store, transport, and mount/detach a predetermined number of semiconductor packages 41 by using a tray 46 that accommodates the predetermined number of semiconductor packages 41. The host unit 21 determines a tray 46 that accommodates a semiconductor package 41 including a nonvolatile memory die 411 to be accessed, among the trays 46 managed in the storage system 1.

When the predetermined number of semiconductor packages 41 accommodated in the determined tray 46 are mounted on the predetermined number of sockets 222 of the drive 22, the host unit 21 reads or writes data from or to the nonvolatile memory die 411 to be accessed.

When the predetermined number of semiconductor packages 41 accommodated in the tray 46 are not mounted on the predetermined number of sockets 222 of the drive 22 and the determined tray 46 is stored in the package stocker 4, the host unit 21 causes the package transport device 3 to transport the determined tray 46 to the drive 22, and to mount the predetermined number of semiconductor packages 41 accommodated in the determined tray 46 on the predetermined number of sockets 222 of the drive 22.

As described above, in the storage system 1 of the present embodiment, the host unit 21 can exchange semiconductor packages 41 connected to sockets 222 of the drive 22 with other semiconductor packages 41 in units of the number of semiconductor packages 41 accommodated in a tray 46.

As a result, a plurality of semiconductor packages 41 can be managed, transported, and mounted/detached in units of the number of semiconductor packages 41 accommodated in the tray 46, and thus it is possible to more efficiently manage and transport the plurality of semiconductor packages 41.

### Reference Signs List

- 1: Storage system
- 2: Storage read/write device
- 3: Package transport device
- 4: Package stocker
- 5: Management server
- 6: Semiconductor package management table
- 7: Tray management table
- 21: Host unit (host apparatus)
- 22: Drive
- 31: Transport unit
- 41: Semiconductor package
- 46: Tray
- 222: Socket
- 223: Controller
- 411: Nonvolatile memory die

## Claims

1. A storage system comprising:
a package stocker (4) configured to store a plurality of semiconductor packages (41), each of the plurality of semiconductor packages (41) including one or more nonvolatile memory dies (411);
a drive (22) including at least one socket (222) on which a semiconductor package (41) among the plurality of semiconductor packages (41) is able to be detachably mounted, and a controller (223) configured to control the one or more nonvolatile memory dies (411) of the semiconductor package (41) mounted on the socket (222);
a host apparatus (21) communicatively connected to the drive (22) and configured to execute reading or writing data from or to the one or more nonvolatile memory dies (411) of the semiconductor package (41) mounted on the socket (222) via the controller (223); and
a package transport device (3) configured to transport each of the plurality of semiconductor packages (41) between the package stocker (4) and the drive (22),
wherein the host apparatus (21) is further configured to:
determine a first semiconductor package that includes a first nonvolatile memory die to be accessed, among the plurality of semiconductor packages (41);
when the first semiconductor package is mounted on the socket (222) of the drive (22), execute reading or writing data from or to the first nonvolatile memory die (411) via the controller (223); and
when the first semiconductor package is not mounted on the socket (222) of the drive (22), cause the package transport device (3) to transport the first semiconductor package to the drive (22), and to mount the first semiconductor package on the socket (222) of the drive (22).

2. The storage system according to claim 1, wherein
the host apparatus (21) is further configured to:
when the first semiconductor package is not mounted on the socket (222) of the drive (22) and the drive (22) includes an empty socket, cause the package transport device (3) to transport the first semiconductor package to the drive (22), and to mount the first semiconductor package on the empty socket of the drive (22); and
when the first semiconductor package is not mounted on the socket of the drive (22) and the drive (22) includes no empty socket, cause the package transport device (3) to detach a second semiconductor package from the socket (222) of the drive (22), and cause the package transport device (3) to transport the first semiconductor package to the drive (22), and to mount the first semiconductor package on the socket (222) of the drive (22) from which the second semiconductor package has been detached.

3. The storage system according to claim 1, wherein
the host apparatus (21) is further configured to:
manage a priority of each of the plurality of semiconductor packages (41); and
control a location where each of the plurality of semiconductor packages (41) is present, based on the priority of each of the plurality of semiconductor packages (41), such that:
a semiconductor package having a priority of a first level is mounted on the socket (222) of the drive (22);
a semiconductor package having a priority of a second level lower than the priority of the first level is held in the package transport device (3); and
a semiconductor package having a priority of a third level lower than the priority of the second level is stored in the package stocker (4).

4. The storage system according to claim 3, wherein
the package stocker (4) includes a first storage location and a second storage location, and
the host apparatus (21) is configured to control the location where each of the plurality of semiconductor packages (41) is present, based on the priority of each of the plurality of semiconductor packages (41), such that:
the semiconductor package having the priority of the third level is stored in the first storage location of the package stocker (4); and
a semiconductor package having a priority of a fourth level lower than the priority of the third level is stored in the second storage location of the package stocker (4).

5. The storage system according to claim 4, wherein
a distance between the first storage location and the package transport device (3) is shorter than a distance between the second storage location and the package transport device (3).

6. The storage system according to claim 1, wherein
the package stocker (4) is further configured to store a plurality of trays (46), each of the plurality of trays (46) accommodating a first number of semiconductor packages (41), the first number being two or more,
the drive (22) includes the first number of sockets on which the first number of semiconductor packages (41) accommodated in one of the plurality of trays (46) are able to be collectively and detachably mounted, and
the host apparatus (21) is further configured to:
identify a first tray that accommodates the first semiconductor package, among the plurality of trays (46);
when the first number of semiconductor packages (41) accommodated in the first tray are mounted on the first number of sockets of the drive (22), execute reading or writing data from or to the first nonvolatile memory die (411); and
when the first number of semiconductor packages (41) accommodated in the first tray are not mounted on the first number of sockets of the drive (22), cause the package transport device (3) to transport the first tray to the drive (22), and to mount the first number of semiconductor packages (41) accommodated in the first tray on the first number of sockets of the drive (22).

7. The storage system according to claim 6, wherein
the host apparatus (21) is further configured to:
manage a priority of each of the plurality of trays (46), the priority of each of the plurality of trays (46) being determined based on a priority of each of the plurality of semiconductor packages (41); and
control a location where each of the plurality of trays (46) is present, based on the priority of each of the plurality of trays (46), such that:
the first number of semiconductor packages (41) accommodated in a tray having a priority of a first level are mounted on the first number of sockets of the drive (22);
a tray having a priority of a second level lower than the priority of the first level is held in the package transport device (3);
a tray having a priority of a third level lower than the priority of the second level is stored in a first storage location of the package stocker (4); and
a tray having a priority of a fourth level lower than the priority of the third level is stored in a second storage location of the package stocker (4).

8. The storage system according to claim 7, wherein
a distance between the first storage location and the package transport device (3) is shorter than a distance between the second storage location and the package transport device (3).

9. The storage system according to claim 6, wherein
the package stocker (4) includes a tray loading/unloading slot configured to be used to:
add one of the plurality of trays (46) to the package stocker (4) from an outside of the package stocker (4); and
eject one of the plurality of trays (46) from the package stocker (4) to the outside of the package stocker (4).

10. The storage system according to claim 9, wherein
the package stocker (4) includes at least a pair of rails extending in parallel to each other and on which one of the plurality of trays (46) is able to be placed, and
the one of the plurality of trays (46) placed on the pair of rails is movable along the pair of rails.

11. The storage system according to claim 6, wherein
each of the plurality of semiconductor packages (41) includes a first surface (416), a second surface (417) opposite to the first surface, and a plurality of ball-type metal terminals (413) disposed on the second surface, and
each of the plurality of trays (46) has a surface in which an opening through which the plurality of ball-type metal terminals of each of the first number of semiconductor packages (41) are exposed is formed.

12. The storage system according to claim 6, wherein
each of the plurality of semiconductor packages (41) includes a first surface (416), a second surface (417) opposite to the first surface (416), and a plurality of ball-type metal terminals (413) disposed on the second surface,
the drive (22) further includes a board (221) on which at least the first number of sockets are disposed,
the board includes one or more first recessed portions, and
each of the plurality of trays (46) has a lower surface in which an opening through which the plurality of ball-type metal terminals (413) of each of the first number of semiconductor packages (41) are exposed is formed, and the lower surface of each of the plurality of trays (46) includes one or more first protrusions configured to fit into the one or more first recessed portions of the board of the drive (22).

13. The storage system according to claim 12, further comprising:
a lid member (226) that includes one or more second recessed portions, wherein
each of the plurality of trays (46) has an upper surface opposite to the lower surface, the upper surface includes one or more second protrusions, and
at least one of the plurality of trays (46) placed on the board is covered with the lid member such that the one or more second recessed portions of the lid member are fitted with the one or more second protrusions of the upper surface of the at least one of the plurality of trays (46).

14. The storage system according to claim 1, wherein
each of the plurality of semiconductor packages (41) includes a plurality of nonvolatile memory dies (411),
each of the plurality of semiconductor packages (41) includes a first surface (416), a second surface (417) opposite to the first surface, and a plurality of ball-type metal terminals (413) disposed on the second surface (417), and the plurality of ball-type metal terminals (413) are connected to channel terminals of the plurality of nonvolatile memory dies (411).

15. The storage system according to claim 1, wherein
the host apparatus (21) includes a processor (201) configured to execute a first program for managing an amount of data stored in at least one of the plurality of semiconductor packages (41) stored in the package stocker (4).

## Patentansprüche

1. Speichersystem, umfassend:
einen Paketstapler (4), der ausgebildet ist, um eine Vielzahl von Halbleiterpaketen (41) zu speichern, wobei jedes der zahlreichen Halbleiterpakete (41) einen oder mehrere nichtflüchtige Speicherchips (411) einschließt;
ein Laufwerk (22) einschließlich mindestens eines Steckplatzes (222), auf dem ein Halbleitergehäuse (41) aus der Vielzahl von Halbleitergehäusen (41) lösbar montiert werden kann, sowie eine Steuereinheit (223), die ausgebildet ist, den einen oder die mehreren nichtflüchtigen Speicherchips (411) des auf dem Steckplatz (222) montierten Halbleitergehäuses (41) zu steuern;
eine Host-Einrichtung (21), die kommunikativ mit dem Laufwerk (22) verbunden und so ausgebildet ist, dass sie über die Steuereinheit (223) Lesen oder Schreiben von Daten aus den oder in die einen oder mehreren nichtflüchtigen Speicherchips (411) des auf dem Steckplatz (222) montierten Halbleitergehäuses (41) ausführt; und
eine Pakettransportvorrichtung (3), die so ausgebildet ist, dass sie jede der zahlreichen Halbleiterpakete (41) zwischen dem Paketstapler (4) und dem Laufwerk (22) transportiert,
wobei die Host-Einrichtung (21) weiter zu Folgendem ausgebildet ist:
Bestimmen eines ersten Halbleiterpakets, das einen ersten nichtflüchtigen Speicherchip einschließt, auf den Zugang gewährt wird, aus der Vielzahl von Halbleiterpaketen (41);
wenn das erste Halbleiterpaket auf dem Steckplatz (222) des Laufwerks (22) montiert ist, Ausführen des Lesens oder Schreibens von Daten aus dem bzw. in den ersten nichtflüchtigen Speicherchip (411) über die Steuereinheit (223); und
wenn das erste Halbleiterpaket nicht auf dem Steckplatz (222) des Laufwerks (22) montiert ist, Veranlassen, dass die Pakettransportvorrichtung (3) das erste Halbleiterpaket zum Laufwerk (22) transportiert und das erste Halbleiterpaket auf dem Steckplatz (222) des Laufwerks (22) montiert.

2. Speichersystem nach Anspruch 1, wobei
die Host-Einrichtung (21) weiter zu Folgendem ausgebildet ist:
wenn das erste Halbleiterpaket nicht auf dem Steckplatz (222) des Laufwerks (22) montiert ist und das Laufwerk (22) einen freien Steckplatz einschließt, Veranlassen, dass die Pakettransportvorrichtung (3) das erste Halbleiterpaket zum Laufwerk (22) transportiert und das erste Halbleiterpaket auf dem freien Steckplatz des Laufwerks (22) montiert; und
wenn das erste Halbleiterpaket nicht auf dem Steckplatz des Laufwerks (22) montiert ist und das Laufwerk (22) keinen leeren Steckplatz einschließt, Veranlassen, dass die Pakettransportvorrichtung (3) ein zweites Halbleiterpaket vom Steckplatz (222) des Laufwerks (22) löst, und Veranlassen, dass die Pakettransportvorrichtung (3) das erste Halbleiterpaket zum Laufwerk (22) transportiert, und das erste Halbleiterpaket auf den Steckplatz (222) des Laufwerks (22) zu montieren, das das zweite Halbleiterpaket aufweist.

3. Speichersystem nach Anspruch 1, wobei
die Host-Einrichtung (21) weiter zu Folgendem ausgebildet ist:
Verwalten einer Priorität für jedes der Vielzahl von Halbleiterpaketen (41); und
Steuern einer Stelle, an der sich jedes der Vielzahl von Halbleiterpaketen (41) befindet, basierend auf der Priorität jedes der Vielzahl von Halbleiterpaketen (41), derart, dass:
ein Halbleiterpaket mit einer Priorität der ersten Stufe auf dem Steckplatz (222) des Laufwerks (22) montiert wird;
ein Halbleiterpaket, das eine Priorität einer zweiten Stufe aufweist, die niedriger ist als die Priorität der ersten Stufe, in der Pakettransportvorrichtung (3) gehalten wird; und
ein Halbleiterpaket, das eine Priorität einer dritten Stufe aufweist, die niedriger ist als die Priorität der zweiten Stufe, im Paketstapler (4) gespeichert wird.

4. Speichersystem nach Anspruch 3, wobei
der Paketstapler (4) einen ersten Speicherplatz und einen zweiten Speicherplatz einschließt, und
die Host-Einrichtung (21) so ausgebildet ist, dass sie die Stelle, an der sich jedes der mehrere Halbleiterpakete (41) befindet, basierend auf der Priorität jedes der mehrere Halbleiterpakete (41) so steuert, dass:
das Halbleiterpaket, das die Priorität der dritten Stufe aufweist, am ersten Speicherplatz des Paketstaplers (4) gespeichert wird; und
ein Halbleiterpaket, das eine Priorität der vierten Stufe aufweist, die niedriger ist als die Priorität der dritten Stufe, am zweiten Speicherplatz des Paketstaplers (4) gespeichert wird.

5. Speichersystem nach Anspruch 4, wobei
eine Distanz zwischen dem ersten Speicherplatz und der Pakettransportvorrichtung (3) kürzer ist als eine Distanz zwischen dem zweiten Speicherplatz und der Pakettransportvorrichtung (3).

6. Speichersystem nach Anspruch 1, wobei
der Paketstapler (4) weiter so ausgebildet ist, dass er eine Vielzahl von Fächern (46) aufnehmen kann, wobei jedes der Fächer (46) eine erste Anzahl von Halbleiterpaketen (41) aufnehmen kann, wobei die erste Anzahl zwei oder mehr beträgt,
das Laufwerk (22) die erste Anzahl von Steckplätzen einschließt, auf denen die erste Anzahl von Halbleiterpaketen (41), die in einer der Vielzahl von Fächern (46) aufgenommen sind, gemeinsam und lösbar montiert werden können, und
die Host-Einrichtung (21) weiter zu Folgendem ausgebildet ist:
Identifizieren eines ersten Fachs, das das erste Halbleiterpaket aufnimmt, aus der Vielzahl von Fächern (46);
wenn die erste Anzahl von Halbleiterpaketen (41), die in dem ersten Fach untergebracht sind, auf die erste Anzahl von Steckplätzen des Laufwerks (22) montiert sind, Ausführen des Lesens oder Schreibens von Daten aus dem bzw. in den ersten nichtflüchtigen Speicherchip (411); und
wenn die erste Anzahl von Halbleiterpaketen (41), die das erste Fach aufnehmen, nicht auf der ersten Anzahl von Steckplätzen des Laufwerks (22) montiert sind, Veranlassen, dass die Pakettransportvorrichtung (3) das erste Fach zum Laufwerk (22) transportiert und die erste Anzahl von Halbleiterpaketen (41), die das erste Fach aufnehmen, auf der ersten Anzahl von Steckplätzen des Laufwerks (22) montiert.

7. Speichersystem nach Anspruch 6, wobei
die Host-Einrichtung (21) weiter zu Folgendem ausgebildet ist:
Verwalten einer Priorität jedes der Vielzahl von Fächern (46), wobei die Priorität jedes der Vielzahl von Fächern (46) basierend auf einer Priorität jedes der Vielzahl von Halbleiterpaketen (41) bestimmt wird; und
Steuern einer Stelle, an der sich jedes der Vielzahl von Fächern (46) befindet, basierend auf der Priorität jedes der Vielzahl von Fächern (46), derart, dass:
die erste Anzahl von Halbleiterpaketen (41), die in einem Fach mit einer Priorität einer ersten Stufe untergebracht sind, auf die erste Anzahl von Steckplätzen des Laufwerks (22) montiert werden;
ein Fach, das eine Priorität einer zweiten Stufe aufweist, die niedriger ist als die Priorität der ersten Stufe, in der Pakettransportvorrichtung (3) gehalten wird;
ein Fach, das eine Priorität der dritten Stufe aufweist, die niedriger ist als die Priorität der zweiten Stufe, am ersten Speicherplatz des Paketstaplers (4) gespeichert wird; und
ein Fach, das eine Priorität der vierten Stufe aufweist, die niedriger ist als die Priorität der dritten Stufe, an einem zweiten Speicherplatz des Paketstaplers (4) gespeichert wird.

8. Speichersystem nach Anspruch 7, wobei
eine Distanz zwischen dem ersten Speicherplatz und der Pakettransportvorrichtung (3) kürzer ist als eine Distanz zwischen dem zweiten Speicherplatz und der Pakettransportvorrichtung (3).

9. Speichersystem nach Anspruch 6, wobei
der Paketstapler (4) einen Schlitz für das Ein- und Ausladen von Fächern einschließt, der ausgebildet ist, um für Folgendes verwendet zu werden:
Einführen eines der mehrere Fächer (46) von außerhalb des Paketstaplers (4) in den Paketstapler (4); und
Ausstoßen eines der mehrere Fächer (46) aus dem Paketstapler (4) nach außerhalb des Paketstaplers (4).

10. Speichersystem nach Anspruch 9, wobei
der Paketstapler (4) mindestens ein Paar parallel zueinander verlaufender Schienen einschließt, auf denen eines der Vielzahl von Fächern (46) platziert werden kann, und
eines der Vielzahl von Fächern (46), das auf dem Schienenpaar platziert ist, entlang des Schienenpaars beweglich ist.

11. Speichersystem nach Anspruch 6, wobei
jedes der Vielzahl von Halbleiterpaketen (41) eine erste Oberfläche (416), eine der ersten Oberfläche gegenüberliegende zweite Oberfläche (417) sowie eine Vielzahl von kugelförmigen Metallanschlüssen (413), die auf der zweiten Oberfläche angeordnet sind, einschließt und
jedes der Vielzahl von Fächern (46) eine Oberfläche aufweist, in der eine Öffnung gebildet ist, durch die die Vielzahl von kugelförmigen Metallanschlüssen jedes der ersten Anzahl von Halbleiterpaketen (41) freigelegt ist.

12. Speichersystem nach Anspruch 6, wobei
jedes der Vielzahl von Halbleiterpaketen (41) eine erste Oberfläche (416), eine der ersten Oberfläche (416) gegenüberliegende zweite Oberfläche (417) sowie eine Vielzahl von kugelförmigen Metallanschlüssen (413), die auf der zweiten Oberfläche angeordnet sind, einschließt,
das Laufwerk (22) weiter eine Platine (221) einschließt, auf der mindestens die erste Anzahl von Steckplätzen angeordnet ist,
die Platine einen oder mehrere erste vertiefte Abschnitte einschließt, und
jede der Vielzahl von Fächern (46) eine Unterseite aufweist, in der eine Öffnung ausgebildet ist, durch die die Vielzahl von kugelförmigen Metallanschlüssen (413) jedes der ersten Anzahl von Halbleiterpaketen (41) offengelegt sind, und die Unterseite jedes der Vielzahl von Fächern (46) einen oder mehrere erste Vorsprünge einschließt, die so ausgebildet sind, dass sie in die einen oder mehreren ersten vertieften Abschnitte der Platine des Laufwerks (22) passen.

13. Speichersystem nach Anspruch 12, weiter umfassend:
ein Deckelelement (226), das einen oder mehrere zweite vertiefte Abschnitte einschließt, wobei
jede der Vielzahl von Fächern (46) eine der Unterseite gegenüberliegende Oberseite aufweist, wobei die Oberseite einen oder mehrere zweite Vorsprünge einschließt, und
mindestens eine der Vielzahl von Fächern (46), die auf der Platine angeordnet ist, mit dem Deckelelement abgedeckt ist, derart, dass der eine oder die mehreren zweiten vertieften Abschnitten des Deckelelements mit dem einen oder den mehreren zweiten Vorsprüngen der Oberseite des mindestens einen der Vielzahl von Fächern (46) in Eingriff stehen.

14. Speichersystem nach Anspruch 1, wobei
jedes der Vielzahl von Halbleiterpaketen (41) eine Vielzahl von nichtflüchtigen Speicherchips (411) einschließt,
jedes der Vielzahl von Halbleiterpaketen (41) eine erste Oberfläche (416), eine der ersten Oberfläche gegenüberliegende zweite Oberfläche (417) sowie eine Vielzahl von kugelförmigen Metallanschlüssen (413) einschließt, die auf der zweiten Oberfläche (417) angeordnet sind, und die Vielzahl von kugelförmigen Metallanschlüssen (413) ist mit Kanalanschlüssen der Vielzahl von nichtflüchtigen Speicherchips (411) verbunden.

15. Speichersystem nach Anspruch 1, wobei
die Host-Einrichtung (21) einen Prozessor (201) einschließt, der so ausgebildet ist, dass er ein erstes Programm zur Verwaltung einer Datenmenge ausführt, die in mindestens einem der zahlreichen Halbleiterpakete (41) gespeichert ist, die im Paketlager (4) gespeichert werden.

## Revendications

1. Système de stockage comprenant :
un empileur de paquets (4) configuré pour stocker une pluralité de boîtiers de semi-conducteurs (41), chacun de la pluralité des boîtiers de semi-conducteurs (41) incluant une ou plusieurs puces de mémoire non volatile (411) ;
un entraînement (22) incluant au moins un support (222) sur lequel un boîtier de semi-conducteur (41) parmi la pluralité de boîtiers de semi-conducteurs (41) peut être monté de manière détachable, et un dispositif de commande (223) configuré pour commander la ou les puces de mémoire non volatile (411) du boîtier de semi-conducteur (41) montées sur le support (222) ;
un appareil hôte (21) connecté de manière communicative à l'entraînement (22) et configuré pour exécuter des opérations de lecture ou d'écriture de données à partir ou vers une ou plusieurs puces de mémoire non volatile (411) du boîtier semi-conducteur (41) monté sur le support (222) via le dispositif de commande (223) ; et
un dispositif de transport de boîtiers (3) configuré pour transporter chacun des boîtiers de semi-conducteurs (41) entre l'empileur de paquets (4) et l'entraînement (22),
dans lequel l'appareil hôte (21) est en outre configuré pour :
déterminer un premier boîtier de semi-conducteur qui inclut une première puce de mémoire non volatile à laquelle accéder, parmi la pluralité de boîtiers semi-conducteurs (41) ;
lorsque le premier boîtier de semi-conducteur est monté sur le support (222) de l'entraînement (22), exécuter la lecture ou l'écriture de données depuis ou vers la première puce de mémoire non volatile (411) via le dispositif de commande (223) ; et
lorsque le premier boîtier de semi-conducteur n'est pas monté sur le support (222) de l'entraînement (22), amener le dispositif de transport de boîtiers (3) à transporter le premier boîtier de semi-conducteur vers l'entraînement (22) et à monter le premier boîtier de semi-conducteur sur le support (222) de l'entraînement (22).

2. Système de stockage de données selon la revendication 1, dans lequel
l'appareil hôte (21) est en outre configuré pour :
lorsque le premier boîtier de semi-conducteur n'est pas monté sur le support (222) de l'entraînement (22) et que l'entraînement (22) inclut un support vide, amener le dispositif de transport de boîtiers (3) à transporter le premier boîtier de semi-conducteur vers l'entraînement (22) et à monter le premier boîtier de semi-conducteur sur le support vide de l'entraînement (22) ; et
lorsque le premier boîtier de semi-conducteur n'est pas monté sur le support de l'entraînement (22) et que l'entraînement (22) n'inclut aucun support vide, amener le dispositif de transport de boîtier (3) à détacher un deuxième boîtier de semi-conducteur du support (222) de l'entraînement (22), et amener le dispositif de transport de boîtier (3) à transporter le premier boîtier de semi-conducteur vers l'entraînement (22), et à monter le premier boîtier de semi-conducteur sur le support (222) de l'entraînement (22) d'où le deuxième boîtier de semi-conducteur a été détaché.

3. Système de stockage de données selon la revendication 1, dans lequel
l'appareil hôte (21) est en outre configuré pour :
gérer la priorité de chacun des multiples boîtiers de semi-conducteurs (41) ; et
commander l'emplacement dans lequel se trouvent chacun des multiples boîtiers de semi-conducteurs (41), en fonction de la priorité de chacun des multiples boîtiers de semi-conducteurs (41), de sorte que :
un boîtier de semi-conducteur présentant une priorité de premier niveau soit monté sur le support (222) de l'entraînement (22) ;
un boîtier de semi-conducteur présentant une priorité de deuxième niveau inférieure à la priorité de premier niveau est maintenu dans le dispositif de transport de boîtier (3) ; et
un boîtier de semi-conducteur présentant une priorité de troisième niveau inférieure à la priorité de deuxième niveau est stocké dans l'empileur de paquets (4).

4. Système de stockage selon la revendication 3, dans lequel
l'empileur de paquets (4) inclut un premier emplacement de stockage et un deuxième emplacement de stockage, et
l'appareil hôte (21) est configuré pour commander l'emplacement dans lequel se trouvent chacun de la pluralité de boîtiers de semi-conducteurs (41), en fonction de la priorité de chacun de la pluralité de boîtiers de semi-conducteurs (41), de sorte que :
le boîtier de semi-conducteur présentant la priorité du troisième niveau est stocké dans le premier emplacement de stockage de l'empileur de boîtiers (4) ; et
un boîtier de semi-conducteur présentant une priorité de quatrième niveau inférieure à la priorité du troisième niveau est stocké dans le deuxième emplacement de stockage de l'empileur de paquets (4).

5. Système de stockage selon la revendication 4, dans lequel
une distance entre le premier emplacement de stockage et le dispositif de transport de paquets (3) est plus courte qu'une distance entre le deuxième emplacement de stockage et le dispositif de transport de paquets (3).

6. Système de stockage de données selon la revendication 1, dans lequel
l'empileur de paquets (4) est en outre configuré pour stocker une pluralité de plateaux (46), chacun de la pluralité de plateaux (46) pouvant accueillir un premier nombre de boîtiers de semi-conducteurs (41), ce premier nombre étant deux ou plus,
l'entraînement (22) inclut le premier nombre de supports sur lesquels le premier nombre de boîtiers de semi-conducteurs (41) logés dans l'un de la pluralité de plateaux (46) peuvent être montés collectivement et de manière amovible, et
l'appareil hôte (21) est en outre configuré pour :
identifier un premier plateau qui accueille le premier boîtier de semi-conducteur, parmi la pluralité de plateaux (46) ;
lorsque le premier nombre de boîtiers de semi-conducteurs (41) abrités dans le premier plateau sont montés sur le premier nombre de supports de l'entraînement (22), exécuter la lecture ou l'écriture de données depuis ou vers la première puce de mémoire non volatile (411) ; et
lorsque le premier nombre de boîtiers de semi-conducteurs (41) abrités dans le premier plateau ne sont pas montés sur le premier nombre de supports de l'entraînement (22), amener le dispositif de transport de paquets (3) à transporter le premier plateau vers l'entraînement (22) et à monter le premier nombre de boîtiers de semi-conducteurs (41) abrités dans le premier plateau sur le premier nombre de supports de l'entraînement (22).

7. Système de stockage selon la revendication 6, dans lequel
l'appareil hôte (21) est en outre configuré pour :
gérer la priorité de chacun de la pluralité de plateaux (46), la priorité de chacun de la pluralité de plateaux (46) étant déterminée en fonction de la priorité de chacun de la pluralité de boîtiers de semi-conducteurs (41) ; et
commander l'emplacement dans lequel se trouve chacun des plateaux (46), en fonction de la priorité de chacun de la pluralité de plateaux (46), de sorte que :
le premier nombre de boîtiers de semi-conducteurs (41) abrités dans un plateau présentant une priorité de premier niveau sont montés sur le premier nombre de supports de l'entraînement (22) ;
un plateau présentant une priorité de deuxième niveau inférieure à la priorité du premier niveau est maintenu dans le dispositif de transport de paquets (3) ;
un plateau présentant une priorité de troisième niveau inférieure à celle du deuxième niveau est stocké dans un premier emplacement de stockage de l'empileur de paquets (4) ; et
un plateau présentant une priorité de quatrième niveau inférieure à la priorité du troisième niveau est stocké dans un deuxième emplacement de stockage de l'empileur de paquets (4).

8. Système de stockage selon la revendication 7, dans lequel
une distance entre le premier emplacement de stockage et le dispositif de transport de paquets (3) est plus courte qu'une distance entre le deuxième emplacement de stockage et le dispositif de transport de paquets (3).

9. Système de stockage selon la revendication 6, dans lequel
l'empileur de paquets (4) inclut une fente de chargement/déchargement de plateau configuré pour être utilisé pour :
ajouter l'un de la pluralité de plateaux (46) à l'empileur de paquets (4) depuis l'extérieur de l'empileur de paquets ; et
éjecter l'un de la pluralité de plateaux (46) de l'empileur de paquets (4) vers l'extérieur de l'empileur de paquets (4).

10. Système de stockage selon la revendication 9, dans lequel
l'empileur de paquets (4) inclut au moins une paire de rails parallèles l'un à l'autre sur lesquels l'un de la pluralité de plateaux (46) peut être placé, et
l'un de la pluralité de plateaux (46) placés sur la paire de rails est mobile le long de la paire de rails.

11. Système de stockage selon la revendication 6, dans lequel
chacun des boîtiers de semi-conducteurs (41) inclut une première surface (416), une deuxième surface (417) opposée à la première surface, et une pluralité de bornes métalliques à bille (413) disposées sur la deuxième surface, et
chacun de la pluralité de plateaux (46) possède une surface dans laquelle est formée une ouverture à travers laquelle sont exposées les bornes métalliques de type bille de chacun du premier nombre de boîtiers de semi-conducteurs (41).

12. Système de stockage selon la revendication 6, dans lequel
chacun de la pluralité de boîtiers de semi-conducteurs (41) inclut une première surface (416), une deuxième surface (417) opposée à la première surface (416), et une pluralité de bornes métalliques de type bille (413) disposées sur la deuxième surface,
l'entraînement (22) inclut en outre une carte (221) sur laquelle sont disposés au moins le premier nombre de supports,
la carte inclut une ou plusieurs premières parties évidées, et
chacun de la pluralité de plateaux (46) possède une surface inférieure dans laquelle est formée une ouverture à travers laquelle sont exposées la pluralité de bornes métalliques à bille (413) de chacun du premier nombre de boîtiers de semi-conducteurs (41), et la surface inférieure de chacun de la pluralité de plateaux (46) inclut une ou plusieurs premières protubérances configurées pour s'insérer dans les une ou plusieurs premières parties évidées de la carte de l'entraînement (22).

13. Système de stockage selon la revendication 12, comprenant en outre :
un élément de couvercle (226) qui inclut une ou plusieurs deuxièmes parties évidées, dans lequel
chacun de la pluralité de plateaux (46) possède une surface supérieure opposée à la surface inférieure, la surface supérieure inclut une ou plusieurs deuxièmes protubérances, et
au moins un de la pluralité de plateaux (46) placés sur la carte est recouvert par l'élément de couvercle de telle sorte que la ou les deuxièmes parties évidées de l'élément de couvercle sont équipées de la ou des deuxièmes protubérances de la surface supérieure du au moins un de la pluralité de plateaux (46).

14. Système de stockage de données selon la revendication 1, dans lequel
chacun de la pluralité de boîtiers de semi-conducteurs (41) inclut une pluralité de puces de mémoire non volatile (411),
chacun de la pluralité de boîtiers de semi-conducteurs (41) inclut une première surface (416), une deuxième surface (417) opposée à la première surface, et une pluralité de bornes métalliques de type bille (413) disposées sur la deuxième surface (417), et la pluralité de bornes métalliques de type bille (413) sont connectées aux bornes de canal de la pluralité de puces de mémoire non volatile (411).

15. Système de stockage de données selon la revendication 1, dans lequel
l'appareil hôte (21) inclut un processeur (201) configuré pour exécuter un premier programme de gestion d'une quantité de données stockées dans au moins un des multiples boîtiers de semi-conducteurs (41) stockés dans l'empileur de paquets (4).
